# EUROPEAN PATENT APPLICATION

(11) **EP 4 707 928 A1**
(43) Date of publication of application: **11.03.2026**
(21) Application number: 24800105.9
(22) Date of filing: 26.04.2024
(51) Int. Cl.: G03F 7/11, H01L 21/027

(54) **COMPOSITION FOR FORMING SURFACE-MODIFIED LAYER, AND METHOD FOR FORMING RESIST PATTERN**

(30) Priority: 01.05.2023 JP 2023075761
(71) Applicant: TOKYO OHKA KOGYO CO., LTD., Kawasaki-shi, Kanagawa 211 0012 (JP)
(72) Inventor: KUROSAWA Tsuyoshi, Kawasaki-shi, Kanagawa 211-0012 (JP); KOHNO Shinichi, Kawasaki-shi, Kanagawa 211-0012 (JP); SHIROKI Takeaki, Kawasaki-shi, Kanagawa 211-0012 (JP)
(74) Representative: Plasseraud IP
(86) International application number: PCT/JP2024/016568
(87) International publication number: WO 2024/228374

(57) **Abstract**

A composition for forming a surface-modified layer, which is a composition for forming a surface-modified layer provided between a support and a resist film, the composition including a resin component (G) having a constitutional unit (g0) represented by General Formula (g0-1), and a resin component (P) having a constitutional unit (p0) represented by General Formula (p0-1). R is a hydrogen atom, an alkyl group having 1 to 5 carbon atoms, or a halogenated alkyl group having 1 to 5 carbon atoms; Yg⁰ is a divalent linking group; Rg⁰ is an epoxy group-containing group; Yp⁰ is a divalent linking group; and Rp⁰ is a chain-like hydrocarbon group having 2 to 20 carbon atoms, which may have a substituent.

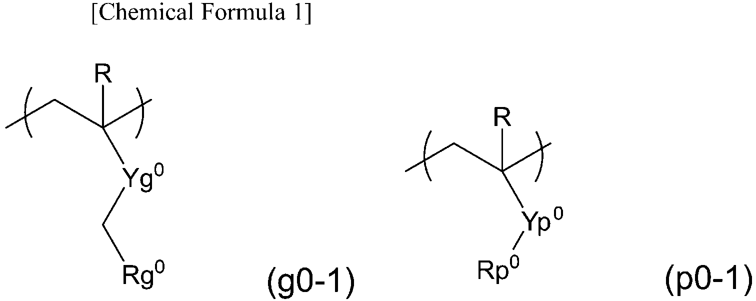

## Description

### TECHNICAL FIELD

The present invention relates to a composition for forming a surface-modified layer, and a resist pattern-forming method.

Priority is claimed on Japanese Patent Application No. 2023-075761, filed May 1, 2023, the content of which is incorporated herein by reference.

### BACKGROUND ART

In recent years, in the manufacture of semiconductor elements and liquid crystal display elements, advances in lithography technologies have led to rapid progress in the field of pattern fining. Typically, these pattern fining technologies involve shortening the wavelength (increasing the energy) of the exposure light source.

Resist materials are required to have lithography characteristics such as sensitivity to these exposure light sources and resolution that enables reproduction of a fine-sized pattern.

As a resist material that satisfies these requirements, a chemically amplified-type resist composition that contains a base material component of which solubility in a developing solution is changed by an action of an acid, and an acid generator component that generates an acid upon light exposure has been used in the related art.

In a case where a resist pattern is formed on an inorganic substrate, adhesiveness between a support such as a silicon wafer and a resist film is a problem. Insufficient adhesiveness between the support and the resist film causes pattern collapse of the resist pattern. Examples of a method of enhancing the adhesiveness of the resist film to the support include a method of providing a surface-modified layer between the support and the resist film. For example, Patent Document 1 describes a surface reforming material containing an epoxy resin having a mass-average molecular weight of 1,000 to 50,000.

### Citation List

### Patent Document

Patent Document 1: Japanese Unexamined Patent Application, First Publication No. 2011-197425

### SUMMARY OF INVENTION

### Technical Problem

With the progression of pattern miniaturization is, various lithography characteristics such as pattern collapse resistance and pattern resolution improvement are required more than ever in lithography technology. In the related art, in order to prevent pattern collapse, a method of improving the adhesiveness of a resist pattern to a support by performing a hexamethyldisilazane (HMDS) treatment on a support such as a silicon wafer or providing an organic antireflection film has been used.

However, in a case where a resist pattern of an isolated line is formed with a fine dimension, pattern collapse may not be sufficiently suppressed due to insufficient adhesiveness of the resist film to the support, and the like. In addition, there is a case where residue after the exposure and development of the resist film cannot be sufficiently suppressed.

The present invention has been made in view of the above circumstances, and an object of the present invention is to provide a composition for forming a surface-modified layer which is capable of improving the adhesiveness of a resist film to a support, and a resist pattern-forming method using the composition for forming a surface-modified layer.

### Solution to Problem

In order to achieve the above-described object, the present invention employs the following configurations.

That is, a first aspect of the present invention is a composition for forming a surface-modified layer, which is a composition for forming a surface-modified layer provided between a support and a resist film, the composition including a resin component (G) having a constitutional unit (g0) represented by General Formula (g0-1) and a resin component (P) having a constitutional unit (p0) represented by General Formula (p0-1). 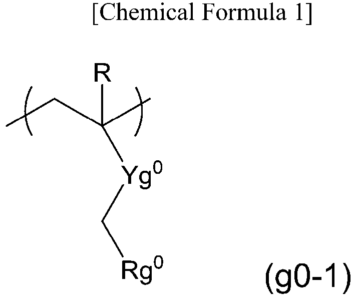 [In the formula, R represents a hydrogen atom, an alkyl group having 1 to 5 carbon atoms, or a halogenated alkyl group having 1 to 5 carbon atoms; Yg⁰ represents a divalent linking group; and Rg⁰ represents an epoxy group-containing group]. 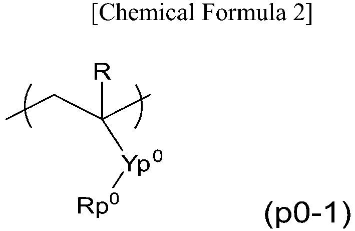 [In the formula, R represents a hydrogen atom, an alkyl group having 1 to 5 carbon atoms, or a halogenated alkyl group having 1 to 5 carbon atoms; Yp⁰ represents a divalent linking group; and Rp⁰ represents a chain-like hydrocarbon group having 2 to 20 carbon atoms, which may have a substituent].

A second aspect of the present invention is a resist pattern-forming method including step (i) of forming a surface-modified layer on a support using the composition for forming a surface-modified layer according to the first aspect, step (ii) of forming a resist film on the surface-modified layer formed on the support using a resist composition, step (iii) of exposing the resist film, and step (iv) of developing the exposed resist film to form a resist pattern.

### Advantageous Effects of Invention

According to the present invention, it is possible to provide a composition for forming a surface-modified layer which is capable of improving the adhesiveness of a resist film to a support, and a resist pattern-forming method using the composition for forming a surface-modified layer.

### DESCRIPTION OF EMBODIMENTS

In the present specification and the scope of the present claims, the term "aliphatic" is a relative concept used with respect to "aromatic" and defines a group or compound that has no aromaticity.

The term "alkyl group" includes a linear, branched, or cyclic monovalent saturated hydrocarbon group unless otherwise specified. The same applies to the alkyl group in an alkoxy group.

The term "alkylene group" includes a linear, branched, or cyclic divalent saturated hydrocarbon group unless otherwise specified.

Examples of "halogen atom" include a fluorine atom, a chlorine atom, a bromine atom, and an iodine atom.

The term "constitutional unit" indicates a monomer unit constituting a polymer compound (a resin, a polymer, or a copolymer).

The expression "may have a substituent" includes both a case where a hydrogen atom (-H) is substituted with a monovalent group and a case where a methylene (-CH₂-) group is substituted with a divalent group.

The term "light exposure" is a general concept for irradiation with radiation.

The term "acid-decomposable group" indicates a group having acid decomposability in which at least part of a bond in the structure of the acid-dissociable group can be cleaved by the action of an acid.

Examples of the acid-decomposable group of which the polarity is increased by the action of an acid include groups which are decomposed by the action of an acid to generate a polar group.

Examples of the polar group include a carboxy group, a hydroxyl group, an amino group, and a sulfo group (-SO₃H).

More specific examples of the acid-decomposable group include a group in which the above-described polar group has been protected by an acid-dissociable group (such as a group in which a hydrogen atom of the OH-containing polar group has been protected by an acid-dissociable group).

Here, the term "acid-dissociable group" indicates both a group (i) having an acid dissociation property in which a bond between the acid-dissociable group and an atom adjacent to the acid-dissociable group can be cleaved by the action of an acid and a group (ii) in which some bonds are cleaved by the action of an acid, a decarboxylation reaction occurs, and thus the bond between the acid-dissociable group and the atom adjacent to the acid-dissociable group can be cleaved.

It is necessary that the acid-dissociable group that constitutes the acid-decomposable group be a group which exhibits a lower polarity than that of the polar group generated by the dissociation of the acid-dissociable group. Thus, in a case where the acid-dissociable group is dissociated by the action of an acid, a polar group exhibiting a higher polarity than that of the acid-dissociable group is generated so that the polarity is increased. As a result, the polarity of an entire component (A1) is increased. Due to the increase in the polarity, the solubility in a developing solution is relatively changed such that the solubility is increased in a case where the developing solution is an alkali developing solution and the solubility is decreased in a case where the developing solution is an organic developing solution.

The term "base material component" denotes an organic compound having film-forming ability. Organic compounds used as the base material component are classified into non-polymers and polymers. As the non-polymers, non-polymers having a molecular weight of 500 or greater and less than 4000 (hereinafter, referred to as "low-molecular-weight compounds") are typically used. Hereinafter, the term "resin", "polymer compound", or "polymer" indicates a polymer having a molecular weight of 1000 or greater. As the molecular weight of the polymer, the weight-average molecular weight in terms of polystyrene according to gel permeation chromatography (GPC) is used.

The expression "constitutional unit to be derived" denotes a constitutional unit formed by cleavage of a multiple bond between carbon atoms, for example, an ethylenic double bond.

In "acrylic acid ester", the hydrogen atom bonded to the carbon atom at the α-position may be substituted with a substituent. The substituent (R^{αx}) that substitutes the hydrogen atom bonded to the carbon atom at the α-position is an atom other than the hydrogen atom or a group. Further, itaconic acid diester in which the substituent (R^{αx}) has been substituted with a substituent having an ester bond or α-hydroxyacryl ester in which the substituent (R^{αx}) has been substituted with a hydroxyalkyl group or a group obtained by modifying a hydroxyl group thereof can be described as acrylic acid ester. Further, the carbon atom at the α-position of acrylic acid ester indicates the carbon atom to which the carbonyl group of acrylic acid is bonded, unless otherwise specified.

Hereinafter, acrylic acid ester in which the hydrogen atom bonded to the carbon atom at the α-position has been substituted with a substituent is also referred to as α-substituted acrylic acid ester.

The concept "derivative" includes those obtained by substituting a hydrogen atom at the α-position of a target compound with another substituent such as an alkyl group or a halogenated alkyl group, and derivatives thereof. Examples of the derivatives thereof include those obtained by substituting a hydrogen atom of a hydroxyl group of a target compound, in which the hydrogen atom at the α-position may be substituted with a substituent, with an organic group, and those obtained by bonding a substituent other than a hydroxyl group to a target compound in which the hydrogen atom at the α-position may be substituted with a substituent. Further, the α-position denotes the first carbon atom adjacent to a functional group unless otherwise specified.

Examples of the substituent that substitutes the hydrogen atom at the α-position of hydroxystyrene include the same groups as those for R^{αx}.

In the present specification and the scope of the present claims, asymmetric carbons may be present and enantiomers or diastereomers may be present depending on the structures of the chemical formulae. In this case, these isomers are represented by one chemical formula. These isomers may be used alone or in the form of a mixture.

### (Composition for Forming Surface-Modified Layer)

The composition for forming a surface-modified layer according to the first aspect of the present invention is used for forming a surface-modified layer provided between a support and a resist film. The composition for forming a surface-modified layer according to the present embodiment contains a resin component (G) having a constitutional unit (g0) represented by General Formula (g0-1) described later (hereinafter, also referred to as a "component (G)") and a resin component (P) having a constitutional unit (p0) represented by General Formula (p0-1) described later (hereinafter, also referred to as a "component (P)").

### <Resin Component (G): Component (G)>

The component (G) contains a polymer compound having a constitutional unit (g0) represented by General Formula (g0-1) described later.

### <<Constitutional Unit (g0)>>

The constitutional unit (g0) is a constitutional unit represented by General Formula (g0-1). 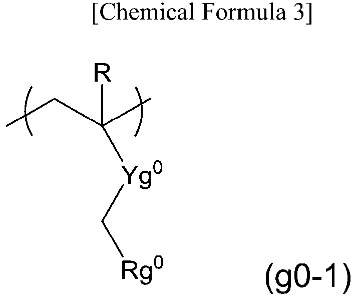 [In the formula, R represents a hydrogen atom, an alkyl group having 1 to 5 carbon atoms, or a halogenated alkyl group having 1 to 5 carbon atoms; Yg⁰ represents a divalent linking group; and Rg⁰ represents an epoxy group-containing group].

In Formula (g0-1), as the alkyl group having 1 to 5 carbon atoms as R, a linear or branched alkyl group having 1 to 5 carbon atoms is preferable, and specific examples thereof include a methyl group, an ethyl group, a propyl group, an isopropyl group, an n-butyl group, an isobutyl group, a tert-butyl group, a pentyl group, an isopentyl group, and a neopentyl group. The halogenated alkyl group having 1 to 5 carbon atoms is a group in which some or all hydrogen atoms in the alkyl group having 1 to 5 carbon atoms have been substituted with halogen atoms. As the halogen atom, a fluorine atom is particularly preferable.

R preferably represents a hydrogen atom, an alkyl group having 1 to 5 carbon atoms, or a fluorinated alkyl group having 1 to 5 carbon atoms, and most preferably a hydrogen atom or a methyl group from the viewpoint of industrial availability.

In Formula (g0-1), examples of the divalent linking group in Yg⁰ include a divalent hydrocarbon group which may have a substituent, and a divalent linking group including a heteroatom.

### · Divalent hydrocarbon group which may have substituent:

The divalent hydrocarbon group which may have a substituent may be an aliphatic hydrocarbon group or an aromatic hydrocarbon group.

### ·· Aliphatic Hydrocarbon Group

The aliphatic hydrocarbon group indicates a hydrocarbon group that has no aromaticity. The aliphatic hydrocarbon group may be saturated or unsaturated. In general, it is preferable that the aliphatic hydrocarbon group be saturated.

Examples of the aliphatic hydrocarbon group include a linear or branched aliphatic hydrocarbon group and an aliphatic hydrocarbon group having a ring in the structure thereof.

### ··· Linear or Branched Aliphatic Hydrocarbon Group

The linear aliphatic hydrocarbon group preferably has 1 to 10 carbon atoms, more preferably 1 to 6 carbon atoms, still more preferably 1 to 4 carbon atoms, and most preferably 1 to 3 carbon atoms.

As the linear aliphatic hydrocarbon group, a linear alkylene group is preferable. Specific examples thereof include a methylene group [-CH₂-], an ethylene group [-(CH₂)₂-], a trimethylene group [-(CH₂)₃-], a tetramethylene group [-(CH₂)₄-], and a pentamethylene group [-(CH₂)₅-].

The branched aliphatic hydrocarbon group preferably has 2 to 10 carbon atoms, more preferably has 3 to 6 carbon atoms, still more preferably has 3 or 4 carbon atoms, and most preferably has 3 carbon atoms.

As the branched aliphatic hydrocarbon group, a branched alkylene group is preferable. Specifically, alkylalkylene groups, for example, alkylmethylene groups such as -CH(CH₃)-, -CH(CH₂CH₃)-, -C(CH₃)₂-, -C(CH₃)(CH₂CH₃)-, -C(CH₃)(CH₂CH₂CH₃)-, and -C(CH₂CH₃)₂-; alkylethylene groups such as -CH(CH₃)CH₂-, -CH(CH₃)CH(CH₃)-, - C(CH₃)₂CH₂-, -CH(CH₂CH₃)CH₂-, and -C(CH₂CH₃)₂-CH₂-; alkyltrimethylene groups such as -CH(CH₃)CH₂CH₂-, and -CH₂CH(CH₃)CH₂-; and alkyltetramethylene groups such as -CH(CH₃)CH₂CH₂CH₂- and -CH₂CH(CH₃)CH₂CH₂- are exemplary examples. As the alkyl group in the alkylalkylene group, a linear alkyl group having 1 to 5 carbon atoms is preferable.

The linear or branched aliphatic hydrocarbon group may or may not have a substituent. Examples of the substituent include a fluorine atom, a fluorinated alkyl group having 1 to 5 carbon atoms which has been substituted with a fluorine atom, and a carbonyl group.

### ··· Aliphatic Hydrocarbon Group having Ring in Structure thereof

Examples of the aliphatic hydrocarbon group having a ring in the structure thereof include a cyclic aliphatic hydrocarbon group which may have a substituent having a heteroatom in the ring structure thereof (a group in which two hydrogen atoms have been removed from an aliphatic hydrocarbon ring), a group in which the cyclic aliphatic hydrocarbon group is bonded to the terminal of a linear or branched aliphatic hydrocarbon group, and a group in which the cyclic aliphatic hydrocarbon group is interposed in the middle of a linear or branched aliphatic hydrocarbon group. As the linear or branched aliphatic hydrocarbon group, the same groups as those described above are exemplary examples.

The cyclic aliphatic hydrocarbon group preferably has 3 to 20 carbon atoms and more preferably has 3 to 12 carbon atoms.

The cyclic aliphatic hydrocarbon group may be a polycyclic group or a monocyclic group. As the monocyclic alicyclic hydrocarbon group, a group in which two hydrogen atoms have been removed from a monocycloalkane is preferable. The monocycloalkane preferably has 3 to 6 carbon atoms, and specific examples thereof include cyclopentane and cyclohexane. As the polycyclic alicyclic hydrocarbon group, a group obtained by removing two hydrogen atoms from a polycycloalkane is preferable. The number of carbon atoms in the polycycloalkane is preferably 7 to 12, and specific examples thereof include adamantane, norbornane, isobornane, tricyclo[5.2.1.0^{2,6}]decane, and tetracyclododecane.

The cyclic aliphatic hydrocarbon group may or may not have a substituent. Examples of the substituent include an alkyl group, an alkoxy group, a halogen atom, a halogenated alkyl group, a hydroxyl group, and a carbonyl group.

As the alkyl group as the substituent, an alkyl group having 1 to 5 carbon atoms is preferable, and a methyl group, an ethyl group, a propyl group, an n-butyl group, or a tert-butyl group is more preferable.

As the alkoxy group as the substituent, an alkoxy group having 1 to 5 carbon atoms is preferable, a methoxy group, an ethoxy group, an n-propoxy group, an iso-propoxy group, an n-butoxy group, or a tert-butoxy group is more preferable, and a methoxy group or an ethoxy group is still more preferable.

As the halogen atom as the substituent, a fluorine atom is preferable.

Examples of the halogenated alkyl group as the substituent include groups in which some or all hydrogen atoms in the above-described alkyl groups are substituted with the above-described halogen atoms.

In the cyclic aliphatic hydrocarbon group, some carbon atoms constituting the ring structure thereof may be substituted with a substituent having a heteroatom. As the substituent having a heteroatom, -O-, -C(=O)-O-, -S-, -S(=O)₂-, or -S(=O)₂-O- is preferable.

### ·· Aromatic Hydrocarbon Group

The aromatic hydrocarbon group is a hydrocarbon group having at least one aromatic ring.

The aromatic ring is not particularly limited as long as the aromatic ring is a cyclic conjugated system having (4n+2) π electrons and may be monocyclic or polycyclic. The aromatic ring preferably has 5 to 30 carbon atoms, more preferably 5 to 20 carbon atoms, still more preferably 6 to 15 carbon atoms, and particularly preferably 6 to 12 carbon atoms. Here, the number of carbon atoms in a substituent is not included in the number of carbon atoms.

Specific examples of the aromatic ring include aromatic hydrocarbon rings such as benzene, naphthalene, anthracene, and phenanthrene; and aromatic heterocyclic rings in which some carbon atoms constituting the above-described aromatic hydrocarbon rings have been substituted with heteroatoms. Examples of the heteroatom in the aromatic heterocyclic rings include an oxygen atom, a sulfur atom, and a nitrogen atom. Specific examples of the aromatic heterocyclic ring include a pyridine ring and a thiophene ring.

Specific examples of the aromatic hydrocarbon group include a group in which two hydrogen atoms have been removed from the above-described aromatic hydrocarbon ring or aromatic heterocyclic ring (an arylene group or a heteroarylene group); a group in which two hydrogen atoms have been removed from an aromatic compound having two or more aromatic rings (for example, biphenyl or fluorene); and a group in which one hydrogen atom of a group (an aryl group or a heteroaryl group) obtained by removing one hydrogen atom from the above-described aromatic hydrocarbon ring or aromatic heterocyclic ring has been substituted with an alkylene group (for example, a group obtained by further removing one hydrogen atom from an aryl group in an arylalkyl group such as a benzyl group, a phenethyl group, a 1-naphthylmethyl group, a 2-naphthylmethyl group, a 1-naphthylethyl group, or a 2-naphthylethyl group). The number of carbon atoms in the alkylene group bonded to the aryl group or the heteroaryl group is preferably in a range of 1 to 4, more preferably 1 or 2, and particularly preferably 1.

In the aromatic hydrocarbon group, the hydrogen atom in the aromatic hydrocarbon group may be substituted with a substituent. For example, the hydrogen atom bonded to the aromatic ring in the aromatic hydrocarbon group may be substituted with a substituent. Examples of substituents include an alkyl group, an alkoxy group, a halogen atom, a halogenated alkyl group, and a hydroxyl group.

As the alkyl group as the substituent, an alkyl group having 1 to 5 carbon atoms is preferable, and a methyl group, an ethyl group, a propyl group, an n-butyl group, or a tert-butyl group is more preferable.

As the alkoxy group, the halogen atom, and the halogenated alkyl group as the substituents, the groups described as the substituents that substitute a hydrogen atom in the cyclic aliphatic hydrocarbon group are exemplary examples. As the halogen atom as a substituent, a bromine atom or an iodine atom is preferable, and an iodine atom is more preferable.

### · Divalent linking group having heteroatom:

Examples of the divalent linking group having a heteroatom include -O-, - C(=O)-O-, -O-C(=O)-, -C(=O)-, -O-C(=O)-O-, -C(=O)-NH-, -NH-, -NH-C(=NH)- (H may be substituted with a substituent such as an alkyl group or an acyl group), -S-, - S(=O)₂-, -S(=O)₂-O-, and a group represented by General Formula -Y²¹-O-Y²²-, -Y²¹-O-, -Y²¹-C(=O)-O-, -C(=O)-O-Y²¹-, -[Y²¹-C(=O)-O]_{m"}-Y²²-, -Y²¹-O-C(=O)Y²²-, or -Y²¹-S(=O)₂-O-Y²²- [in the formulae, Y²¹ and Y²² each independently represents a divalent hydrocarbon group which may have a substituent, O represents an oxygen atom, and m" represents an integer of 1 to 3].

In a case where the above-described divalent linking group containing a heteroatom is -C(=O)-NH-, -C(=O)-NH-C(=O)-, -NH-, or -NH-C(=NH)-, H may be substituted with a substituent such as an alkyl group and an acyl group. The substituent (alkyl group, acyl group, and the like) preferably has 1 to 10 carbon atoms, more preferably has 1 to 8 carbon atoms, and particularly preferably has 1 to 5 carbon atoms.

In General Formula -Y²¹-O-Y²²-, -Y²¹-O-, -Y²¹-C(=O)-O-, -C(=O)-O-Y²¹-, - [Y²¹-C(=O)-O]_{m"}-Y²², -Y²¹-O-C(=O)-Y²²-, or -Y²¹-S(=O)₂-O-Y²²-, Y²¹ and Y²² each independently represents a divalent hydrocarbon group which may have a substituent. Examples of the divalent hydrocarbon group include the same groups as described above.

As Y²¹, a linear aliphatic hydrocarbon group is preferable, a linear alkylene group is more preferable, a linear alkylene group having 1 to 5 carbon atoms is still more preferable, and a methylene group or an ethylene group is particularly preferable.

As Y²², a linear or branched aliphatic hydrocarbon group is preferable, and a methylene group, an ethylene group, or an alkylmethylene group is more preferable. The alkyl group in the alkylmethylene group is preferably a linear alkyl group having 1 to 5 carbon atoms, more preferably a linear alkyl group having 1 to 3 carbon atoms, and most preferably a methyl group.

In the group represented by Formula -[Y²¹-C(=O)-O]_{m"}-Y²²-, m" represents an integer of 1 to 3, preferably an integer of 1 or 2, and more preferably 1. That is, a group represented by Formula -Y²¹-C(=O)-O-Y²²- is particularly preferable as the group represented by Formula -[Y²¹-C(=O)-O]ₘ"-Y²²-. Among these, a group represented by Formula -(CH₂)_{a'}-C(=O)-O-(CH₂)_{b'}- is preferable. In the formula, a' represents an integer of 1 to 10, preferably an integer of 1 to 8, more preferably an integer of 1 to 5, still more preferably 1 or 2, and most preferably 1. b' represents an integer of 1 to 10, preferably an integer of 1 to 8, more preferably an integer of 1 to 5, still more preferably 1 or 2, and most preferably 1.

As Yg⁰, an ester bond [-C(=O)-O-, -O-C(=O)-], an ether bond (-O-), a linear or branched alkylene group, or a combination of two or more kinds thereof is preferable, and an ester bond [-C(=O)-O-, -O-C(=O)-] is more preferable.

The epoxy group-containing group in Rg⁰ of General Formula (g0-1) is not particularly limited as long as it is a group containing an epoxy ring. Examples of the epoxy group-containing group in Rg⁰ include a group represented by General Formula (rg-1) and an alicyclic epoxy group. 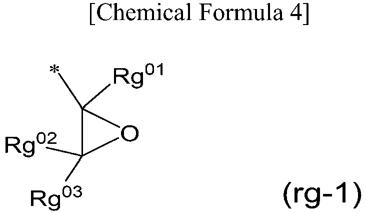 [In the formula, Rg⁰¹ to Rg⁰³ each independently represents a hydrogen atom or an alkyl group. * represents a bonding site].

In Formula (rg-1), the alkyl group in Rg⁰¹ to Rg⁰³ may be linear or branched, but is preferably a linear alkyl group. The linear alkyl group as Rg⁰¹ to Rg⁰³ is preferably an alkyl group having 1 to 5 carbon atoms, more preferably an alkyl group having 1 to 3 carbon atoms, still more preferably a methyl group or an ethyl group, and particularly preferably a methyl group. The branched alkyl group in Rg⁰¹ to Rg⁰³ preferably has 3 to 5 carbon atoms, and more preferably has 3 carbon atoms.

Rg⁰¹ to Rg⁰³ are preferably a hydrogen atom or a methyl group, and more preferably a hydrogen atom. It is still more preferable that all of Rg⁰¹ to Rg⁰³ be hydrogen atoms.

The alicyclic epoxy group is an alicyclic group including an epoxy group. Examples of the alicyclic epoxy group include a group represented by General Formula (rg-2), a group represented by General Formula (rg-3), and a group represented by General Formula (rg-4). 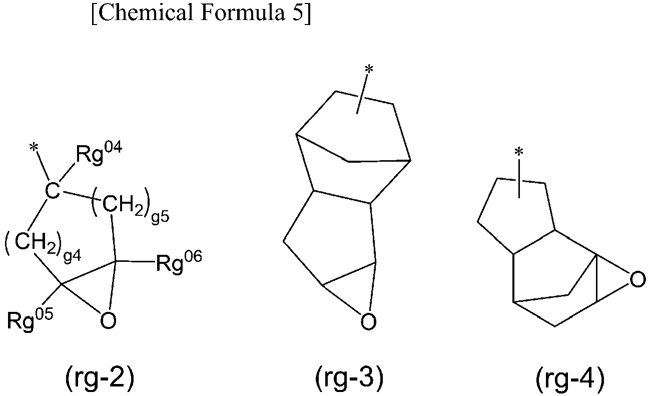 [In the formula, Rg⁰⁴ to Rg⁰⁶ each independently represents a hydrogen atom or an alkyl group; and g4 and g5 each independently represents an integer of 1 to 20. * represents a bonding site].

In Formula (rg-2), the alkyl group in Rg⁰⁴ to Rg⁰⁶ may be linear or branched, but is preferably a linear alkyl group. The linear alkyl group as Rg⁰⁴ to Rg⁰⁶ is preferably an alkyl group having 1 to 5 carbon atoms, more preferably an alkyl group having 1 to 3 carbon atoms, still more preferably a methyl group or an ethyl group, and particularly preferably a methyl group. The branched alkyl group in Rg⁰⁴ to Rg⁰⁶ preferably has 3 to 5 carbon atoms, and more preferably has 3 carbon atoms.

Rg⁰⁴ to Rg⁰⁶ are preferably a hydrogen atom or a methyl group, and more preferably a hydrogen atom. It is still more preferable that all of Rg⁰⁴ to Rg⁰⁶ be hydrogen atoms.

In Formula (rg-2), g4 is preferably an integer of 1 to 5, more preferably an integer of 1 to 3, still more preferably 1 or 2, and particularly preferably 2.

In Formula (rg-2), g5 is preferably an integer of 1 to 5, more preferably an integer of 1 to 3, still more preferably 1 or 2, and particularly preferably 1.

The constitutional unit (g0) is preferably a group represented by General Formula (g0-1-1). 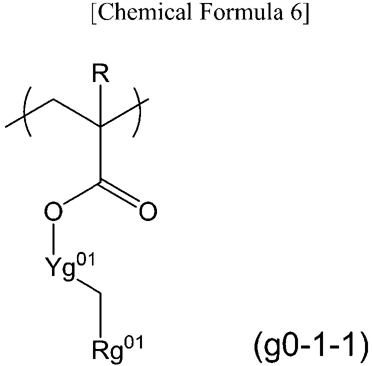 [In the formula, R represents a hydrogen atom, an alkyl group having 1 to 5 carbon atoms, or a halogenated alkyl group having 1 to 5 carbon atoms; Yg⁰¹ represents a single bond or a divalent linking group; and Rg⁰¹ represents an epoxy group-containing group].

R in Formula (g0-1-1) is the same as R in General Formula (g0-1).

Examples of the divalent linking group in Yg⁰¹ in Formula (g0-1-1) include the same ones as the divalent linking group in Yg⁰ in Formula (g0-1). Yg⁰¹ is preferably a single bond, a linear or branched alkylene group, or a combination of a linear or branched alkylene group and an ester bond or an ether bond, more preferably a single bond or a linear or branched alkylene group, and still more preferably a single bond. The linear or branched alkylene group preferably has 1 to 5 carbon atoms, more preferably has 1 to 3 carbon atoms, and still more preferably an ethylene group or a methylene group.

Examples of Rg⁰¹ in Formula (g0-1-1) include the same ones as those of Rg⁰ in Formula (g0-1). Rg⁰¹ is preferably a group represented by any of Formulae (rg-1) to (rg-4).

Specific examples of the constitutional unit (g0) are shown below, but are not limited thereto.

In the formulae shown below, R^{α} represents a hydrogen atom, a methyl group, or a trifluoromethyl group.

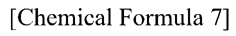

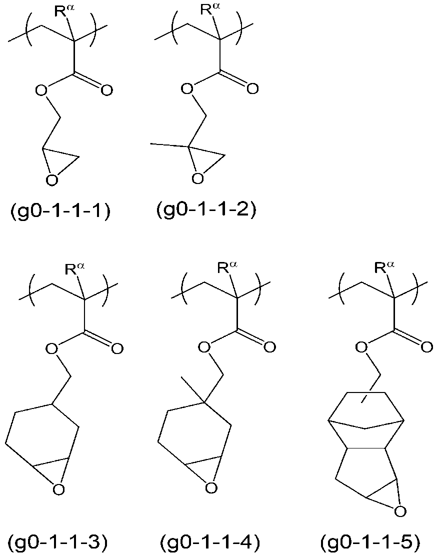

The constitutional unit (g0) contained in the component (G) may be one kind or two or more kinds.

The proportion of the constitutional unit (g0) in the component (G) is preferably 10% by mole or more, more preferably 20% by mole or more, still more preferably 30% by mole or more, even still more preferably 40% by mole or more, particularly preferably 50% by mole or more, and may be 100% by mole with respect to the total amount (100% by mole) of all constitutional units constituting the component (G).

In a case where the proportion of the constitutional unit (g0) is equal to or higher than the preferred lower limit, the crosslinking efficiency with the support is increased, and the adhesiveness between the resist film and the support is further improved.

The proportion of the constitutional unit (g0) in the component (G) is, for example, 10% to 90% by mole, preferably 20% to 80% by mole, more preferably 30% to 80% by mole, still more preferably 40% to 80% by mole, and particularly preferably 50% to 80% by mole, with respect to the total amount (100% by mole) of all constitutional units constituting the component (G).

In a case where the proportion of the constitutional unit (g0) is equal to or less than the preferred upper limit, a balance with other constitutional units can be maintained, and various lithography characteristics in a case where a resist pattern is formed are enhanced.

### <<Other Constitutional Units>>

The component (G) may have another constitutional unit in addition to the above-described constitutional unit (g0). Examples of the other constitutional units include a constitutional unit (a11) derived from (α-substituted) acrylic acid or (α-substituted) methyl acrylate, a constitutional unit (a10) represented by General Formula (a10-1), a constitutional unit (a2) including a lactone-containing cyclic group, and a constitutional unit (a8) derived from a compound represented by General Formula (a8-1) described later.

Among these, examples of other preferred constitutional units include the constitutional unit (a11) and the constitutional unit (a10).

### · Constitutional Unit (a11)

The component (G) may have the constitutional unit (a11). A constitutional unit represented by General Formula (a11-1) is preferable as the constitutional unit (a11). 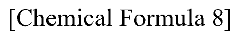 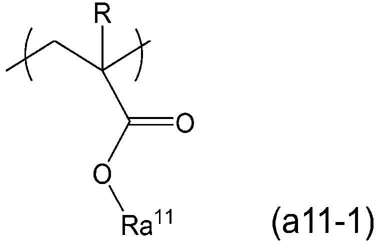 [In the formula, R represents a hydrogen atom, an alkyl group having 1 to 5 carbon atoms, or a halogenated alkyl group having 1 to 5 carbon atoms; and Ra¹¹ represents a hydrogen atom or a methyl group].

R in Formula (a11-1) is the same as R in General Formula (g0-1). R is preferably a hydrogen atom, an alkyl group having 1 to 5 carbon atoms, or a fluorinated alkyl group having 1 to 5 carbon atoms, and particularly preferably a hydrogen atom or a methyl group.

In Formula (a11-1), Ra¹¹ is preferably a hydrogen atom.

Specific examples of the constitutional unit (a11) are shown below, but the present invention is not limited thereto.

In the formulae shown below, R^{α} represents a hydrogen atom, a methyl group, or a trifluoromethyl group.

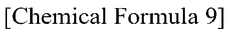

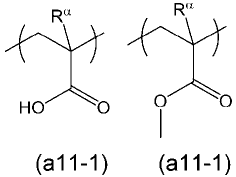

In a case where the component (G) has the constitutional unit (a11), the constitutional unit (a11) may be one kind or two or more kinds. The component (G) may or may not have the constitutional unit (a11).

In a case where the component (G) has the constitutional unit (a11), the proportion of the constitutional unit (a11) in the component (G) is, for example, 1% to 50% by mole, preferably 5% to 40% by mole, more preferably 10% to 30% by mole, and still more preferably 10% to 20% by mole with respect to the total amount (100% by mole) of all constitutional units constituting the component (G).

In a case where the proportion of the constitutional unit (a11) is within the preferred range, various lithography characteristics in a case where a resist pattern is formed on the surface-modified layer formed of the composition for forming a surface-modified layer according to the present embodiment are enhanced.

### Constitutional unit (a10):

The component (G) may have a constitutional unit (a10). The constitutional unit (a10) is a constitutional unit represented by General Formula (a10-1). 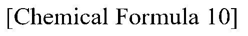 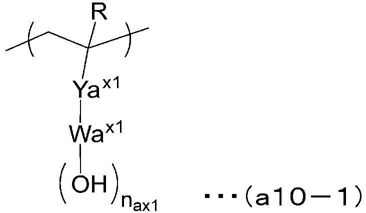 [In the formula, R represents a hydrogen atom, an alkyl group having 1 to 5 carbon atoms, or a halogenated alkyl group having 1 to 5 carbon atoms. Ya^{x1} represents a single bond or a divalent linking group. Wa^{x1} represents an aromatic hydrocarbon group which may have a substituent. nₐₓ₁ represents an integer of 1 or greater].

R in Formula (a10-1) is the same as R in General Formula (g0-1). R is preferably a hydrogen atom, an alkyl group having 1 to 5 carbon atoms, or a fluorinated alkyl group having 1 to 5 carbon atoms, and particularly preferably a hydrogen atom or a methyl group.

In Formula (a10-1), examples of the divalent linking group in Ya^{x1} include the same ones as the divalent linking group in Yg⁰ of General Formula (g0-1).

Ya^{x1} preferably represents a single bond, an ester bond [-C(=O)-O-, -O-C(=O)-], an ether bond (-O-), a linear or branched alkylene group, or a combination of two or more kinds thereof, and more preferably a single bond or an ester bond [-C(=O)-O-, -O-C(=O)-] .

In Formula (a10-1), Wa^{x1} represents an aromatic hydrocarbon group which may have a substituent.

Examples of the aromatic hydrocarbon group as Wa^{x1} include a group obtained by removing (nₐₓ₁+1) hydrogen atoms from an aromatic ring which may have a substituent. The aromatic ring is not particularly limited as long as the aromatic ring is a cyclic conjugated system having (4n+2) π electrons. The aromatic ring preferably has 5 to 30 carbon atoms, more preferably 5 to 20 carbon atoms, still more preferably 6 to 15 carbon atoms, and particularly preferably 6 to 12 carbon atoms. Specific examples of the aromatic ring include aromatic hydrocarbon rings such as benzene, naphthalene, anthracene, and phenanthrene; and an aromatic heterocyclic ring obtained by substituting some carbon atoms constituting the above-described aromatic hydrocarbon ring with a heteroatom. Examples of the heteroatom in the aromatic heterocyclic rings include an oxygen atom, a sulfur atom, and a nitrogen atom. Specific examples of the aromatic heterocyclic ring include a pyridine ring and a thiophene ring.

Examples of the aromatic hydrocarbon group as Wa^{x1} also include a group obtained by removing (nₐₓ₁+1) hydrogen atoms from an aromatic compound including an aromatic ring (for example, biphenyl or fluorene) which may have two or more substituents.

Among these, Wa^{x1} preferably represents a group in which (nₐₓ₁+ 1) hydrogen atoms have been removed from benzene, naphthalene, anthracene, or biphenyl, more preferably a group in which (nₐₓ₁+1) hydrogen atoms have been removed from benzene or naphthalene, and still more preferably a group in which (nₐₓ₁+ 1) hydrogen atoms have been removed from benzene.

The aromatic hydrocarbon group as Wa^{x1} may or may not have a substituent. Examples of the substituent include an alkyl group, an alkoxy group, a halogen atom, and a halogenated alkyl group. Examples of the alkyl group, the alkoxy group, the halogen atom, and the halogenated alkyl group, as the substituent, include the same groups as those for the above-described substituent of the cyclic aliphatic hydrocarbon group as Ya^{x1}. The substituent is preferably a linear or branched alkyl group having 1 to 5 carbon atoms, more preferably a linear or branched alkyl group having 1 to 3 carbon atoms, still more preferably an ethyl group or a methyl group, and particularly preferably a methyl group. It is preferable that the aromatic hydrocarbon group as Wa^{x1} not have a substituent.

In Formula (a10-1), nₐₓ₁ represents an integer of 1 or greater, preferably an integer of 1 to 10, more preferably an integer of 1 to 5, still more preferably 1, 2, or 3, and particularly preferably 1 or 2.

Specific examples of the constitutional unit (a10) are shown below. In the formulae shown below, R^{α} represents a hydrogen atom, a methyl group, or a trifluoromethyl group.

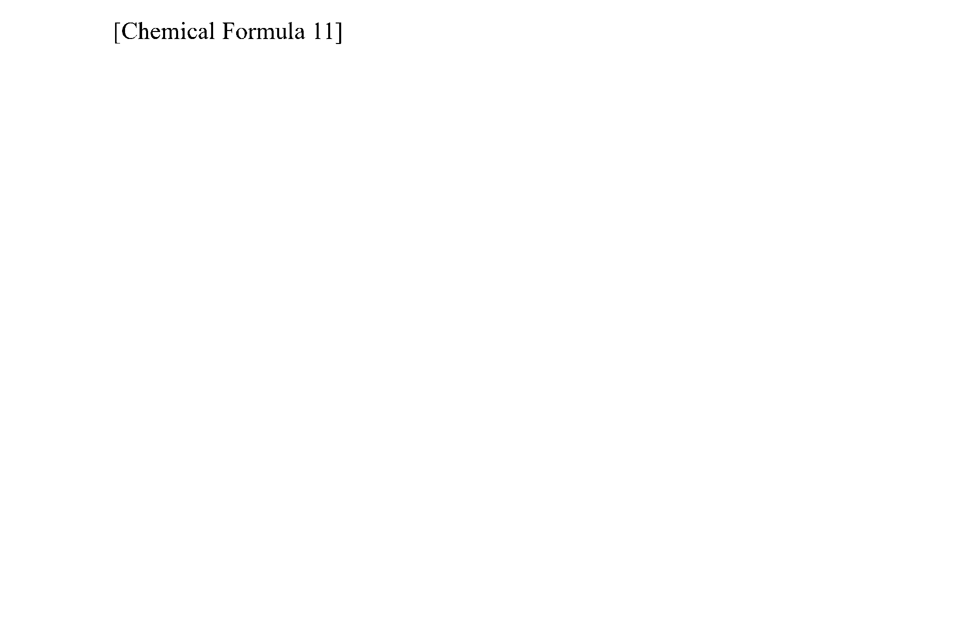

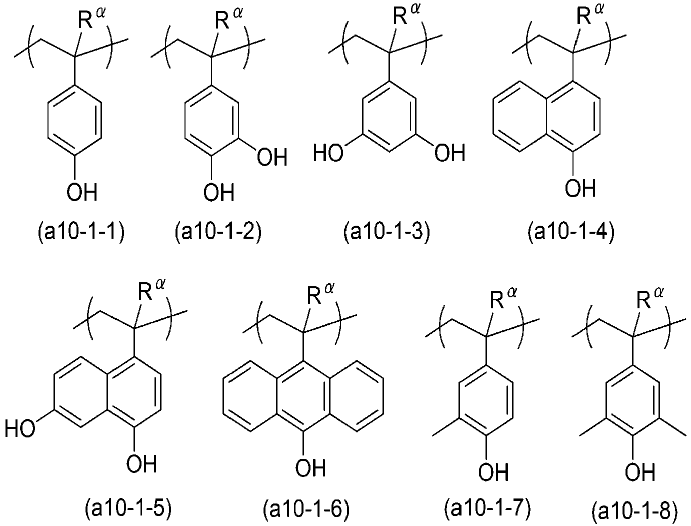

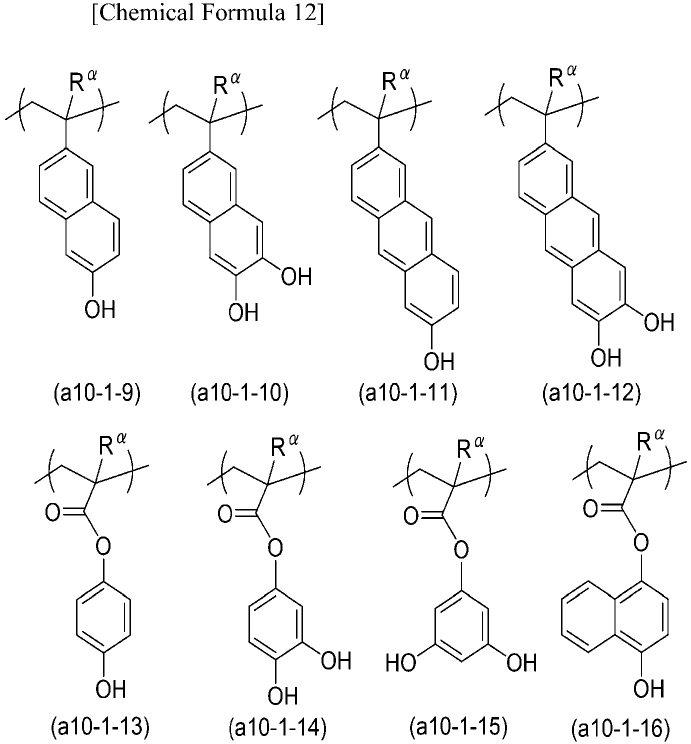

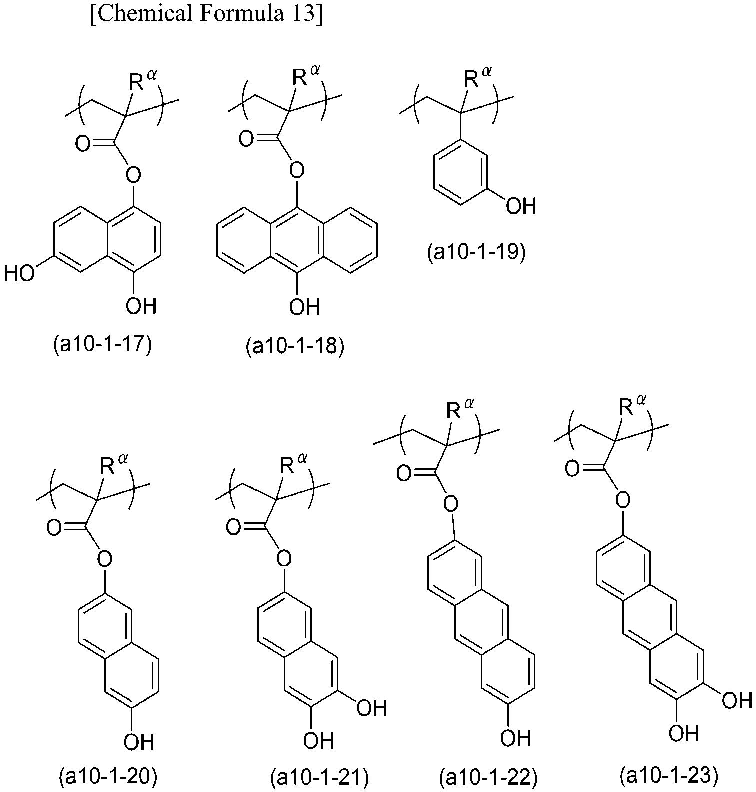

In a case where the component (G) has the constitutional unit (a10), the constitutional unit (a10) may be one kind or two or more kinds. The component (G) may or may not have the constitutional unit (a10).

In a case where the component (G) has the constitutional unit (a10), the proportion of the constitutional unit (a10) in the component (G) is preferably in a range of 20% to 80% by mole, more preferably in a range of 25% to 70% by mole, still more preferably in a range of 30% to 60% by mole, and particularly preferably in a range of 30% to 50% by mole with respect to the total amount (100% by mole) of all constitutional units constituting the component (G).

In a case where the proportion of the constitutional unit (a10) is within the preferred range, various lithography characteristics in a case where a resist pattern is formed on the surface-modified layer formed of the composition for forming a surface-modified layer according to the present embodiment are enhanced.

The component (G) contained in the composition for forming a surface-modified layer according to the present embodiment may be used alone or in combination of two or more kinds thereof.

Examples of the component (G) include a polymer compound consisting of a repeating structure of the constitutional unit (g0); a polymer compound including a repeating structure of the constitutional unit (g0) and the constitutional unit (a10); and a polymer compound including a repeating structure of the constitutional unit (g0) and the constitutional unit (a11).

In the polymer compound having a repeating structure of the constitutional unit (g0) and the constitutional unit (a10), the proportion of the constitutional unit (g0) is preferably in a range of 20% to 80% by mole, more preferably in a range of 30% to 70% by mole, still more preferably in a range of 40% to 70% by mole, and particularly preferably in a range of 50% to 60% by mole with respect to the total amount (100% by mole) of all constitutional units constituting the polymer compound. The proportion of the constitutional unit (a10) is preferably 20% to 80% by mole, more preferably 30% to 70% by mole, still more preferably 30% to 60% by mole, and particularly preferably 40% to 50% by mole with respect to the total amount (100% by mole) of all constitutional units constituting the polymer compound.

In the polymer compound having a repeating structure of the constitutional unit (g0) and the constitutional unit (a11), the proportion of the constitutional unit (g0) is preferably in a range of 20% to 80% by mole, more preferably in a range of 30% to 80% by mole, still more preferably in a range of 40% to 80% by mole, and particularly preferably in a range of 50% to 80% by mole with respect to the total amount (100% by mole) of all constitutional units constituting the polymer compound. The proportion of the constitutional unit (a11) is preferably 20% to 80% by mole, more preferably 20% to 70% by mole, still more preferably 20% to 60% by mole, and particularly preferably 20% to 50% by mole with respect to the total amount (100% by mole) of all constitutional units constituting the polymer compound.

The component (G) can be produced by dissolving, in a polymerization solvent, each of monomers from which constitutional units are derived, and adding thereto a radical polymerization initiator such as azobisisobutyronitrile (AIBN) or dimethyl azobisisobutyrate (for example, V-601) to carry out polymerization.

Alternatively, the component (G) can be produced by dissolving, in a polymerization solvent, a monomer from which the constitutional unit (g0) is derived and a monomer from which an optional constitutional unit (for example, the constitutional unit (a10), the constitutional unit (a11) or the like) is derived, adding a radical polymerization initiator as described above thereto to carry out polymerization, and carrying out a deprotection reaction.

Further, a -C(CF₃)₂-OH group may be introduced into the terminal during the polymerization using a chain transfer agent such as HS-CH₂-CH₂-CH₂-C(CF₃)₂-OH in combination.

The weight-average molecular weight (Mw) (in terms of polystyrene equivalent, determined by gel permeation chromatography (GPC)) of the component (G) is, for example, preferably 1,000 to 50,000, more preferably 2,000 to 40,000, still more preferably 3,000 to 30,000, and particularly preferably 3,000 to 20,000.

(G) In a case where the weight-average molecular weight of the component is within the above-described range, the adhesiveness of the resist film to the support is further enhanced.

The dispersity (Mw/Mn) of the component (G) is not particularly limited, and is preferably 1.0 to 4.0, and more preferably 1.0 to 3.0. Further, Mn represents the number-average molecular weight.

Specific examples of the component (G) are shown below but are not limited thereto.

In the formulae shown below, R^{α} represents a hydrogen atom, a methyl group, or a trifluoromethyl group.

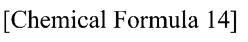

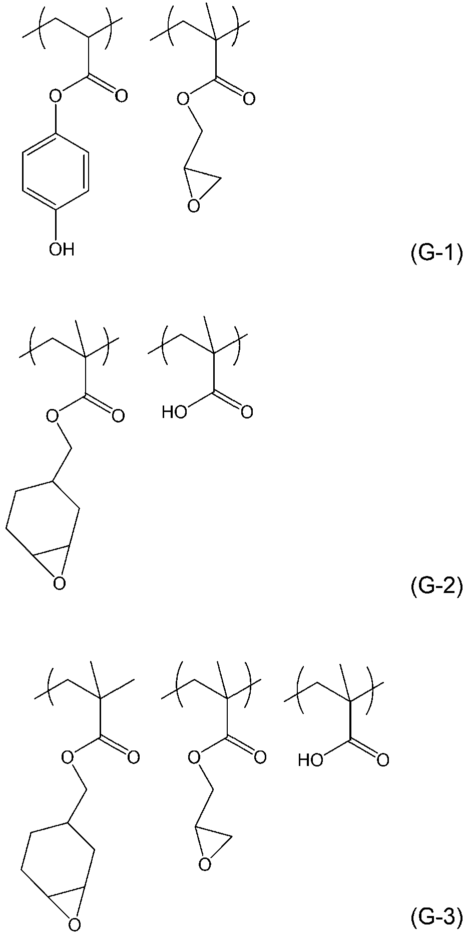

### <Resin Component (P): Component (P)>

The component (P) includes a polymer compound having a constitutional unit (p0) represented by General Formula (p0-1) described later.

### <<Constitutional Unit (p0)>>

The constitutional unit (p0) is a constitutional unit represented by General Formula (p0-1). 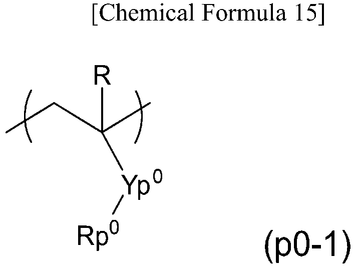 [In the formula, R represents a hydrogen atom, an alkyl group having 1 to 5 carbon atoms, or a halogenated alkyl group having 1 to 5 carbon atoms; Yp⁰ represents a divalent linking group; and Rp⁰ represents a chain-like hydrocarbon group having 2 to 20 carbon atoms, which may have a substituent].

R in Formula (p0-1) is the same as R in General Formula (g0-1). R is preferably a hydrogen atom, an alkyl group having 1 to 5 carbon atoms, or a fluorinated alkyl group having 1 to 5 carbon atoms, and particularly preferably a hydrogen atom or a methyl group.

In Formula (p0-1), examples of the divalent linking group in Yp⁰ include the same ones as those in Yg⁰ in General Formula (g0-1).

As Yp⁰, an ester bond [-C(=O)-O-, -O-C(=O)-], an ether bond (-O-), a linear or branched alkylene group, or a combination of two or more kinds thereof is preferable, and an ester bond [-C(=O)-O-, -O-C(=O)-] is more preferable.

In Formula (p0-1), the chain-like hydrocarbon group in Rp⁰ may be saturated or unsaturated, but is preferably saturated. As the chain-like hydrocarbon group in Rp⁰, a linear or branched alkyl group is preferable, and a linear alkyl group is more preferable.

The linear alkyl group as Rp⁰ preferably has 2 to 16 carbon atoms, more preferably 2 to 14 carbon atoms, still more preferably 2 to 10 carbon atoms, and particularly preferably 2 to 8 carbon atoms.

The branched alkyl group as Rp⁰ preferably has 3 to 16 carbon atoms, more preferably 3 to 16 carbon atoms, still more preferably 3 to 10 carbon atoms, and particularly preferably 3 to 8 carbon atoms.

The chain-like hydrocarbon group in Rp⁰ may have a substituent. The substituent which may be contained in the chain-like hydrocarbon group in Rp⁰ may be a monovalent substituent which substitutes a hydrogen atom (-H) contained in the hydrocarbon chain or a divalent substituent which substitutes a methylene group (-CH₂-) constituting the hydrocarbon chain.

Examples of the substituent for substituting the hydrogen atom include a fluorine atom, a carboxy group, and a hydroxy group. The chain-like hydrocarbon group in Rp⁰ preferably does not have a substituent that substitutes a hydrogen atom.

Examples of the divalent substituent that substitutes a methylene group constituting a hydrocarbon chain include -O-, -C(=O)-O-, -O-C(=O)-, -C(=O)-, -O-C(=O)-O-, -C(=O)-NH-, -NH-, -NH-C(=NH)- (H may be substituted with a substituent such as an alkyl group or an acyl group), -S-, -S(=O)₂-, and -S(=O)₂-O-. As the divalent substituent, -O- is preferable.

As Rp⁰, -(CH₂)ₚ₂-CH₃ (p2 is an integer of 1 to 19) or -(CH₂)ₚ₁-O-CH₃ (p1 is an integer of 1 to 19) is preferable. p1 and p2 are preferably 1 to 15, more preferably 1 to 13, still more preferably 1 to 9, and particularly preferably 1 to 7.

As the constitutional unit (p0), a constitutional unit represented by General Formula (p0-1-1) (hereinafter, also referred to as a "constitutional unit (p01)") or a constitutional unit represented by General Formula (p0-1-2) (hereinafter, also referred to as a "constitutional unit (p02)") is preferable. 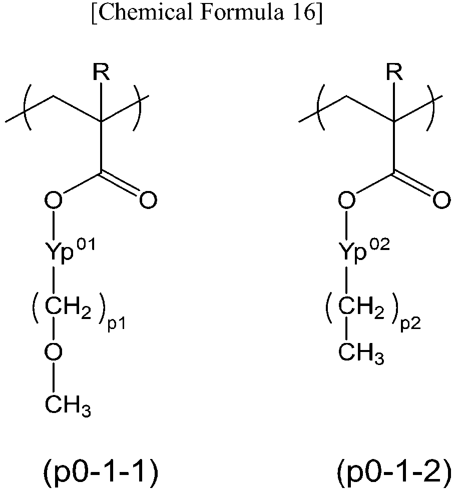 [In the formula, R represents a hydrogen atom, an alkyl group having 1 to 5 carbon atoms, or a halogenated alkyl group having 1 to 5 carbon atoms; Yp⁰¹ and Yp⁰² each independently represents a single bond or a divalent linking group; and p1 and p2 each independently represents an integer of 1 to 19].

R in Formulae (p0-1-1) and (p0-1-2) is the same as R in General Formula (g0-1). R is preferably a hydrogen atom, an alkyl group having 1 to 5 carbon atoms, or a fluorinated alkyl group having 1 to 5 carbon atoms, and particularly preferably a hydrogen atom or a methyl group.

Examples of the divalent linking group in Yp⁰¹ and Yp⁰² in Formulae (p0-1-1) and (p0-1-2) include the same ones as those of Yg⁰ in General Formula (g0-1).

As Yp⁰¹ and Yp⁰², a single bond, a linear or branched alkylene group, or a combination of a linear or branched alkylene group and an ester bond or an ether bond is preferable, a single bond or a linear or branched alkylene group is more preferable, and a single bond is still more preferable. The linear or branched alkylene group preferably has 1 to 5 carbon atoms, more preferably has 1 to 3 carbon atoms, and still more preferably an ethylene group or a methylene group.

In Formulae (p0-1-1) and (p0-1-2), p1 and p2 are preferably 1 to 15, more preferably 1 to 13, still more preferably 1 to 9, and particularly preferably 1 to 7.

Specific examples of the constitutional unit (p0) are shown below, but the present invention is not limited thereto.

In the formulae shown below, R^{α} represents a hydrogen atom, a methyl group, or a trifluoromethyl group.

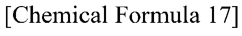

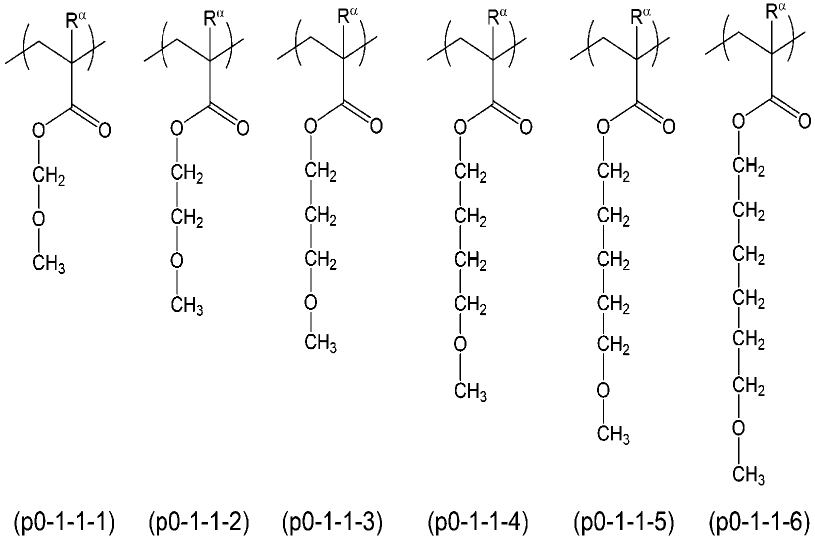

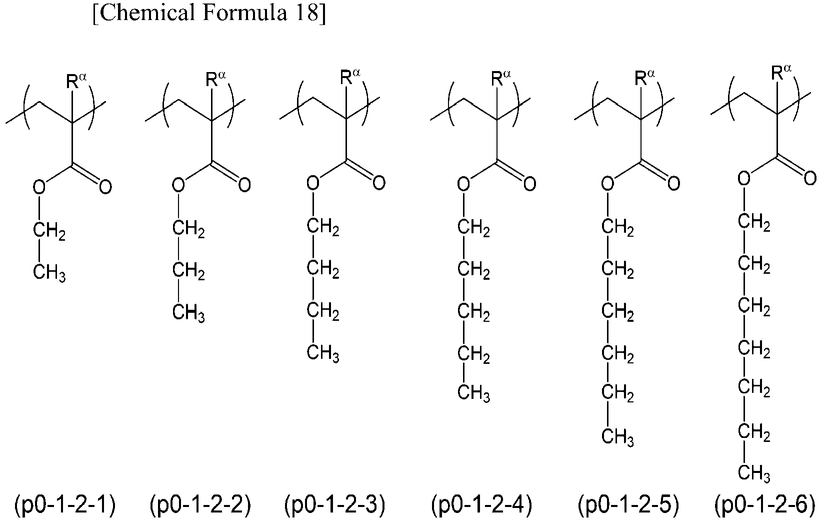

The constitutional unit (p0) contained in the component (P) may be one kind or may be two or more kinds. The constitutional unit (p0) is preferably two or more kinds. It is preferable that the component (P) have one or more kinds of the constitutional units (p01), and one or more kinds of the constitutional units (p02). In a case where the component (P) includes two or more kinds of constitutional units (p0), the adhesiveness of the resist film to the support can be further improved, and pattern collapse is less likely to occur even in a case where a fine resist pattern is formed.

In a case where the component (P) has the constitutional unit (p01) and the constitutional unit (p02) as the constitutional unit (p0), examples of a molar ratio (constitutional unit (p01): constitutional unit (p02)) between the constitutional unit (p01) and the constitutional unit (p02) include 10:90 to 90:10, and the molar ratio is preferably 30:70 to 90:10, more preferably 40:60 to 80:20, and still more preferably 50:50 to 80:20. In a case where the molar ratio of the constitutional unit (p01) to the constitutional unit (p02) is within the preferred range, the adhesiveness of the resist film to the support can be further improved.

The proportion of the constitutional unit (p0) in the component (P) is preferably 10% by mole or more, more preferably 20% by mole or more, still more preferably 30% by mole or more, even still more preferably 40% by mole or more, and particularly preferably 50% by mole or more with respect to the total amount (100% by mole) of all the constitutional units constituting the component (P), and may be 100% by mole.

In a case where the proportion of the constitutional unit (p0) is equal to or higher than the preferred lower limit, the adhesiveness between the resist film and the support is further improved, and the residue after the formation of the resist pattern is further reduced.

The proportion of the constitutional unit (p0) in the component (P) is, for example, 10% to 90% by mole, preferably 20% to 90% by mole, more preferably 30% to 90% by mole, still more preferably 40% to 90% by mole, and particularly preferably 50% to 90% by mole, with respect to the total amount (100% by mole) of all constitutional units constituting the component (P).

In a case where the proportion of the constitutional unit (g0) is equal to or less than the preferred upper limit, a balance with other constitutional units can be maintained, and various lithography characteristics in a case where a resist pattern is formed are enhanced.

### <<Other Constitutional Units>>

The component (P) may have other constitutional units in addition to the constitutional unit (p0). Examples of the other constitutional units include a constitutional unit (a1) including an acid-decomposable group of which the polarity is increased by the action of an acid, the constitutional unit (a11) described above, the constitutional unit (a10) described above, a constitutional unit (a2) including a lactone-containing cyclic group, and a constitutional unit (a8) derived from a compound represented by General Formula (a8-1) described later.

Among these, preferred other constitutional units include the constitutional unit (a1) and the constitutional unit (a11).

### Constitutional unit (a1):

The component (P) may have the constitutional unit (a1). The constitutional unit (a1) is a constitutional unit that contains an acid-decomposable group of which the polarity is increased due to the action of an acid.

Examples of the acid-dissociable group are the same as those which have been suggested as the acid-dissociable groups of the base resin for a chemically amplified-type resist composition.

Specific examples of the suggested acid-dissociable group of the base resin for a chemically amplified-type resist composition include "acetal type acid-dissociable group", "tertiary alkyl ester type acid-dissociable group", "tertiary alkyloxycarbonyl acid-dissociable group", and "secondary alkyloxycarbonyl acid-dissociable group" described below.

### Acetal type acid-dissociable group:

Examples of the acid-dissociable group that protects a carboxy group or a hydroxyl group in the polar groups include an acid-dissociable group represented by General Formula (a1-r-1) (hereinafter, also referred to as "acetal type acid-dissociable group"). 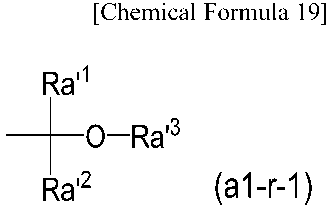 [In the formula, Ra'¹ and Ra'² represent a hydrogen atom or an alkyl group. Ra'³ represents a hydrocarbon group, and Ra'³ may be bonded to any of Ra'¹ and Ra'² to form a ring].

In Formula (a1-r-1), it is preferable that at least one of Ra'¹ and Ra'² represent a hydrogen atom and more preferable that both Ra'¹ and Ra'² represent a hydrogen atom.

In a case where Ra'¹ or Ra'² represents an alkyl group, examples of the alkyl group include the same alkyl groups described as the substituent which may be bonded to the carbon atom at the α-position in the description on α-substituted acrylic acid ester. Among these, an alkyl group having 1 to 5 carbon atoms is preferable. Specific preferred examples thereof include linear or branched alkyl groups. More specific examples thereof include a methyl group, an ethyl group, a propyl group, an isopropyl group, an n-butyl group, an isobutyl group, a tert-butyl group, a pentyl group, an isopentyl group, and a neopentyl group. Among these, a methyl group or an ethyl group is more preferable, and a methyl group is particularly preferable.

In Formula (a1-r-1), examples of the hydrocarbon group as Ra'³ include a linear or branched alkyl group and a cyclic hydrocarbon group.

The linear alkyl group preferably has 1 to 5 carbon atoms, more preferably 1 to 4 carbon atoms, and still more preferably 1 or 2 carbon atoms. Specific examples thereof include a methyl group, an ethyl group, an n-propyl group, an n-butyl group, and an n-pentyl group. Among these, a methyl group, an ethyl group, or an n-butyl group is preferable, and a methyl group or an ethyl group is more preferable.

The branched alkyl group preferably has 3 to 10 carbon atoms and more preferably 3 to 5 carbon atoms. Specific examples thereof include an isopropyl group, an isobutyl group, a tert-butyl group, an isopentyl group, a neopentyl group, a 1,1-diethylpropyl group, and a 2,2-dimethylbutyl group. Among these, an isopropyl group is preferable.

In a case where Ra'³ represents a cyclic hydrocarbon group, the hydrocarbon group may be an aliphatic hydrocarbon group or an aromatic hydrocarbon group and may be a polycyclic group or a monocyclic group.

As the aliphatic hydrocarbon group which is a monocyclic group, a group in which one hydrogen atom has been removed from a monocycloalkane is preferable.
The monocycloalkane preferably has 3 to 6 carbon atoms, and specific examples thereof include cyclopentane and cyclohexane.

As the aliphatic hydrocarbon group which is a polycyclic group, a group in which one hydrogen atom has been removed from a polycycloalkane is preferable. As the polycycloalkane, a group having 7 to 12 carbon atoms is preferable, and specific examples thereof include adamantane, norbornane, isobornane, tricyclo[5.2.1.0^{2,6}]decane, and tetracyclododecane.

In a case where the cyclic hydrocarbon group as Ra'³ becomes an aromatic hydrocarbon group, the aromatic hydrocarbon group is a hydrocarbon group having at least one aromatic ring.

The aromatic ring is not particularly limited as long as the aromatic ring is a cyclic conjugated system having (4n+2) π electrons and may be monocyclic or polycyclic. The aromatic ring preferably has 5 to 30 carbon atoms, more preferably 5 to 20 carbon atoms, still more preferably 6 to 15 carbon atoms, and particularly preferably 6 to 12 carbon atoms.

Specific examples of the aromatic ring include aromatic hydrocarbon rings such as benzene, naphthalene, anthracene, and phenanthrene; and aromatic heterocyclic rings in which some carbon atoms constituting the above-described aromatic hydrocarbon rings have been substituted with heteroatoms. Examples of the heteroatom in the aromatic heterocyclic rings include an oxygen atom, a sulfur atom, and a nitrogen atom. Specific examples of the aromatic heterocyclic ring include a pyridine ring and a thiophene ring.

Specific examples of the aromatic hydrocarbon group as Ra'³ include a group in which one hydrogen atom has been removed from the above-described aromatic hydrocarbon ring or aromatic heterocyclic ring (such as an aryl group or a heteroaryl group); a group in which one hydrogen atom has been removed from an aromatic compound having two or more aromatic rings (such as biphenyl or fluorene); and a group in which one hydrogen atom of the above-described aromatic hydrocarbon ring or aromatic heterocyclic ring has been substituted with an alkylene group (for example, an arylalkyl group such as a benzyl group, a phenethyl group, a 1-naphthylmethyl group, a 2-naphthylmethyl group, a 1-naphthylethyl group, or a 2-naphthylethyl group). The number of carbon atoms in the alkylene group bonded to the aromatic hydrocarbon ring or aromatic heterocyclic ring is preferably in a range of 1 to 4, more preferably 1 or 2, and particularly preferably 1.

The cyclic hydrocarbon group as Ra'³ may have a substituent. Examples of this substituent include Ra^{x5} described above.

In a case where Ra'³ is bonded to any of Ra'¹ and Ra'² to form a ring, the cyclic group is preferably a 4- to 7-membered ring and more preferably a 4- to 6-membered ring. Specific examples of the cyclic group include a tetrahydropyranyl group and a tetrahydrofuranyl group.

### Tertiary alkyl ester type acid-dissociable group:

Examples of the acid-dissociable group that protects a carboxy group among the polar groups include an acid-dissociable group represented by General Formula (a1-r-2).

Among examples of the acid-dissociable group represented by Formula (a1-r-2), hereinafter, a group formed of an alkyl group will also be referred to as "tertiary alkyl ester type acid-dissociable group" for convenience. 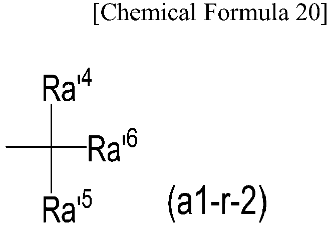 [In the formula, Ra'⁴ to Ra'⁶ each represents a hydrocarbon group, and Ra'⁵ and Ra'⁶ may be bonded to each other to form a ring].

Examples of the hydrocarbon group as Ra'⁴ include a linear or branched alkyl group, a chain-like or cyclic alkenyl group, and a cyclic hydrocarbon group.

Examples of the linear or branched alkyl group and the cyclic hydrocarbon group (an aliphatic hydrocarbon group which is a monocyclic group, an aliphatic hydrocarbon group which is a polycyclic group, or an aromatic hydrocarbon group) as Ra'⁴ include the same groups as those for Ra'³.

As the chain-like or cyclic alkenyl group as Ra'⁴, an alkenyl group having 2 to 10 carbon atoms is preferable.

Examples of the hydrocarbon group as Ra'⁵ or Ra'⁶ include the same groups as those for Ra'³.

In a case where Ra'⁵ and Ra'⁶ are bonded to each other to form a ring, suitable examples thereof include a group represented by General Formula (a1-r2-1), a group represented by General Formula (a1-r2-2), and a group represented by General Formula (a1-r2-3).

Meanwhile, in a case where Ra'⁴ to Ra'⁶ represent an independent hydrocarbon group without being bonded to each other, suitable examples thereof include a group represented by General Formula (a1-r2-4). 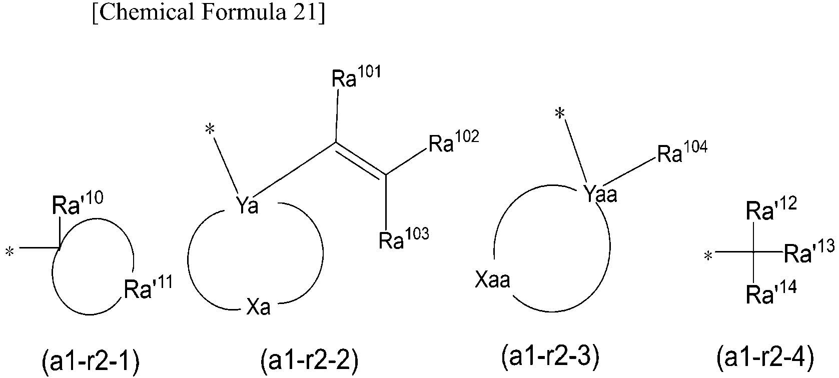 [In Formula (a1-r2-1), Ra'¹⁰ represents a linear or branched alkyl group having 1 to 12 carbon atoms, in which a part thereof may be substituted with a halogen atom or a heteroatom-containing group. Ra'¹¹ represents a group that forms an aliphatic cyclic group with the carbon atom to which Ra'¹⁰ has been bonded. In Formula (a1-r2-2), Ya represents a carbon atom. Xa represents a group that forms a cyclic hydrocarbon group with Ya. Some or all hydrogen atoms in this cyclic hydrocarbon group may be substituted. Ra¹⁰¹ to Ra¹⁰³ each independently represents a hydrogen atom, a chain-like monovalent saturated hydrocarbon group having 1 to 10 carbon atoms, or a monovalent aliphatic cyclic saturated hydrocarbon group having 3 to 20 carbon atoms. Some or all hydrogen atoms in the chain-like saturated hydrocarbon group and the aliphatic cyclic saturated hydrocarbon group may be substituted. Two or more of Ra¹⁰¹ to Ra¹⁰³ may be bonded to each other to form a cyclic structure. In Formula (a1-r2-3), Yaa represents a carbon atom. Xaa represents a group that forms an aliphatic cyclic group with Yaa. Ra¹⁰⁴ represents an aromatic hydrocarbon group which may have a substituent. In Formula (a1-r2-4), Ra'¹² and Ra'¹³ each independently represents a chain-like monovalent saturated hydrocarbon group having 1 to 10 carbon atoms. Some or all hydrogen atoms contained in the chain-like saturated hydrocarbon group may be substituted. Ra'¹⁴ represents a hydrocarbon group which may have a substituent. * represents a bonding site (the same applies hereinafter)].

In Formula (a1-r2-1), Ra'¹⁰ represents a linear or branched alkyl group having 1 to 12 carbon atoms, in which a part thereof may be substituted with a halogen atom or a heteroatom-containing group.

The linear alkyl group as Ra'¹⁰ has 1 to 12 carbon atoms, preferably 1 to 10 carbon atoms, and particularly preferably 1 to 5 carbon atoms.

Examples of the branched alkyl group as Ra'¹⁰ include the same groups as those for Ra'³ described above.

The alkyl group in Ra'¹⁰ may be partially substituted with a halogen atom or a heteroatom-containing group. For example, some hydrogen atoms constituting the alkyl group may be substituted with a halogen atom or a heteroatom-containing group. Further, some carbon atoms (methylene group or the like) constituting the alkyl group may be substituted with a heteroatom-containing group. Examples of the heteroatoms here include an oxygen atom, a nitrogen atom, and a sulfur atom. Examples of the heteroatom-containing group include (-O-), -C(=O)-O-, -O-C(=O)-, -C(=O)-, -O-C(=O)-O-, -C(=O)-NH-, -NH-, -S-, -S(=O)₂-, and -S(=O)₂-O-.

In Formula (a1-r2-1), preferred examples of Ra'¹¹ (an aliphatic cyclic group that is formed together with a carbon atom to which Ra'¹⁰ is bonded) include the groups described as the aliphatic hydrocarbon group (alicyclic hydrocarbon group) which is a monocyclic group or a polycyclic group as Ra'³ in Formula (a1-r-1). Among them, it is preferably a monocyclic alicyclic hydrocarbon group, and specifically, it is more preferably a cyclopentyl group or a cyclohexyl group.

In Formula (a1-r2-2), examples of the cyclic hydrocarbon group that is formed by Xa together with Ya include a group formed by further removing one or more hydrogen atoms from the cyclic monovalent hydrocarbon group (an aliphatic hydrocarbon group) as Ra'³ in Formula (al-r-1).

The cyclic hydrocarbon group that is formed by Xa together with Ya may have a substituent. Examples of the substituent include the same as those which may be included in the cyclic hydrocarbon group as Ra'³.

In Formula (a1-r2-2), examples of the chain-like monovalent saturated hydrocarbon group having 1 to 10 carbon atoms as Ra¹⁰¹ to Ra¹⁰³ include a methyl group, an ethyl group, a propyl group, a butyl group, a pentyl group, a hexyl group, a heptyl group, an octyl group, and a decyl group.

Examples of the monovalent aliphatic cyclic saturated hydrocarbon group having 3 to 20 carbon atoms as Ra¹⁰¹ to Ra¹⁰³ include a monocyclic aliphatic saturated hydrocarbon group such as a cyclopropyl group, a cyclobutyl group, a cyclopentyl group, a cyclohexyl group, a cycloheptyl group, a cyclooctyl group, a cyclodecyl group, or a cyclododecyl group; and a polycyclic aliphatic saturated hydrocarbon group such as a bicyclo[2.2.2] octanyl group, a tricyclo[5.2.1.0^{2,6}] decanyl group, a tricyclo[3.3.1.1^{3,7}] decanyl group, a tetracyclo[6.2.1.1^{3,6}.0^{2,7}] dodecanyl group, or an adamantyl group.

From the viewpoint of ease of synthesis, Ra¹⁰¹ to Ra¹⁰³ preferably represent a hydrogen atom or a chain-like monovalent saturated hydrocarbon group having 1 to 10 carbon atoms, more preferably a hydrogen atom, a methyl group, or an ethyl group, and particularly preferably a hydrogen atom.

Examples of the substituent included in the chain-like saturated hydrocarbon group or the aliphatic cyclic saturated hydrocarbon group represented by Ra¹⁰¹ to Ra¹⁰³ are the same groups as those for Ra^{x5}

Examples of the group having a carbon-carbon double bond generated by two or more of Ra¹⁰¹ to Ra¹⁰³ being bonded to each other to form a cyclic structure include a cyclopentenyl group, a cyclohexenyl group, a methylcyclopentenyl group, a methylcyclohexenyl group, a cyclopentylidenethenyl group, and a cyclohexylidenethenyl group. Among these, from the viewpoint of ease of synthesis, a cyclopentenyl group, a cyclohexenyl group, or a cyclopentylidenethenyl group is preferable.

In Formula (a1-r2-3), preferred examples of the aliphatic cyclic group that is formed by Xaa together with Yaa include the group described as the aliphatic hydrocarbon group which is a monocyclic group or a polycyclic group as Ra'³ in Formula (a1-r-1).

In Formula (a1-r2-3), examples of the aromatic hydrocarbon group as Ra¹⁰⁴ include a group in which one or more hydrogen atoms have been removed from an aromatic hydrocarbon ring having 5 to 30 carbon atoms. Among the examples, Ra¹⁰⁴ preferably represents a group in which one or more hydrogen atoms have been removed from an aromatic hydrocarbon ring having 6 to 15 carbon atoms, more preferably a group in which one or more hydrogen atoms have been removed from benzene, naphthalene, anthracene, or phenanthrene, still more preferably a group in which one or more hydrogen atoms have been removed from benzene, naphthalene, or anthracene, particularly preferably a group in which one or more hydrogen atoms have been removed from benzene or naphthalene, and most preferably a group in which one or more hydrogen atoms have been removed from benzene.

Examples of the substituent that Ra¹⁰⁴ in Formula (a1-r2-3) may have include a methyl group, an ethyl group, propyl group, a hydroxy group, a carboxy group, a halogen atom, an alkoxy group (a methoxy group, an ethoxy group, a propoxy group, a butoxy group, and the like), and an alkyloxycarbonyl group.

In Formula (a1-r2-4), Ra'¹² and Ra'¹³ each independently represents a chain-like monovalent saturated hydrocarbon group having 1 to 10 carbon atoms. Examples of the chain-like monovalent saturated hydrocarbon group having 1 to 10 carbon atoms as Ra'¹² and Ra'¹³ include the same one as the chain-like monovalent saturated hydrocarbon group having 1 to 10 carbon atoms as Ra¹⁰¹ to Ra¹⁰³ as described above. Some or all hydrogen atoms contained in the chain-like saturated hydrocarbon group may be substituted.

Ra'¹² and Ra'¹³ preferably represent an alkyl group having 1 to 5 carbon atoms, more preferably an alkyl group having 1 to 5 carbon atoms, still more preferably a methyl group or an ethyl group, and particularly preferably a methyl group.

In a case where the chain-like saturated hydrocarbon group represented by Ra'¹² and Ra'¹³ is substituted, examples of the substituent include the same groups as those for Ra^{x5} described above.

In Formula (a1-r2-4), Ra'¹⁴ represents a hydrocarbon group which may have a substituent. Examples of the hydrocarbon group as Ra'¹⁴ include a linear or branched alkyl group and a cyclic hydrocarbon group.

The linear alkyl group as Ra'¹⁴ preferably has 1 to 5 carbon atoms, more preferably 1 to 4 carbon atoms, and still more preferably 1 or 2 carbon atoms. Specific examples thereof include a methyl group, an ethyl group, an n-propyl group, an n-butyl group, and an n-pentyl group. Among these, a methyl group, an ethyl group, or an n-butyl group is preferable, and a methyl group or an ethyl group is more preferable.

The branched alkyl group as Ra'¹⁴ preferably has 3 to 10 carbon atoms and more preferably 3 to 5 carbon atoms. Specific examples thereof include an isopropyl group, an isobutyl group, a tert-butyl group, an isopentyl group, a neopentyl group, a 1,1-diethylpropyl group, and a 2,2-dimethylbutyl group. Among these, an isopropyl group is preferable.

In a case where Ra'¹⁴ represents a cyclic hydrocarbon group, the hydrocarbon group may be an aliphatic hydrocarbon group or an aromatic hydrocarbon group and may be a polycyclic group or a monocyclic group.

As the aliphatic hydrocarbon group which is a monocyclic group, a group in which one hydrogen atom has been removed from a monocycloalkane is preferable. The monocycloalkane preferably has 3 to 6 carbon atoms, and specific examples thereof include cyclopentane and cyclohexane.

As the aliphatic hydrocarbon group which is a polycyclic group, a group in which one hydrogen atom has been removed from a polycycloalkane is preferable. As the polycycloalkane, a group having 7 to 12 carbon atoms is preferable, and specific examples thereof include adamantane, norbornane, isobornane, tricyclo[5.2.1.0^{2,6}]decane, and tetracyclododecane.

Examples of the aromatic hydrocarbon group as Ra'¹⁴ include the same groups as those for the aromatic hydrocarbon group as Ra¹⁰⁴. Among these, Ra'¹⁴ preferably represents a group in which one or more hydrogen atoms have been removed from an aromatic hydrocarbon ring having 6 to 15 carbon atoms, more preferably a group in which one or more hydrogen atoms have been removed from benzene, naphthalene, anthracene, or phenanthrene, still more preferably a group in which one or more hydrogen atoms have been removed from benzene, naphthalene, or anthracene, particularly preferably a group in which one or more hydrogen atoms have been removed from naphthalene or anthracene, and most preferably a group in which one or more hydrogen atoms have been removed from naphthalene.

Examples of the substituent which may be included in Ra'¹⁴ include the same groups as those for the substituent which may be included in Ra¹⁰⁴.

In a case where Ra'¹⁴ in Formula (a1-r2-4) represents a naphthyl group, the position bonded to the tertiary carbon atom in Formula (a1-r2-4) may be any of the 1-position or the 2-position of the naphthyl group.

In a case where Ra'¹⁴ in Formula (a1-r2-4) represents an anthryl group, the position bonded to the tertiary carbon atom in Formula (a1-r2-4) may be any of the 1-position, the 2-position, or the 9-position of the anthryl group.

Specific examples of the group represented by Formula (a1-r2-1) are shown below.

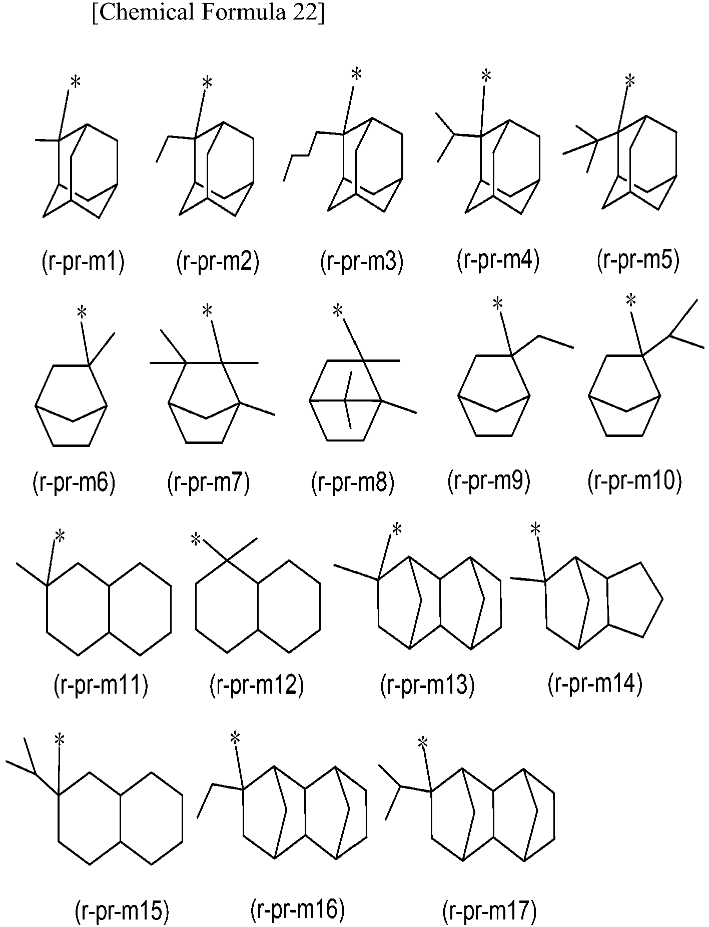

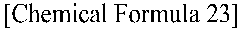

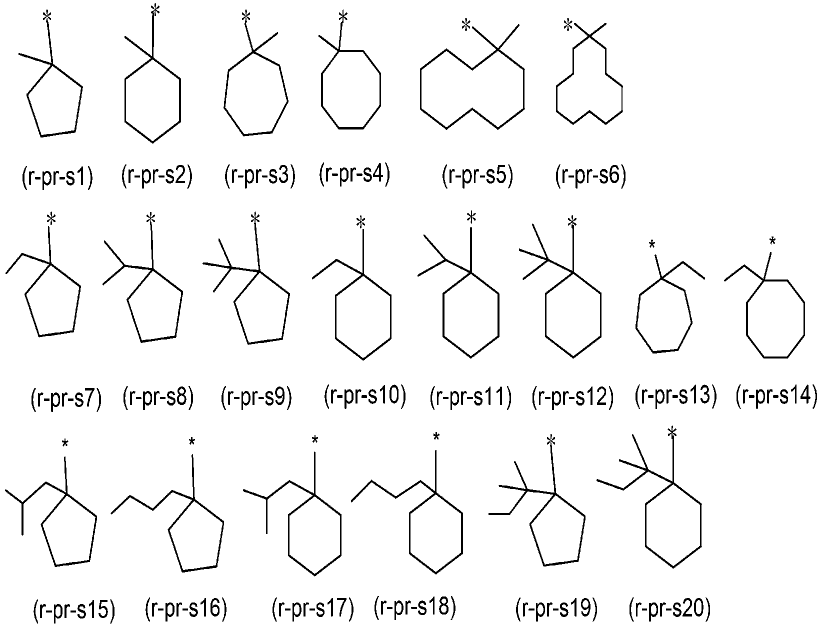

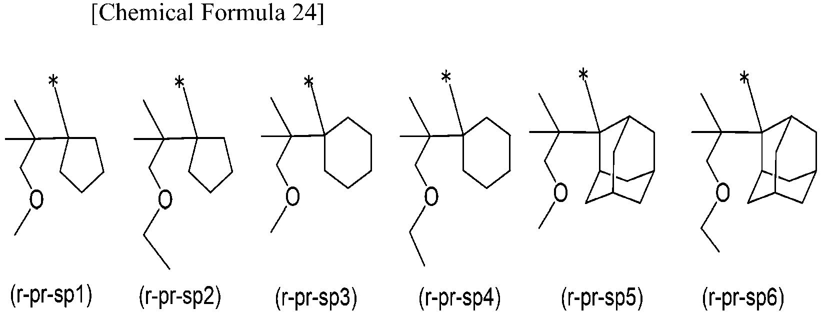

Specific examples of the group represented by Formula (a1-r2-2) are shown below.

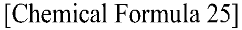

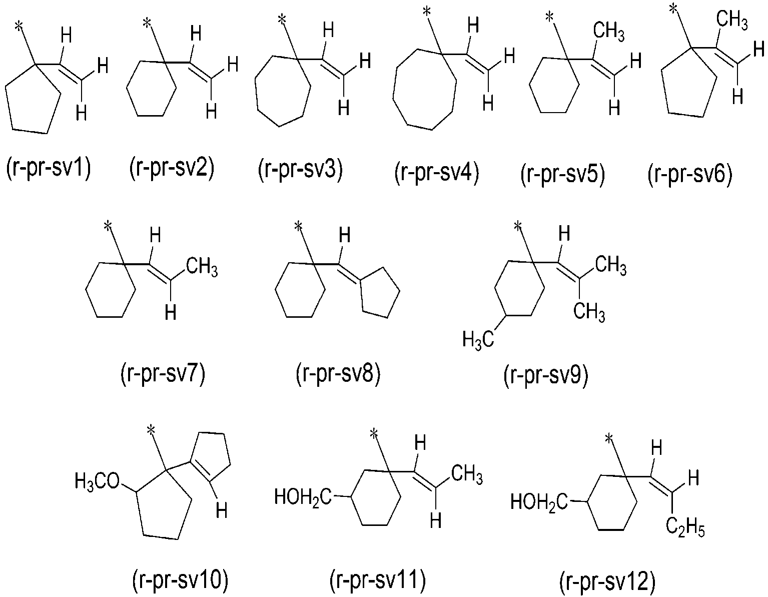

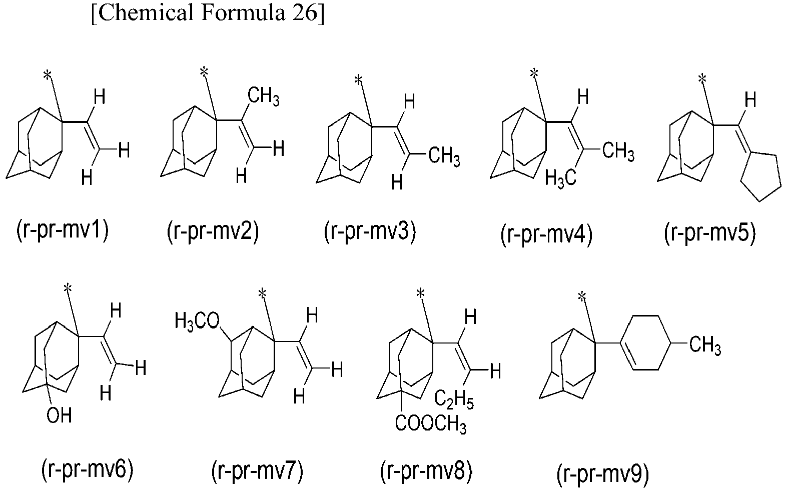

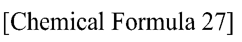

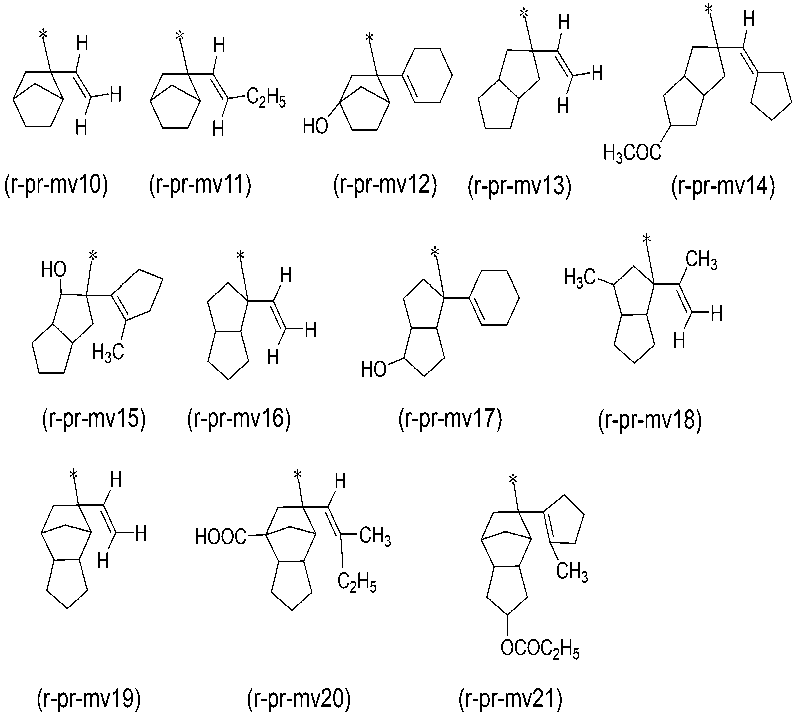

Specific examples of the group represented by Formula (a1-r2-3) are shown below.

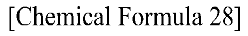

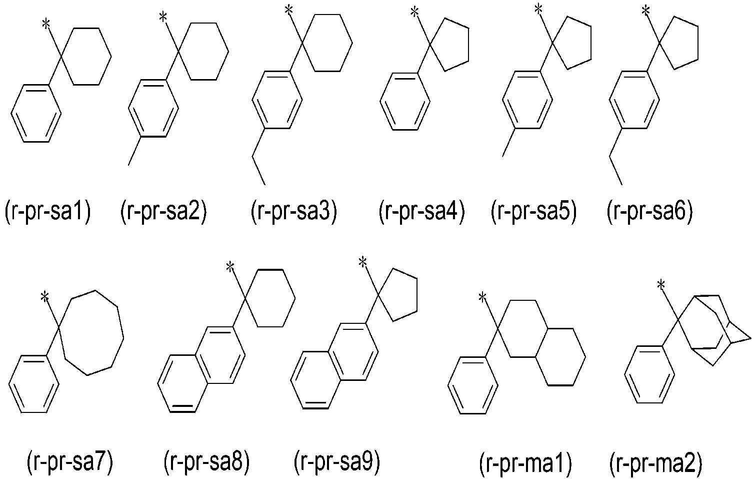

Specific examples of the group represented by Formula (a1-r2-4) are shown below.

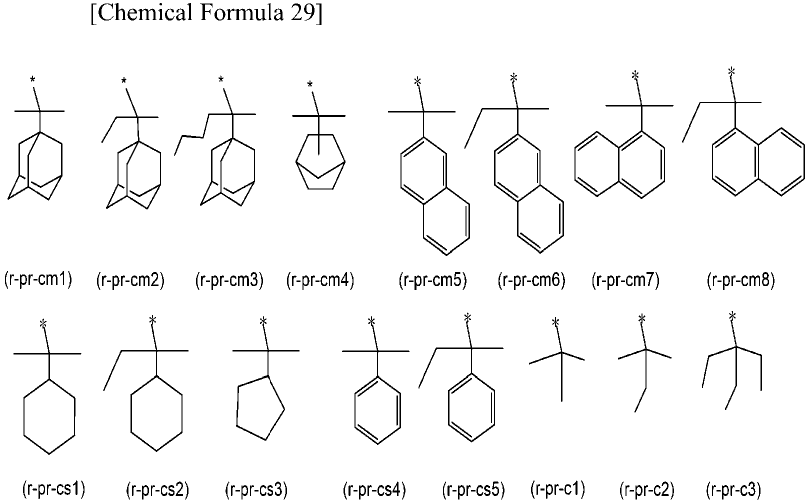

### Tertiary alkyloxycarbonyl acid-dissociable group:

Examples of the acid-dissociable group that protects a hydroxyl group among the polar groups include an acid-dissociable group (hereinafter, also referred to as "tertiary alkyloxycarbonyl acid-dissociable group" for convenience) represented by General Formula (a1-r-3). 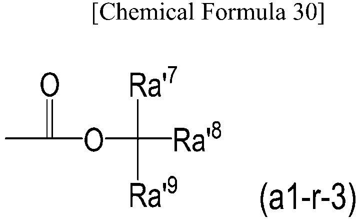 [In the formula, Ra'⁷ to Ra'⁹ each represents an alkyl group].

In Formula (al-r-3), Ra'⁷ to Ra'⁹ each preferably represents an alkyl group having 1 to 5 carbon atoms and more preferably an alkyl group having 1 to 3 carbon atoms.

Further, the total number of carbon atoms in each alkyl group is preferably in a range of 3 to 7, more preferably in a range of 3 to 5, and most preferably 3 or 4.

### Secondary alkyl ester type acid-dissociable group:

Examples of the acid-dissociable group that protects a carboxy group among the polar groups include an acid-dissociable group represented by General Formula (a1-r-4). 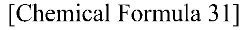 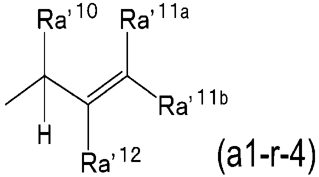 [In the formula, Ra'¹⁰ represents a hydrocarbon group. Ra'^{11a} and Ra'^{11b} each independently represents a hydrogen atom, a halogen atom, or an alkyl group. Ra'¹² represents a hydrogen atom or a hydrocarbon group. Ra'¹⁰ and Ra'^{11a} or Ra'^{11b} may be bonded to each other to form a ring. Ra'^{11a} or Ra'^{11b} and Ra'¹² may be bonded to each other to form a ring].

Examples of the hydrocarbon group as Ra'¹⁰ or Ra'¹² in the formula include the same groups as those for Ra'³

Examples of the alkyl group as Ra'^{11a} and Ra'^{11b} in the formula include the same groups as those for the alkyl group as Ra'¹.

In the formula, the hydrocarbon group as Ra'¹⁰ or Ra'¹² and the alkyl group as Ra'^{11a} and Ra'^{11b} may have a substituent. Examples of this substituent include Ra^{x5} described above.

Ra'¹⁰ and Ra'^{11a} or Ra'^{11b} may be bonded to each other to form a ring. The ring may be a polycyclic ring or a monocyclic ring, and may be an alicyclic ring or an aromatic ring.

The alicyclic ring and the aromatic ring may have a heteroatom.

Among the examples described above, as the ring formed by Ra'¹⁰ and Ra'^{11a} or Ra'^{11b} being bonded to each other, monocycloalkene, a ring in which some carbon atoms of monocycloalkene are substituted with heteroatoms (such as an oxygen atom and a sulfur atom), or monocycloalkadiene is preferable, cycloalkene having 3 to 6 carbon atoms is preferable, and cyclopentene or cyclohexene is preferable.

The ring formed by Ra'¹⁰ and Ra'^{11a} or Ra'^{11b} being bonded to each other may be a condensed ring. Specific examples of the condensed ring include indane.

The ring formed by Ra'¹⁰ and Ra'^{11a} or Ra'^{11b} being bonded to each other may have a substituent. Examples of this substituent include Ra^{x5} described above.

Ra'^{11a} or Ra'^{11b} and Ra'¹² may be bonded to each other to form a ring, and examples of the ring include the same rings as those formed by Ra'¹⁰ and Ra'^{11a} or Ra'^{11b} being bonded to each other.

Specific examples of the group represented by Formula (a1-r-4) are shown below.

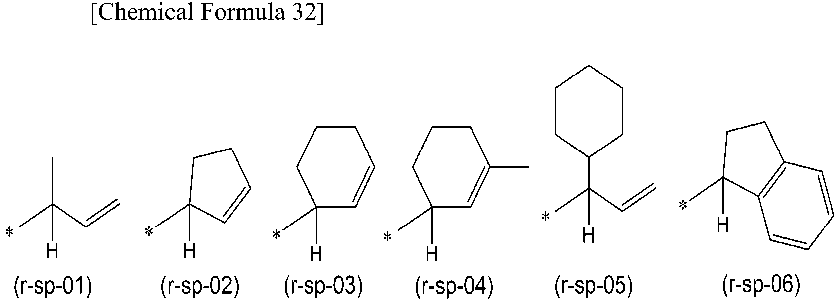

Examples of the constitutional unit (a1) include a constitutional unit derived from acrylic acid ester in which the hydrogen atom bonded to the carbon atom at the α-position may be substituted with a substituent; a constitutional unit derived from acrylamide; a constitutional unit in which at least some hydrogen atoms in a hydroxyl group of a constitutional unit derived from hydroxystyrene or a hydroxystyrene derivative are protected by a substituent containing the acid-decomposable group; and a constitutional unit in which at least some hydrogen atoms in -C(=O)-OH of a constitutional unit derived from vinylbenzoic acid or a vinylbenzoic acid derivative are protected by a substituent containing the acid-decomposable group.

Among the examples, as the constitutional unit (a1), a constitutional unit derived from acrylic acid ester in which the hydrogen atom bonded to the carbon atom at the α-position may be substituted with a substituent is preferable.

Specific preferred examples of such a constitutional unit (a1) include a constitutional unit represented by General Formula (a1-1), (a1-2), or (a1-3). 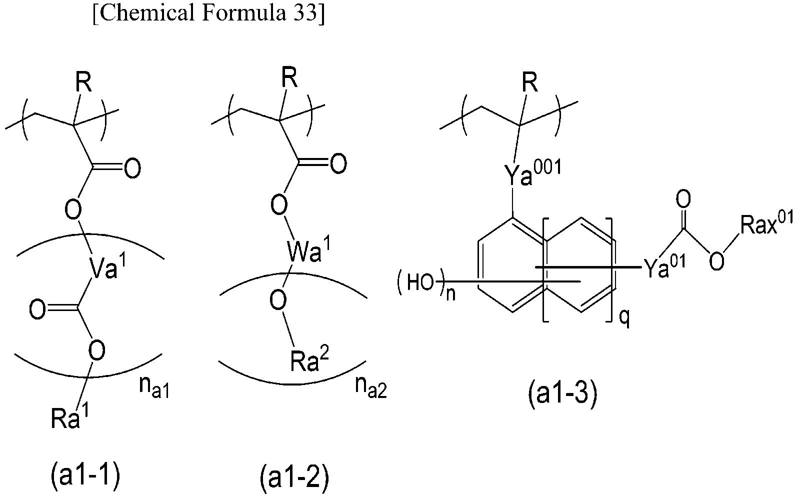 [In the formula, R represents a hydrogen atom, an alkyl group having 1 to 5 carbon atoms, or a halogenated alkyl group having 1 to 5 carbon atoms. Va¹ represents a divalent hydrocarbon group which may contain an ether bond. nₐ₁ represents an integer of 0 to 2. Ra¹ represents an acid-dissociable group represented by General Formula (a1-r-1), (a1-r-2), or (a1-r-4). Wa¹ represents an (nₐ₂+1)-valent hydrocarbon group. nₐ₂ represents an integer of 1 to 3. Ra² represents an acid-dissociable group represented by General Formula (a1-r-1) or (a1-r-3). Ya⁰⁰¹ represents a single bond or a divalent linking group. Ya⁰¹ represents a single bond or a divalent linking group. Rax⁰¹ represents an acid-dissociable group represented by General Formula (a1-r-1), (a1-r-2), or (a1-r-4). q represents an integer of 0 to 3. n represents an integer of 1 or gre. However, n ≤ q × 2 + 4 is satisfied].

In Formulae (al-1) to (a1-3), R is the same as R in Formula (g0-1). R is preferably a hydrogen atom, an alkyl group having 1 to 5 carbon atoms, or a fluorinated alkyl group having 1 to 5 carbon atoms, and more preferably a hydrogen atom or a methyl group.

In Formula (a1-1), the divalent hydrocarbon group as Va¹ may be an aliphatic hydrocarbon group or an aromatic hydrocarbon group. Examples of the divalent hydrocarbon group as Va¹ include the same ones as the divalent hydrocarbon group exemplified in the divalent linking group in Yg⁰ in Formula (g0-1).

Va¹ is preferably an aliphatic hydrocarbon group, more preferably a linear or branched alkylene group having 1 to 10 carbon atoms, and still more preferably a linear alkylene group having 1 to 10 carbon atoms.

In Formula (a1-1), Ra¹ preferably represents an acid-dissociable group represented by General Formula (a1-r-2) or (a1-r-4) and, among these, more preferably a group represented by General Formula (a1-r2-1) or an acid-dissociable group represented by General Formula (a1-r-4).

In Formula (a1-2), the (nₐ₂+1)-valent hydrocarbon group as Wa¹ may be an aliphatic hydrocarbon group or an aromatic hydrocarbon group. The aliphatic hydrocarbon group indicates a hydrocarbon group that has no aromaticity and may be saturated or unsaturated. In general, it is preferable that the aliphatic hydrocarbon group be saturated. Examples of the aliphatic hydrocarbon group include a linear or branched aliphatic hydrocarbon group, an aliphatic hydrocarbon group having a ring in the structure thereof, and a group obtained by combining the linear or branched aliphatic hydrocarbon group and the aliphatic hydrocarbon group having a ring in the structure thereof.

The valency of nₐ₂+1 is preferably divalent, trivalent, or tetravalent and more preferably divalent or trivalent.

In Formula (a1-2), it is preferable that Ra² represent an acid-dissociable group represented by General Formula (a1-r-1).

In Formula (a1-3), the divalent linking group as Ya⁰⁰¹ is not particularly limited, and suitable examples thereof include a divalent hydrocarbon group which may have a substituent and a divalent linking group having a heteroatom.

Among these, it is preferable that Ya⁰⁰¹ represent an ester bond [-C(=O)-O-, -O-C(=O)-], an ether bond (-O-), a linear or branched alkylene group, an aromatic hydrocarbon group, a combination thereof, or a single bond. The alkylene group preferably has 1 to 10 carbon atoms, more preferably 1 to 6 carbon atoms, still more preferably 1 to 4 carbon atoms, and particularly preferably 1 to 3 carbon atoms.

Among these, Ya⁰⁰¹ more preferably represents a combination of an ester bond [-C(=O)-O-, -O-C(=O)-] and a linear alkylene group, or a single bond and still more preferably a single bond.

In Formula (a1-3), the divalent linking group as Ya⁰¹ is not particularly limited, and suitable examples thereof include a divalent hydrocarbon group which may have a substituent and a divalent linking group having a heteroatom.

Among these, it is preferable that Ya⁰¹ represent an ester bond [-C(=O)-O-, -O-C(=O)-], an ether bond (-O-), a linear or branched alkylene group, an aromatic hydrocarbon group, a combination thereof, or a single bond. Among these, Ya⁰¹ is more preferably a combination of an ester bond [-C(=O)-O-, -O-C(=O)-] and a linear alkylene group, or a single bond, and still more preferably a single bond.

In Formula (a1-3), Rax⁰¹ preferably represents an acid-dissociable group represented by General Formula (a1-r-2) or (a1-r-4) and, among these, more preferably an acid-dissociable group represented by General Formula (a1-r-2) and still more preferably a group represented by General Formula (a1-r2-1).

In Formula (a1-3), q represents an integer of 0 to 3. A benzene structure is formed in a case where q represents 0, a naphthalene structure is formed in a case where q represents 1, an anthracene structure is formed in a case where q represents 2, and a tetracene structure is formed in a case where q represents 3.

In Formula (a1-3), n represents an integer of 1 or greater, preferably an integer of 1 to 5, more preferably an integer of 1 to 3, and still more preferably an integer of 1 or 2.

In Formula (a1-3), n ≤ q × 2 + 4 is satisfied. For example, in a case where q represents 1 and thus a naphthalene structure is formed, all six hydrogen atoms of the naphthalene may be substituted with hydroxy groups. In addition, the substitution positions of Ya⁰⁰¹, the -Ya⁰¹-C(=O)-O-Ra⁰¹ group, and the hydroxy group in the naphthalene are not particularly limited.

Specific examples of the constitutional unit (a1) are shown below. In the formulae shown below, R^{α} represents a hydrogen atom, a methyl group, or a trifluoromethyl group.

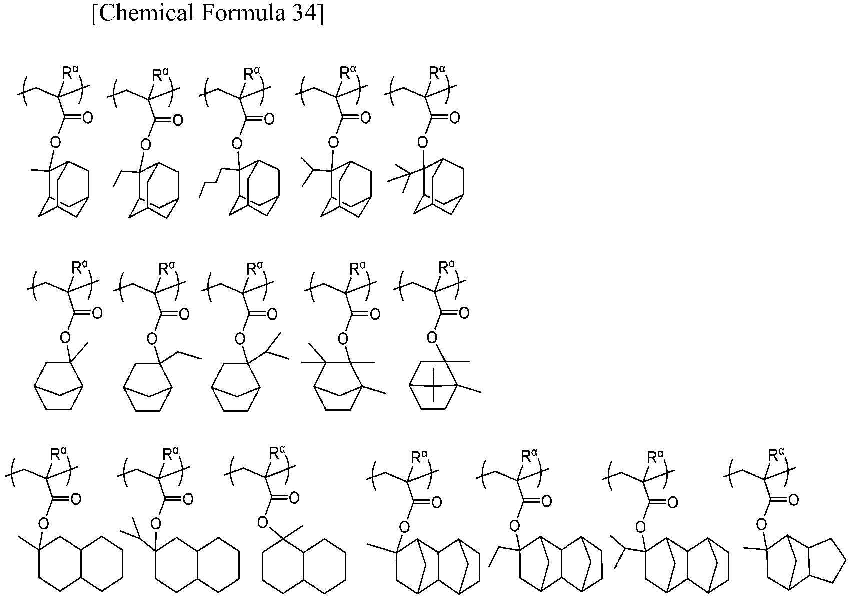

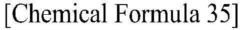

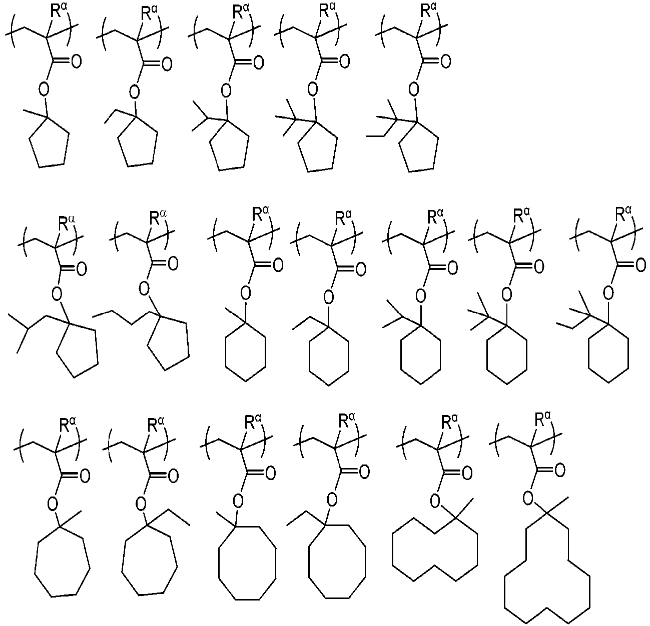

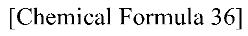

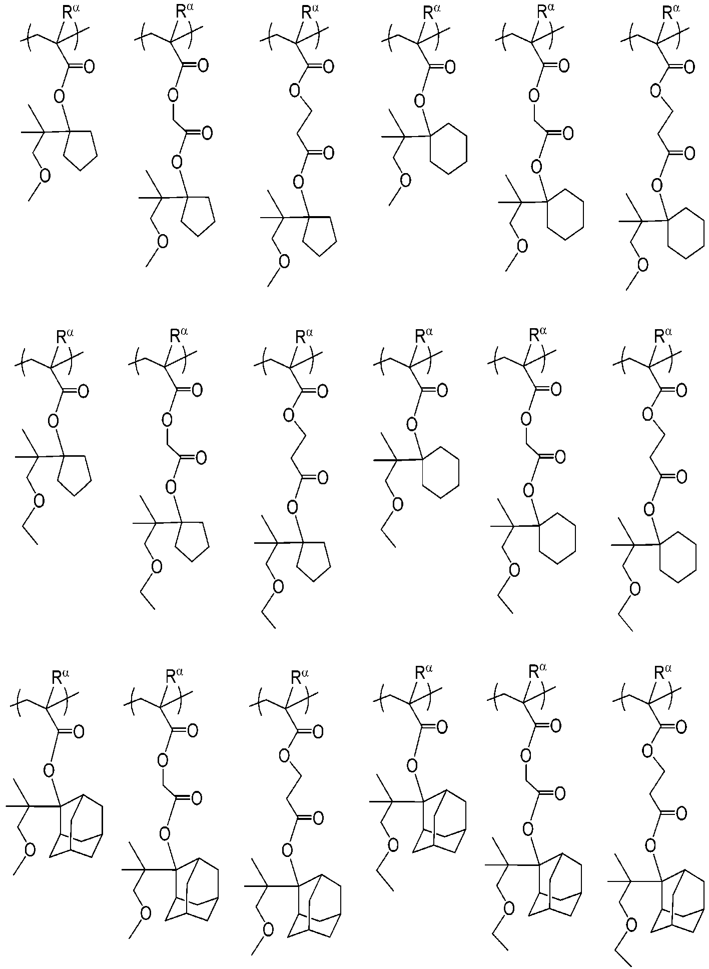

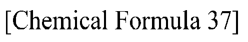

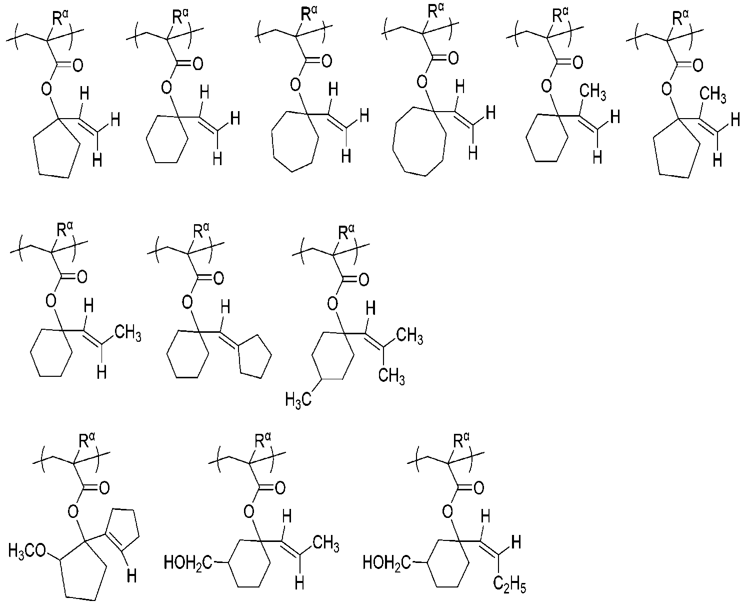

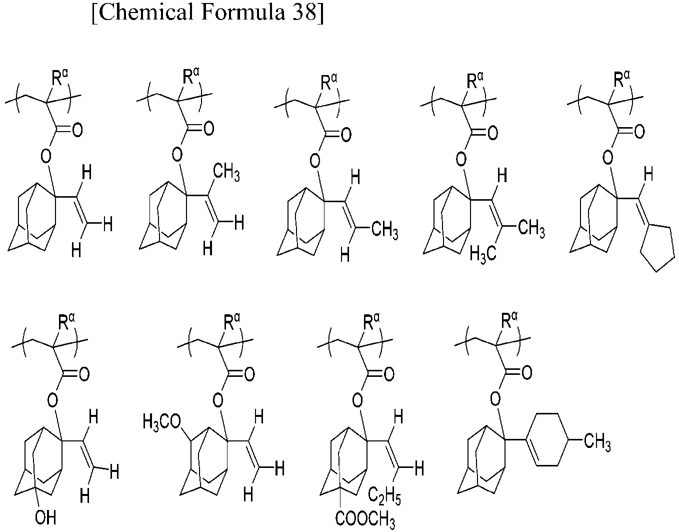

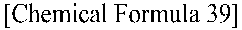

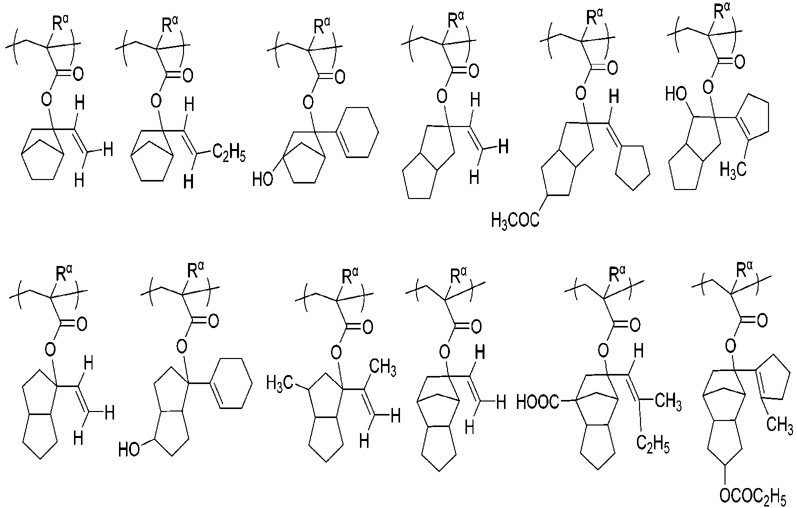

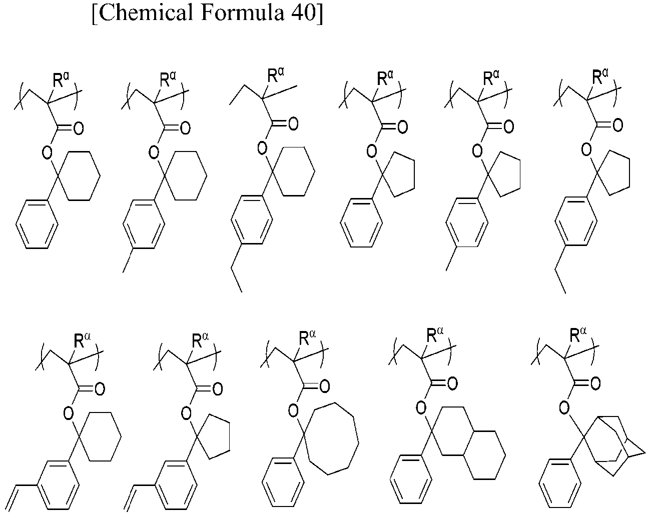

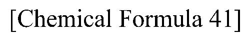

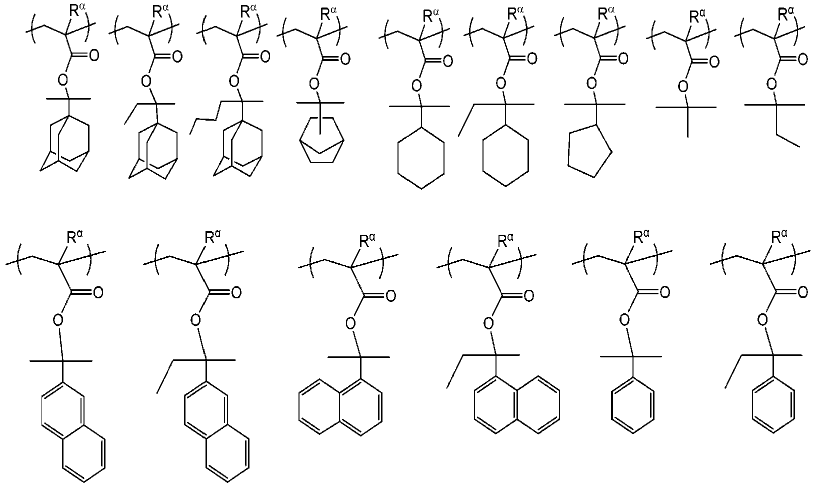

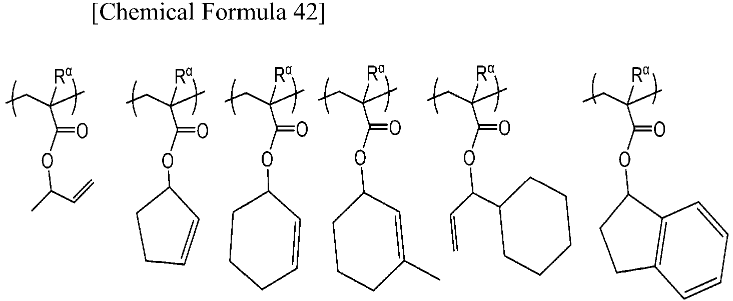

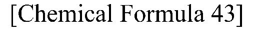

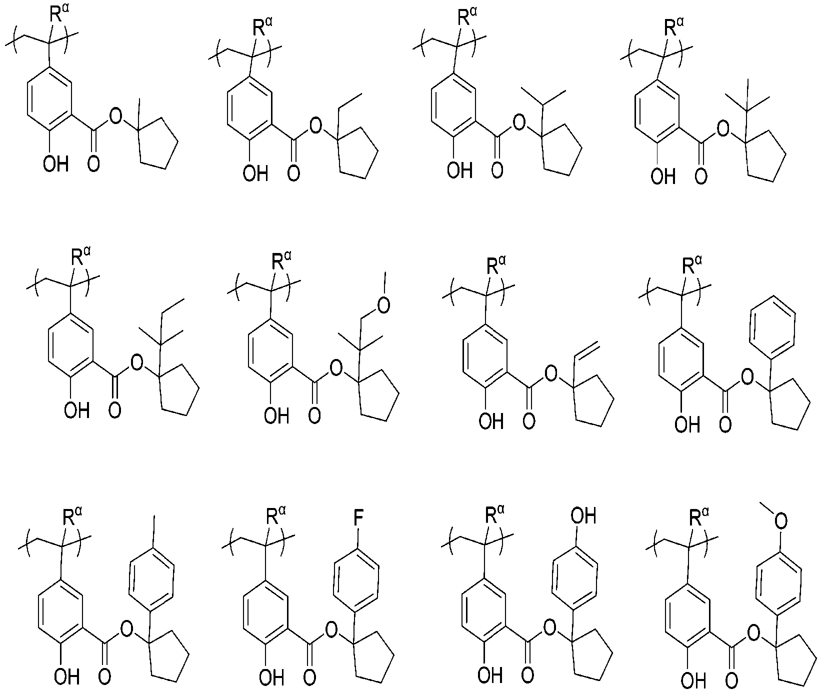

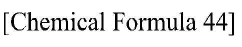

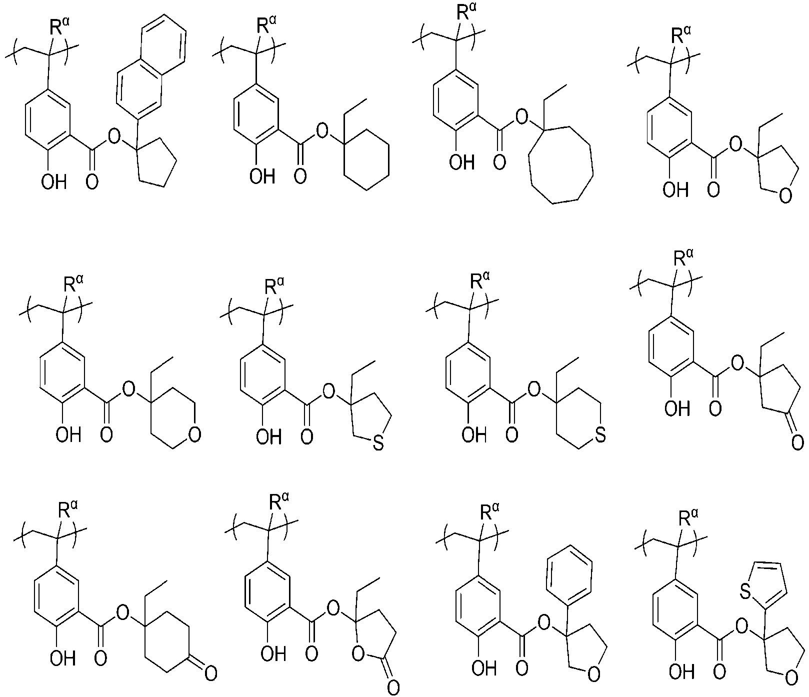

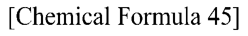

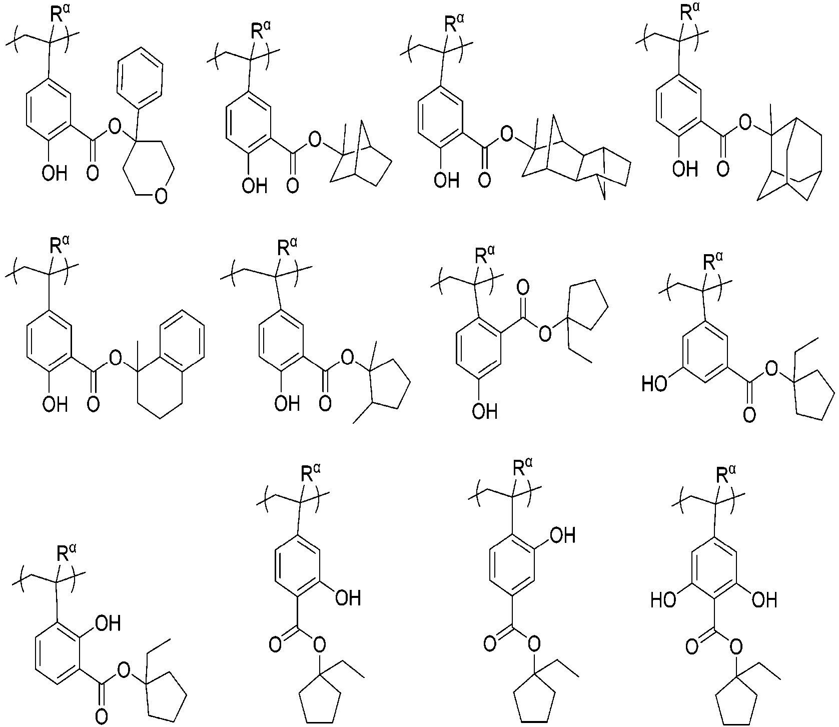

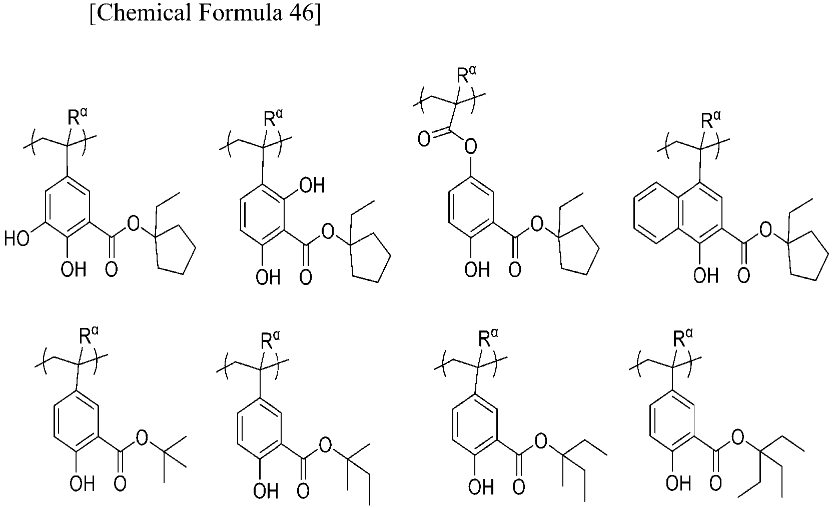

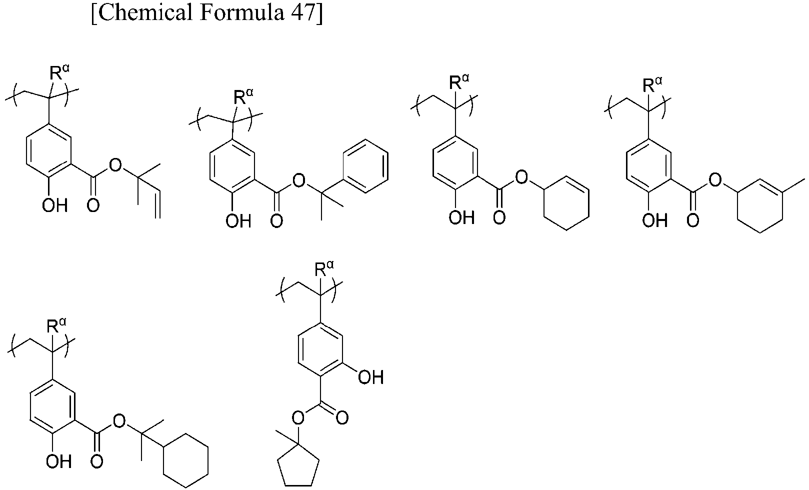

The constitutional unit (a1) is preferably a constitutional unit represented by Formula (a1-1) or a constitutional unit represented by Formula (a1-3), and more preferably a constitutional unit represented by Formula (a1-1). Among these, it is preferable that each acid-dissociable group (Ra¹ and Rax⁰¹) be an acid-dissociable group represented by General Formulae (a1-r2-1), (a1-r2-3), (a1-r2-4), or (a1-r-4).

In a case where the component (P) has the constitutional unit (a1), the constitutional unit (a1) may be one kind or two or more kinds. The component (P) may or may not have the constitutional unit (a1).

In a case where the component (P) has the constitutional unit (a1), the proportion of the constitutional unit (a1) in the component (P) is preferably in a range of 5% to 80% by mole, more preferably in a range of 10% to 75% by mole, still more preferably in a range of 30% to 70% by mole, and particularly preferably in a range of 30% to 60% by mole with respect to the total amount (100% by mole) of all constitutional units constituting the component (P).

In a case where the proportion of the constitutional unit (a1) is equal to or greater than the lower limit of the preferred range, residue is less likely to be generated in a case where a resist pattern is formed. In addition, the adhesiveness of the resist film to the support is further improved, and pattern collapse is less likely to occur even in a case where a fine resist pattern is formed. In a case where the proportion of the constitutional unit (a1) is equal to or less than the upper limit of the above-described preferred range, a balance with other constitutional units can be maintained, and various lithography characteristics in a case where a resist pattern is formed are enhanced.

### · Constitutional Unit (a11)

The component (P) may have a constitutional unit (a11). The constitutional unit (a11) is the same as that described in the component (G) above.

In a case where the component (P) has the constitutional unit (a11), the constitutional unit (a11) may be one kind, or two or more kinds. The component (P) may or may not have the constitutional unit (a11).

In a case where the component (G) has the constitutional unit (a11), the proportion of the constitutional unit (a11) in the component (G) is, for example, 1% to 50% by mole, preferably 5% to 40% by mole, more preferably 10% to 30% by mole, and still more preferably 10% to 20% by mole with respect to the total amount (100% by mole) of all constitutional units constituting the component (G).

In a case where the proportion of the constitutional unit (a11) is within the preferred range, various lithography characteristics in a case where a resist pattern is formed on the surface-modified layer formed of the composition for forming a surface-modified layer according to the present embodiment are enhanced.

The component (P) contained in the composition for forming a surface-modified layer according to the present embodiment may be used alone or in combination of two or more kinds thereof.

Examples of the component (P) include a polymer compound consisting of a repeating structure of the constitutional unit (p0); a polymer compound including a repeating structure of the constitutional unit (p0) and the constitutional unit (a1); a polymer compound including a repeating structure of the constitutional unit (p0) and the constitutional unit (a11); a polymer compound including a repeating structure of the constitutional unit (p0), the constitutional unit (a1), and the constitutional unit (a11); a polymer compound including a repeating structure of the constitutional unit (p01), the constitutional unit (a1), and the constitutional unit (a11); a polymer compound including a repeating structure of the constitutional unit (p02), the constitutional unit (a1), and the constitutional unit (a11); a polymer compound including a repeating structure of the constitutional unit (p01), the constitutional unit (p02), and the constitutional unit (a11); and a polymer compound including a repeating structure of the constitutional unit (p01), the constitutional unit (p02), the constitutional unit (a1), and the constitutional unit (a11).

In the polymer compound having a repeating structure of the constitutional unit (p0) and the constitutional unit (a11), the proportion of the constitutional unit (p0) is preferably in a range of 20% to 90% by mole, more preferably in a range of 30% to 90% by mole, still more preferably in a range of 40% to 90% by mole, and particularly preferably in a range of 50% to 90% by mole with respect to the total amount (100% by mole) of all constitutional units constituting the polymer compound. The proportion of the constitutional unit (a11) is preferably 10% to 80% by mole, more preferably 10% to 70% by mole, still more preferably 10% to 60% by mole, and particularly preferably 10% to 50% by mole with respect to the total (100% by mole) of all constitutional units constituting the polymer compound.

In the polymer compound having a repeating structure of the constitutional unit (p0), the constitutional unit (a1), and the constitutional unit (a11), the proportion of the constitutional unit (p0) is preferably 20% to 80% by mole and more preferably 30% to 70% by mole with respect to the total amount (100% by mole) of all constitutional units constituting the polymer compound. The proportion of the constitutional unit (a1) is preferably 5% to 80% by mole, more preferably 10% to 75% by mole, still more preferably 30% to 70% by mole, and particularly preferably 30% to 60% by mole with respect to the total amount (100% by mole) of all constitutional units constituting the polymer compound. The proportion of the constitutional unit (a11) is preferably 5% to 40% by mole, more preferably 10% to 30% by mole, and still more preferably 10% to 20% by mole with respect to the total amount (100% by mole) of all constitutional units constituting the polymer compound.

The component (P) can be produced by dissolving, in a polymerization solvent, each of monomers from which constitutional units are derived, and adding thereto a radical polymerization initiator such as azobisisobutyronitrile (AIBN) or dimethyl azobisisobutyrate (for example, V-601) to carry out polymerization.

Alternatively, such a component (P) can be produced by dissolving, in a polymerization solvent, a monomer from which the constitutional unit (p0) is derived and a monomer from which an optional constitutional unit (for example, the constitutional unit (a1), the constitutional unit (a11) or the like) is derived, adding a radical polymerization initiator as described above thereto to carry out polymerization, and carrying out a deprotection reaction.

Further, a -C(CF₃)₂-OH group may be introduced into the terminal during the polymerization using a chain transfer agent such as HS-CH₂-CH₂-CH₂-C(CF₃)₂-OH in combination.

The weight-average molecular weight (Mw) of the component (P) (in terms of polystyrene by gel permeation chromatography (GPC)) is, for example, preferably 1,000 to 1,000,000, more preferably 100,000 to 600,000, still more preferably 150,000 to 500,000, and particularly preferably 200,000 to 400,000.

In a case where the weight-average molecular weight of the component (P) is within the above-described range, the adhesiveness of the resist film to the support is further enhanced.

The dispersity (Mw/Mn) of the component (P) is not particularly limited, and is preferably 1.0 to 4.0, and more preferably 1.0 to 3.0. Further, Mn represents the number-average molecular weight.

Specific examples of the component (P) are shown below but are not limited thereto.

In the formulae shown below, R^{α} represents a hydrogen atom, a methyl group, or a trifluoromethyl group.

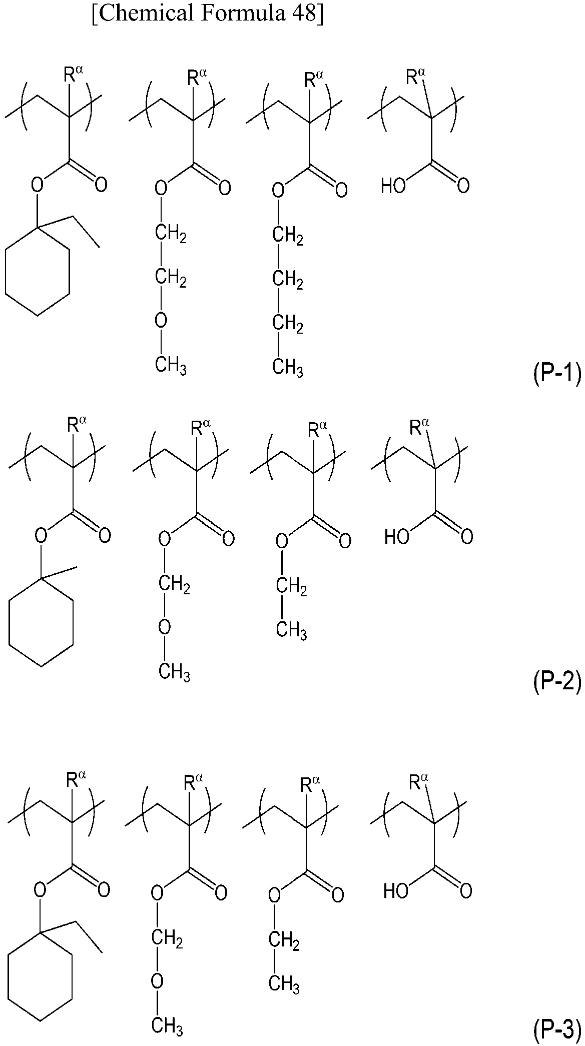

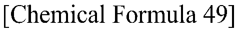

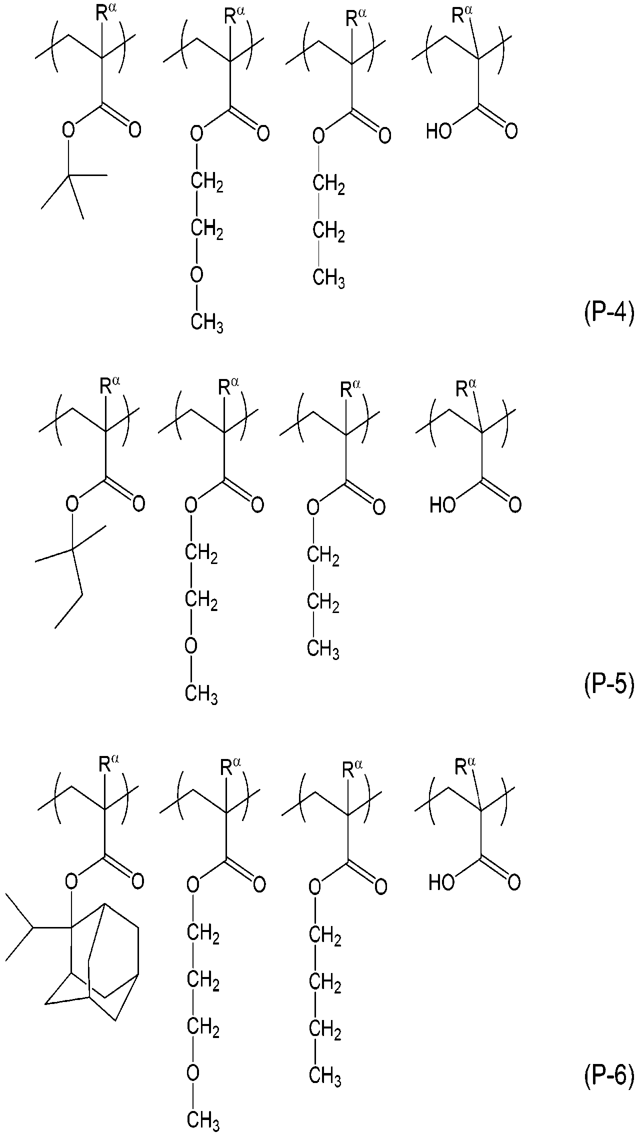

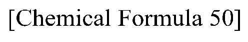

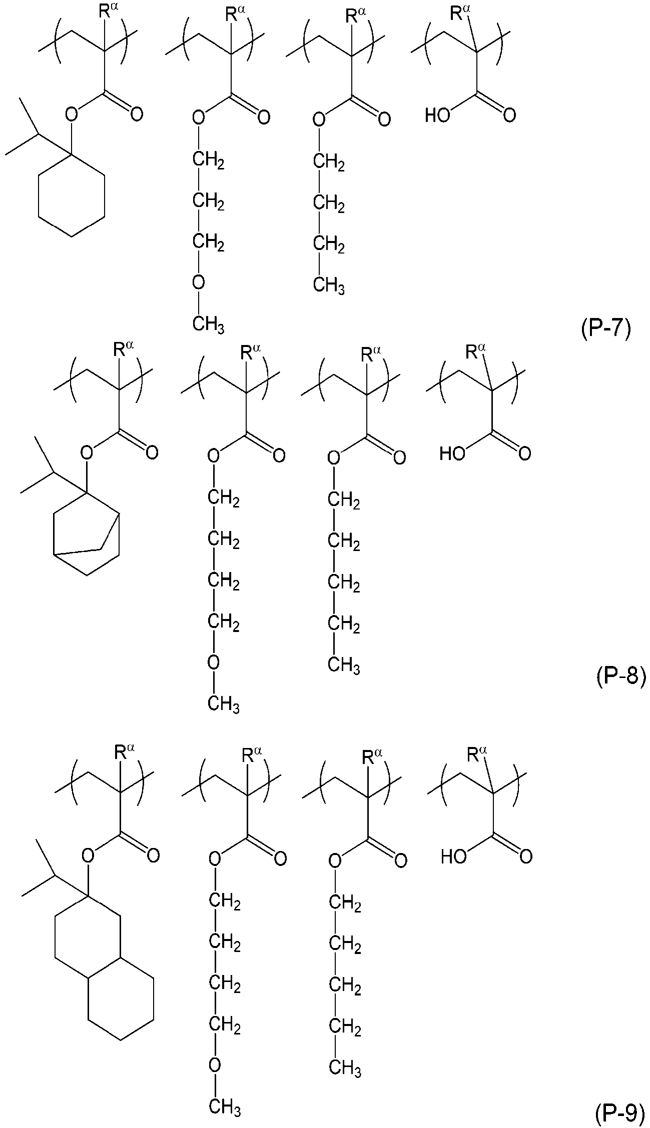

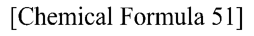

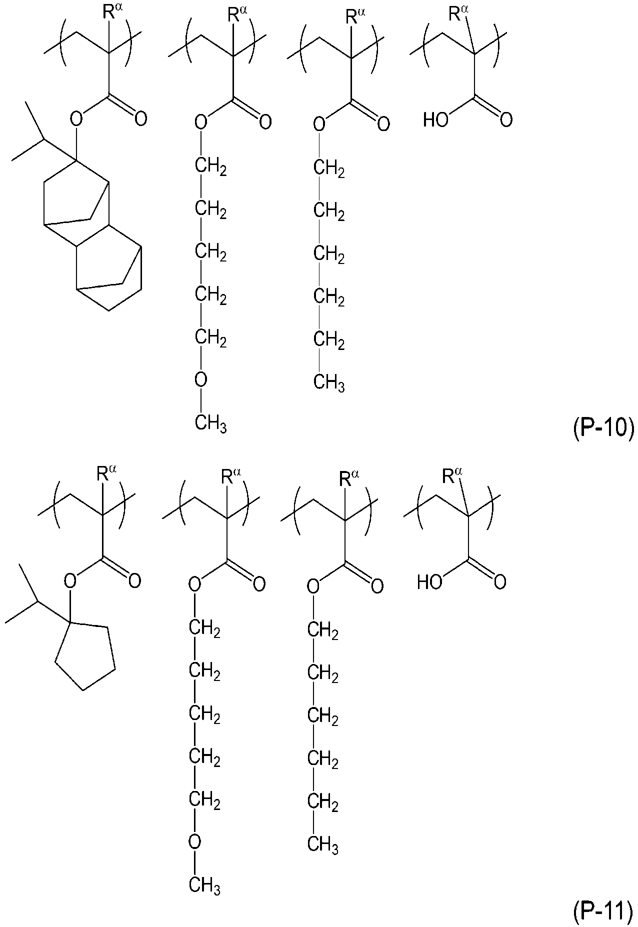

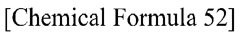

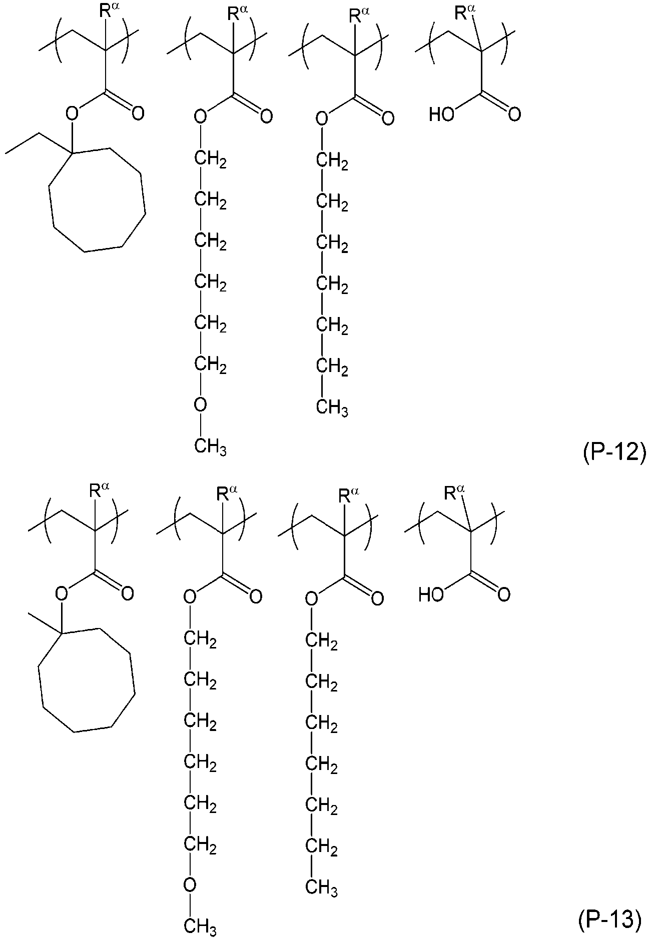

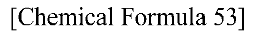

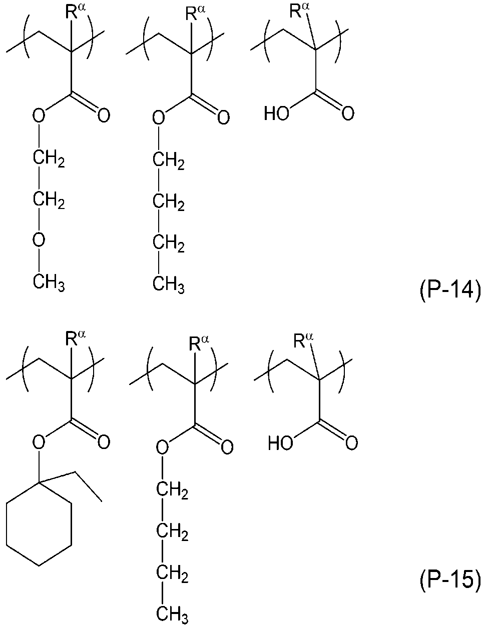

The content of the component (P) in the composition for forming a surface-modified layer according to the present embodiment is preferably 5 to 70 parts by mass, more preferably 5 to 60 parts by mass, still more preferably 5 to 50 parts by mass, and particularly preferably 10 to 50 parts by mass with respect to 100 parts by mass of the total mass of the component (G) and the component (P).

By setting the content of the component (P) to the above-described preferred range, the adhesiveness of the resist film to the support can be further improved.

### <Other Components>

The composition for forming a surface-modified layer according to the present embodiment may contain other components in addition to the above-described component (G) and component (P). Examples of the other components include an organic solvent.

The organic solvent may be any solvent as long as the components (G) and (P) can be dissolved in the solvent to form a uniform solution. Examples of the organic solvent include those used as an organic solvent for a typical chemically amplified-type resist composition.

As the organic solvent, for example, lactones such as γ-butyrolactone; ketones such as acetone, methyl ethyl ketone, cyclohexanone, methyl-n-pentyl ketone, methyl isopentyl ketone, and 2-heptanone; polyhydric alcohols such as ethylene glycol, diethylene glycol, propylene glycol, and dipropylene glycol; compounds having an ester bond such as ethylene glycol monoacetate, diethylene glycol monoacetate, propylene glycol monoacetate, or dipropylene glycol monoacetate; derivatives of polyhydric alcohols such as compounds having an ester bond such as ethylene glycol monoacetate, diethylene glycol monoacetate, propylene glycol monoacetate, or dipropylene glycol monoacetate, and compounds having an ether bond such as monoalkylether or monophenyl ether such as monomethyl ether, monoethyl ether, monopropyl ether, and monobutylether of compounds having the polyhydric alcohols or the ester bond [among these, propylene glycol monomethyl ether acetate (PGMEA) and propylene glycol monomethyl ether (PGME) are preferable]; cyclic ethers such as dioxane; esters such as methyl lactate, ethyl lactate (EL), methyl acetate, ethyl acetate, butyl acetate, methyl pyruvate, ethyl pyruvate, methyl methoxypropionate, and ethyl ethoxypropionate; aromatic organic solvents such as anisole, ethylbenzylether, cresyl methyl ether, diphenylether, dibenzylether, phenetole, butylphenylether, ethylbenzene, diethylbenzene, pentylbenzene, isopropylbenzene, toluene, xylene, cymene, and mesitylene; and the like are exemplary examples.

The organic solvent may be used alone or as a mixed solvent of two or more kinds thereof. For example, the component (G) and the component (P) may be dissolved in a ketone-based solvent such as 2-heptanone, and then diluted with a diluent solvent such as PGMEA. The organic solvent may be used, for example, such that the total content of the component (G) and the component (P) of the composition for forming a surface-modified layer is 0.01% to 5% by mass, preferably 0.1% to 3% by mass, and more preferably 0.1% to 1% by mass. In a case where the total content of the component (G) and the component (P) is equal to or higher than the preferred lower limit, the adhesiveness between the resist film and the support is further improved. In a case where the total content of the component (G) and the component (P) is equal to or smaller than the preferred upper limit, the composition for forming a surface-modified layer has an appropriate viscosity and is easily uniformly applied onto the support.

The composition for forming a surface-modified layer according to the present embodiment preferably contains the component (G), the component (P), and an organic solvent, and more preferably consists of the component (G), the component (P), and an organic solvent.

The composition for forming a surface-modified layer according to the present embodiment is used for forming a surface-modified layer provided between a support and a resist film. The formation of the surface-modified layer using the composition for forming a surface-modified layer according to the present embodiment can be performed by applying the composition for forming a surface-modified layer according to the present embodiment onto a support and baking the composition, as described later. A resist film can be formed by applying a resist composition onto the surface-modified layer formed in such a manner and baking the resist composition. In this way, the surface-modified layer can be formed between the support and the resist film by using the composition for forming a surface-modified layer according to the present embodiment.

### <Support>

The support to which the composition for forming a surface-modified layer according to the present embodiment is applied is not particularly limited, and a well-known support in the related art can be used. Examples of the support include a substrate for an electronic component and a substrate on which a predetermined wiring pattern is formed. Specific examples of the support include a silicon wafer; a substrate made of a metal such as copper, chromium, iron, or aluminum; and a glass substrate. Examples of the material for the wiring pattern include copper, aluminum, nickel, and gold.

The support may be a support on which a processing layer is formed on a substrate. Examples of the processing layer include various Low-k films such as films of Si, SiO2, SiON, SiN, p-Si, α-Si, W, W-Si, Al, Cu, and Al-Si, and stopper films thereof.

The support may be a support on which a hard mask layer is formed on a substrate or on the processing layer. The hard mask layer may be formed of an inorganic material or an organic material. Examples of the inorganic material for forming the hard mask layer include a silicon oxide film (SiO₂ film), a silicon nitride film (Si₃N₄ film), and a silicon oxynitride film (SiON film). Examples of the organic material for forming the hard mask layer include a novolac resin.

### <Resist Composition>

The resist composition to which the composition for forming a surface-modified layer according to the present embodiment is applied is not particularly limited, and a known resist composition in the related art can be used. As the resist composition, a commercially available composition can be used without particular limitation.

The resist composition is preferably a chemically amplified-type resist composition. Examples of the chemically amplified-type resist composition include a resist composition which generates an acid by exposure and has a solubility in a developing solution that changes by the action of the acid. The resist composition contains a base material component (A) (hereinafter, also referred to as "component (A)") of which solubility in a developing solution is changed by the action of the acid. The resist composition may (1) contain an acid generator component (B) (hereinafter, referred to as "component (B)") that generates an acid upon exposure; (2) have a component (A) that generates an acid upon exposure; and (3) have a component (A) that generates an acid upon exposure and further contains component (B).

The resist composition may further contain a base component (D) (hereinafter, also referred to as a "(D) component"), at least one compound (E) (hereinafter, also referred to as a "(E) component") selected from the group consisting of an organic carboxylic acid, an oxoacid of phosphorus, and a derivative thereof, a fluorine additive component (F) (hereinafter, also referred to as an "(F) component"), and an organic solvent component (S) (hereinafter, also referred to as an "component (S)").

The resist composition may be a positive-tone resist composition or a negative-tone resist composition. In the formation of a resist pattern, the resist composition may be applied to an alkali developing process using an alkali developing solution in the developing treatment, or a solvent developing process using a developing solution (an organic developing solution) containing an organic solvent in the developing treatment. The resist composition is preferably for an alkali developing process.

### <<Base Material Component (A)>>

It is preferable that the component (A) include a resin component (A1) (hereinafter, also referred to as a "component (A1)") of which solubility in a developing solution changes by the action of an acid.

### · In regard to Component (A1)

It is preferable that the component (A1) have the constitutional unit (a1) described above. Examples of other constitutional units which may be contained in the component (A1) include the constitutional unit (a10) described above; a constitutional unit (a2) containing a lactone-containing cyclic group; and a constitutional unit (a8) derived from a compound represented by General Formula (a8-1) described later.

### Constitutional unit (a1):

The description of the constitutional unit (a1) is the same as that in the component (P).

The constitutional unit (a1) included in the component (A1) may be used alone or two or more kinds thereof may be used.

From the viewpoint of further easily enhancing the lithography characteristics (the sensitivity, the shape, and the like) using electron beams or EUV, a constitutional unit represented by Formula (a1-1) or a constitutional unit represented by Formula (a1-3) is more preferable as the constitutional unit (a1).

Among these, from the viewpoint of suitably enhancing the reactivity for EB or EUV, the acid-dissociable groups (Ra¹, Rax⁰¹) are each preferably an acid-dissociable group represented by General Formula (a1-r2-1), (a1-r2-3), (a1-r2-4), or (a1-r-4). Among these, it is particularly preferable that the acid-dissociable groups be selected from the cyclic groups.

The proportion of the constitutional unit (a1) in the component (A1) is preferably in a range of 5% to 80% by mole, more preferably in a range of 10% to 75% by mole, still more preferably in a range of 30% to 70% by mole, and particularly preferably in a range of 40% to 70% by mole with respect to the total amount (100% by mole) of all constitutional units constituting the component (A1).

By setting the proportion of the constitutional unit (a1) to be greater than or equal to the lower limits of the above-described preferable ranges, lithography characteristics such as the sensitivity, the resolution, and improved roughness are improved. Further, in a case where the proportion of the constitutional unit (a1) is less than or equal to the upper limits of the above-described preferable ranges, the constitutional unit (a1) and other constitutional units can be balanced, and various lithography characteristics are enhanced.

### Constitutional unit (a10):

The description of the constitutional unit (a10) is the same as that in the component (G).

The constitutional unit (a10) included in the component (A1) may be used alone or two or more kinds thereof may be used. The component (A1) may or may not have the constitutional unit (a10), but it is preferable that the component (A1) have the constitutional unit (a10).

In a case where the component (A1) has the constitutional unit (a10), the proportion of the constitutional unit (a10) in the component (A1) is preferably in a range of 20% to 80% by mole, more preferably in a range of 25% to 70% by mole, still more preferably in a range of 30% to 60% by mole, and particularly preferably in a range of 30% to 50% by mole with respect to the total amount (100% by mole) of all constitutional units constituting the component (A1).

In a case where the proportion of the constitutional unit (a10) is set to be greater than or equal to the above-described lower limits, the sensitivity is likely to be enhanced. On the contrary, in a case where the proportion thereof is set to be less than or equal to the upper limits, the constitutional unit (a10) and other constitutional units are likely to be balanced.

### Constitutional unit (a2):

The component (A1) may have a constitutional unit (a2) containing a lactone-containing cyclic group (here, constitutional units corresponding to the constitutional unit (a1) are excluded).

The term "lactone-containing cyclic group" indicates a cyclic group that has a ring (lactone ring) containing -O-C(=O)- in the ring skeleton. In a case where the lactone ring is counted as the first ring and the group contains only the lactone ring, the group is referred to as a monocyclic group. Further, in a case where the group has other ring structures, the group is referred to as a polycyclic group regardless of the structures. The lactone-containing cyclic group may be a monocyclic group or a polycyclic group.

The lactone-containing cyclic group in the constitutional unit (a2) is not particularly limited, and an optional constitutional unit can be used. Specific examples thereof include groups each represented by General Formulae (a2-r-1) to (a2-r-7). 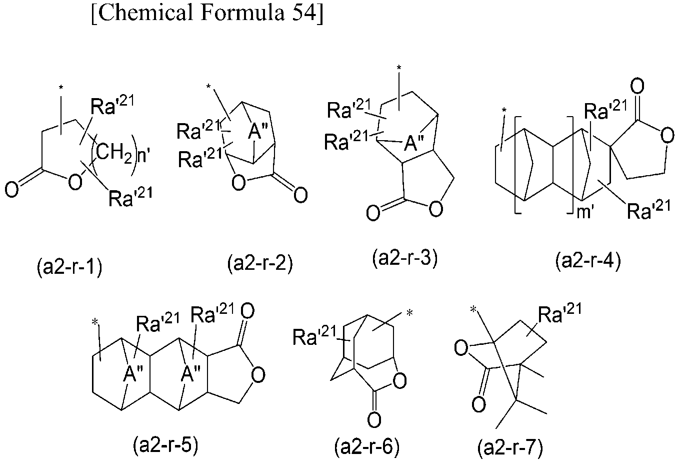 [In the formulae, Ra'²¹'s each independently represents a hydrogen atom, an alkyl group, an alkoxy group, a halogen atom, a halogenated alkyl group, a hydroxyl group, -COOR", -OC(=O)R", a hydroxyalkyl group, or a cyano group, R" represents a hydrogen atom, an alkyl group, or a lactone-containing cyclic group, A" represents an alkylene group having 1 to 5 carbon atoms which may have an oxygen atom (-O-) or a sulfur atom (-S-), an oxygen atom, or a sulfur atom, n' represents an integer of 0 to 2, and m' represents 0 or 1. * represents a bonding site (the same applies hereinafter)].

In General Formulae (a2-r-1) to (a2-r-7), it is preferable that the alkyl group as Ra'²¹ be an alkyl group having 1 to 6 carbon atoms. Further, it is preferable that the alkyl group be linear or branched. Specific examples thereof include a methyl group, an ethyl group, a propyl group, an isopropyl group, an n-butyl group, an isobutyl group, a tert-butyl group, a pentyl group, an isopentyl group, a neopentyl group, and a hexyl group. Among these, a methyl group or ethyl group is preferable, and a methyl group is particularly preferable.

It is preferable that the alkoxy group as Ra'²¹ be an alkoxy group having 1 to 6 carbon atoms. Further, it is preferable that the alkoxy group be linear or branched. Specific examples of the alkoxy groups include a group formed by linking the above-described alkyl group described as the alkyl group represented by Ra'²¹ to an oxygen atom (-O-).

As the halogen atom as Ra'²¹, a fluorine atom is preferable.

Examples of the halogenated alkyl group as Ra'²¹ include groups in which some or all hydrogen atoms in the alkyl group as Ra'²¹ have been substituted with the halogen atoms. As the halogenated alkyl group, a fluorinated alkyl group is preferable, and a perfluoroalkyl group is particularly preferable.

In -COOR" and -OC(=O)R" as Ra'²¹, each R" represents a hydrogen atom, an alkyl group, or a lactone-containing cyclic group.

The alkyl group as R" may be linear, branched, or cyclic and preferably has 1 to 15 carbon atoms.

In a case where R" represents a linear or branched alkyl group, an alkyl group having 1 to 10 carbon atoms is preferable, an alkyl group having 1 to 5 carbon atoms is more preferable, and a methyl group or an ethyl group is particularly preferable.

In a case where R" represents a cyclic alkyl group, the number of carbon atoms thereof is preferably in a range of 3 to 15, more preferably in a range of 4 to 12, and most preferably in a range of 5 to 10. Specific examples thereof include groups in which one or more hydrogen atoms have been removed from a monocycloalkane, which may or may not be substituted with a fluorine atom or a fluorinated alkyl group; and groups in which one or more hydrogen atoms have been removed from a polycycloalkane such as bicycloalkane, tricycloalkane, or tetracycloalkane. More specific examples thereof include a group in which one or more hydrogen atoms have been removed from a monocycloalkane such as cyclopentane or cyclohexane; and a group in which one or more hydrogen atoms have been removed from a polycycloalkane such as adamantane, norbornane, isobornane, tricyclo[5.2.1.0^{2,6}]decane, or tetracyclododecane.

Examples of the lactone-containing cyclic group as R" include the same groups as those for the groups each represented by General Formulae (a2-r-1) to (a2-r-7).

As the hydroxyalkyl group as Ra'²¹, a hydroxyalkyl group having 1 to 6 carbon atoms is preferable, and specific examples thereof include a group in which at least one hydrogen atom in the alkyl group as Ra'²¹ has been substituted with a hydroxyl group.

Among the examples, it is preferable that each Ra'²¹ independently represents a hydrogen atom or a cyano group.

In General Formulae (a2-r-2), (a2-r-3) and (a2-r-5), as the alkylene group having 1 to 5 carbon atoms as A", a linear or branched alkylene group is preferable, and examples thereof include a methylene group, an ethylene group, an n-propylene group, and an isopropylene group. Specific examples of the alkylene groups that contain an oxygen atom or a sulfur atom include a group obtained by interposing -O- or -S- in the terminal of the alkylene group or between the carbon atoms of the alkylene group, and examples thereof include -O-CH₂-, -CH₂-O-CH₂-, -S-CH₂-, and -CH₂-S-CH₂-. A" preferably represents an alkylene group having 1 to 5 carbon atoms or -O-, more preferably an alkylene group having 1 to 5 carbon atoms, and most preferably a methylene group.

As the constitutional unit (a2), a constitutional unit derived from acrylic acid ester in which the hydrogen atom bonded to the carbon atom at the α-position may be substituted with a substituent is preferable.

The constitutional unit (a2) included in the component (A1) may be used alone or two or more kinds thereof may be used. The component (A1) may or may not have the constitutional unit (a2).

In a case where the component (A1) has the constitutional unit (a2), the proportion of the constitutional unit (a2) is preferably in a range of 1% to 20% by mole, more preferably in a range of 1% to 15% by mole, and still more preferably in a range of 1% to 10% by mole with respect to the total amount (100% by mole) of all constitutional units constituting the component (A1).

In a case where the proportion of the constitutional unit (a2) is set to be equal to or greater than the preferable lower limits, the effect to be obtained by allowing the component (A1) to have the constitutional unit (a2) is sufficiently obtained by the above-described effects. Further, in a case where the proportion thereof is set to be equal to or less than the upper limits, the constitutional unit (a2) and other constitutional units can be balanced, and the various lithography characteristics are enhanced.

### Constitutional unit (a8):

The constitutional unit (a8) is a constitutional unit derived from a compound represented by General Formula (a8-1). 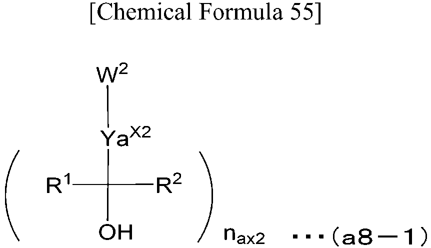 [In the formula, W² represents a polymerizable group-containing group. Ya^{x2} represents a single bond or an (nₐₓ₂+1)-valent linking group. Ya^{x2} and W² may form a condensed ring. R¹ represents a fluorinated alkyl group having 1 to 12 carbon atoms. R² represents an organic group having 1 to 12 carbon atoms which may have a fluorine atom, or a hydrogen atom. R² and Ya^{x2} may be bonded to each other to form a ring structure. nₐₓ₂ represents an integer of 1 to 3].

The term "polymerizable group" in the polymerizable group-containing group as W² is a group that enables a compound having the polymerizable group to be polymerized by radical polymerization or the like, and refers to a group containing multiple bonds between carbon atoms, such as an ethylenic double bond.

The polymerizable group-containing group may be a group formed of only a polymerizable group or a group formed of a polymerizable group and a group other than the polymerizable group. Examples of the group other than the polymerizable group include a divalent hydrocarbon group which may have a substituent and a divalent linking group containing a heteroatom.

Suitable examples of the polymerizable group-containing group include a group represented by a chemical formula: C(R^{X11})(R^{X12})=C(R^{X13})-Ya^{x0}-.

In the chemical formula, R^{X11}, R^{X12}, and R^{X13} each represents a hydrogen atom, an alkyl group having 1 to 5 carbon atoms, or a halogenated alkyl group having 1 to 5 carbon atoms, and Ya^{x0} represents a single bond or a divalent linking group.

Examples of the condensed ring formed by Ya^{x2} and W² include a condensed ring formed by a polymerizable group of the W² moiety and by Ya^{x2} and a condensed ring formed by a group other than the polymerizable group of the W² moiety and by Ya^{x2}.

The condensed ring formed by Ya^{x2} and W² may have a substituent.

The constitutional unit (a8) contained in the component (A1) may be used alone or two or more kinds thereof may be used. The component (A1) may or may not have the constitutional unit (a8).

The proportion of the constitutional unit (a8) in the component (A1) is preferably in a range of 0% to 50% by mole and more preferably in a range of 0% to 30% by mole with respect to the total amount (100% by mole) of all constitutional units constituting the component (A1).

The component (A1) contained in the resist composition may be used alone or in combination of two or more kinds thereof.

Examples of the component (A1) include a polymer compound having a repeating structure of the constitutional unit (a1) and the constitutional unit (a10); and a polymer compound having a repeating structure of the constitutional unit (a1), the constitutional unit (a10), and the constitutional unit (a2).

The component (A1) can be produced by dissolving, in a polymerization solvent, each of monomers from which constitutional units are derived, and adding thereto a radical polymerization initiator such as azobisisobutyronitrile (AIBN) or dimethyl azobisisobutyrate (for example, V-601) to carry out polymerization.

### · In regard to Component (A2)

In the resist composition of the present embodiment, a base material component (hereinafter, also referred to as "component (A2)") which does not correspond to the component (A1) and of which solubility in a developing solution is changed due to the action of an acid may be used in combination as the component (A).

The component (A2) is not particularly limited and may be optionally selected from a plurality of components of the related art which are known as base material components for a chemically amplified-type resist composition and used.

As the component (A2), a polymer compound or a low-molecular-weight compound may be used alone or in combination of two or more kinds thereof.

### <<Acid Generator Component (B)>>

The component (B) is not particularly limited, and those which have been suggested so far as an acid generator for a chemically amplified-type resist composition in the related art can be used.

Examples of the acid generator include various acid generators, for example, onium salt-based acid generators such as iodonium salts and sulfonium salts; oxime sulfonate-based acid generators; diazomethane-based acid generators such as bisalkyl or bisaryl sulfonyl diazomethanes and poly(bis-sulfonyl)diazomethanes; nitrobenzyl sulfonate-based acid generators, iminosulfonate-based acid generators, and disulfone-based acid generators.

The content of the component (B) in the resist composition is preferably in a range of 0 to 30 parts by mass, more preferably in a range of 0 to 20 parts by mass, still more preferably in a range of 0 to 10 parts by mass, and particularly preferably in a range of 0 to 8 parts by mass with respect to 100 parts by mass of the component (A).

It is preferable that the content of the component (B) be set to be in the above-described preferable ranges from the viewpoint that a uniform solution is likely to be obtained in a case where each component of the resist composition is dissolved in an organic solvent, and the storage stability of the resist composition is enhanced.

### <<Base Component (D)>>

The component (D) acts as a quencher (an acid diffusion control agent) which traps the acid generated in the resist composition upon light exposure.

Examples of the component (D) include a photodecomposable base (D1) having acid diffusion controllability (hereinafter, referred to as "component (D1)") which is lost by the decomposition upon light exposure and a nitrogen-containing organic compound (D2) (hereinafter, referred to as "component (D2)") which does not correspond to the component (D1).

### · In regard to Component (D1)

The component (D1) is not particularly limited as long as it decomposes by exposure to lose acid diffusion controllability, and examples thereof include a compound represented by any of General Formulae (d1-1) to (d1-3). 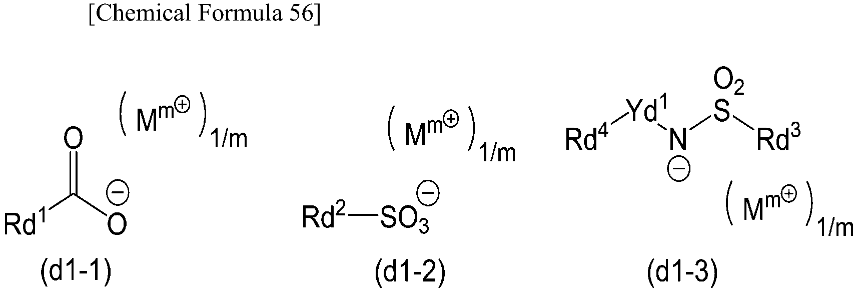 [In the formulae, Rd¹ to Rd⁴ represent a cyclic group which may have a substituent, a chain-like alkyl group which may have a substituent, or a chain-like alkenyl group which may have a substituent. Here, the carbon atom adjacent to the S atom as Rd² in Formula (dl-2) has no fluorine atom bonded thereto. Yd¹ represents a single bond or a divalent linking group. m represents an integer of 1 or greater, and M^{m+}'s each independently represents an m-valent organic cation].

As the organic cation in M^{m+}, a sulfonium cation or an iodonium cation is preferable.

As the component (D1), only any one of the above-described components (d1-1) to (d1-3) or a combination of two or more kinds thereof may be used.

In a case where the resist composition contains the component (D1), the content of the component (D1) in the resist composition is preferably in a range of 0.5 to 15 parts by mass, more preferably in a range of 1 to 12 parts by mass, and still more preferably in a range of 2 to 10 parts by mass with respect to 100 parts by mass of the component (A).

### · In regard to Component (D2)

The component (D2) is not particularly limited as long as it acts as an acid diffusion control agent and does not correspond to the component (D1), and any known compound may be used. Among the examples, an aliphatic amine is preferable, and particularly a secondary aliphatic amine and a tertiary aliphatic amine are more preferable.

The component (D2) may be used alone or in combination of two or more kinds thereof.

In a case where the resist composition contains the component (D2), the content of the component (D2) in the resist composition is typically in a range of 0.01 to 5 parts by mass with respect to 100 parts by mass of the component (A). In a case where the content thereof is set to be in the above-described range, the resist pattern shape, the post-exposure temporal stability, and the like are improved.

### <<At least one Compound (E) Selected from Group Consisting of Organic Carboxylic Acids, Phosphorus Oxo Acids, and Derivatives thereof>>

For the intended purpose of preventing any deterioration in sensitivity, and improving the resist pattern shape and the post-exposure temporal stability, the resist composition may contain at least one compound (E) (hereinafter, referred to as a component (E)) selected from the group consisting of an organic carboxylic acid, and a phosphorus oxo acid and a derivative thereof, as an optional component.

Specific examples of the organic carboxylic acid include acetic acid, malonic acid, citric acid, malic acid, succinic acid, benzoic acid, and salicylic acid. Among these, salicylic acid is preferable.

Examples of the phosphorus oxo acid include phosphoric acid, phosphonic acid, and phosphinic acid. Among these, phosphonic acid is particularly preferable.

In the resist composition of the present embodiment, the component (E) may be used alone or in combination of two or more kinds thereof.

In a case where the resist composition contains the component (E), the content of the component (E) is preferably in a range of 0.01 to 5 parts by mass and more preferably in a range of 0.05 to 3 parts by mass with respect to 100 parts by mass of the component (A).

### <<Fluorine Additive Component (F)>>

The component (F) is used to impart water repellency to the resist film and used as a resin different from the component (A), whereby the lithography characteristics can be improved.

As the component (F), for example, the fluorine-containing polymer compounds described in Japanese Unexamined Patent Application, First Publication Nos. 2010-002870, 2010-032994, 2010-277043, 2011-13569, and 2011-128226 can be used.

The weight-average molecular weight (Mw) (in terms of polystyrene according to gel permeation chromatography) of the component (F) is preferably in a range of 1000 to 50000, more preferably in a range of 5000 to 40000, and most preferably in a range of 10000 to 30000. In a case where the weight-average molecular weight thereof is less than or equal to the upper limits of the above-described ranges, the resist composition exhibits sufficient solubility in a solvent for a resist to be used as a resist. Meanwhile, in a case where the weight-average molecular weight thereof is greater than or equal to the lower limits of the above-described ranges, water repellency of the resist film is enhanced.

Further, the dispersity (Mw/Mn) of the component (F) is preferably in a range of 1.0 to 5.0, more preferably in a range of 1.0 to 3.0, and most preferably in a range of 1.0 to 2.5.

The (F) component may be used alone or in combination of two or more kinds thereof.

In a case where the resist composition contains the component (F), the content of the component (F) is preferably in a range of 0.5 to 10 parts by mass and more preferably in a range of 1 to 10 parts by mass with respect to 100 parts by mass of the component (A).

### <<Organic Solvent Component (S)>>

The component (S) may be used alone or in the form of a mixed solvent obtained by mixing two or more kinds thereof. Among these, propylene glycol monomethyl ether acetate (PGMEA), propylene glycol monomethyl ether (PGME), γ-butyrolactone, ethyl lactate (EL), or cyclohexanone is preferable.

A mixed solvent obtained by mixing PGMEA with a polar solvent is also preferable as the component (S). The blending ratio (mass ratio) may be appropriately determined in consideration of the compatibility or the like between PGMEA and the polar solvent.

A mixed solvent of at least one selected from PGMEA and EL, and γ-butyrolactone is also preferable as the component (S). In this case, as the mixing ratio, the mass ratio between the former and the latter is preferably in a range of 70:30 to 95:5.

The amount of the component (S) to be used is not particularly limited and is appropriately set to have a concentration which enables coating a substrate or the like depending on the thickness of the coated film. The component (S) is typically used in an amount such that the solid content concentration of the resist composition is set to be in a range of 0.1% to 20% by mass and preferably in a range of 0.2% to 15% by mass.

The composition for forming a surface-modified layer according to the present embodiment contains a component (P) in addition to the component (G). In this manner, in a case where a surface-modified layer is formed on the support using the composition for forming a surface-modified layer according to the present embodiment and a resist film is formed on the surface-modified layer, the adhesiveness of the resist film to the support can be enhanced. Furthermore, the generation of residue in a case where a resist pattern is formed by exposure and development of the resist film can be suppressed.

The reason the above-described effects are exhibited is assumed as follows.

The epoxy group in the constitutional unit (g0) contained in the component (G) is subjected to ring opening and is crosslinked with the support by baking in a case of forming the surface-modified layer on the support. On the other hand, in a case where a resist film is formed on the surface-modified layer, the resist film is adsorbed to the surface-modified layer due to the affinity between the constitutional unit (p0) in the component (P) and the resist film. It is considered that the components act synergistically to enhance the adhesiveness of the resist film to the support and to reduce the residue after the formation of the resist pattern.

### (Resist Pattern-Forming Method)

A resist pattern-forming method according to a second aspect of the present invention includes step (i) of forming a surface-modified layer on a support using the composition for forming a surface-modified layer according to the first aspect, step (ii) of forming a resist film on the surface-modified layer formed on the support using a resist composition, step (iii) of exposing the resist film, and step (iv) of developing the exposed resist film to form a resist pattern.

### <Step (i)>

As the support, the same support as that described in the first aspect can be used. The method of forming a surface-modified layer on a support using a composition for forming a surface-modified layer is not particularly limited, and a known method in the related art can be used.

For example, the surface-modified layer can be formed by applying the composition for forming a surface-modified layer onto the support by a well-known method in the related art using a spinner or the like, and performing a baking treatment to volatilize the organic solvent.

Examples of the baking temperature in the baking treatment include 80°C to 400°C, and the baking temperature is preferably 100°C to 300°C, more preferably 160°C to 300°C, still more preferably 190°C to 300°C, and particularly preferably 190°C to 250°C. By setting the baking temperature within the preferred range, the effect of improving the adhesiveness of the resist film to the support can be sufficiently obtained.

Examples of the baking treatment time include 30 seconds to 10 minutes, and the baking treatment time is preferably 50 seconds to 10 minutes and more preferably 60 seconds to 10 minutes. By setting the baking time within the preferred range, the effect of improving the adhesiveness of the resist film to the support can be sufficiently obtained.

The film thickness of the surface-modified layer is, for example, 1 to 5 nm, and is preferably 2 to 4 nm. By setting the film thickness of the surface-modified layer within the above-described range, an effect of improving the adhesiveness of the resist film to the support can be sufficiently obtained. In addition, residue after the formation of the resist pattern can be reduced.

### <Step (ii)>

As the resist composition, the same resist composition as the resist composition in the first aspect can be used. The method of forming a resist film on the surface-modified layer using a resist composition is not particularly limited, and a known method in the related art can be used.

For example, the resist composition is applied onto the surface-modified layer by a known method in the related art using a spinner or the like. Next, a baking (post-application baking (PAB)) treatment is performed under, for example, a temperature condition of 80°C to 150°C for 60 seconds to 10 minutes to form a resist film.

The film thickness of the resist film is, for example, 10 to 300 nm, preferably 15 to 200 nm, more preferably 20 to 100 nm, and still more preferably 20 to 50 nm. By setting the film thickness of the resist film within the above-described range, a resist pattern can be formed with high resolution, and sufficient resistance to etching can be obtained.

### <Step (iii)>

The exposure of the resist film can be carried out by a well-known method in the related art. The selective light exposure is carried out on the resist film, for example, by the light exposure through a mask (mask pattern) having a predetermined pattern formed on the mask by using an exposure apparatus such as an electron beam drawing apparatus or an ArF exposure apparatus, or direct irradiation of the resist film for drawing with an electron beam without using a mask pattern. Thereafter, a baking (post-exposure baking (PEB)) treatment is performed, for example, under a temperature condition of 80°C to 150°C for 60 seconds to 10 minutes.

The wavelength to be used for light exposure is not particularly limited and the exposure can be conducted using radiation such as an ArF excimer laser, a KrF excimer laser, an F₂ excimer laser, extreme ultraviolet (EUV) rays, vacuum ultraviolet rays (VUV), electron beams (EB), X-rays, and soft X-rays.

The method of exposing the resist film to light may be general exposure (dry exposure) conducted in air or an inert gas such as nitrogen, or liquid immersion lithography.

The liquid immersion lithography is an exposure method in which the region between the resist film and the lens at the lowermost position of the exposure apparatus is filled with a solvent (liquid immersion medium) in advance that has a refractive index greater than the refractive index of air, and the exposure (immersion exposure) is conducted in this state.

As the liquid immersion medium, a solvent having a refractive index greater than the refractive index of air but less than the refractive index of the resist film to be exposed is preferable, and examples thereof include water, a fluorine-based inert liquid, a silicon-based solvent, and a hydrocarbon-based solvent.

As the liquid immersion medium, water is preferably used.

### <Step (iv)>

The development treatment of the resist film after exposure can be carried out by a known method in the related art. The developing treatment is conducted using an alkali developing solution in a case of an alkali developing process and using a developing solution containing an organic solvent (organic developing solution) in a case of a solvent developing process. The development treatment is preferably alkali development.

As the alkali developing solution used for the developing treatment in the alkali developing process, a 0.1% to 10% by masstetramethylammonium hydroxide (TMAH) aqueous solution is an exemplary example.

The organic solvent contained in the organic developing solution used for the developing treatment in the solvent developing process may be any solvent that is capable of dissolving the component (A) (the component (A) before light exposure) and can be appropriately selected from known organic solvents. Specific examples thereof include a polar solvent such as a ketone-based solvent, an ester-based solvent, an alcohol-based solvent, a nitrile-based solvent, an amide-based solvent, and an ether-based solvent, and a hydrocarbon-based solvent.

The developing treatment can be performed according to a known developing method, and examples thereof include a method of immersing a support in a developing solution for a certain time (a dip method), a method of raising a developing solution on the surface of a support using the surface tension and maintaining the state for a certain time (a puddle method), a method of spraying a developing solution to the surface of a support (spray method), and a method of continuously ejecting a developing solution onto a support rotating at a certain rate while scanning a developing solution ejection nozzle at a certain rate (dynamic dispense method).

After the developing treatment, it is preferable to conduct a rinse treatment. As the rinse treatment, water rinsing using pure water is preferable in a case of the alkali developing process, and rinsing using a rinse solution containing an organic solvent is preferable in a case of the solvent developing process.

In a case of the solvent developing process, after the developing treatment or the rinse treatment, the developing solution or the rinse solution attached onto the pattern may be removed by a treatment using a supercritical fluid.

After the developing treatment or the rinse treatment, drying is conducted. A bake treatment (post bake) may be conducted after the developing treatment in some cases.

The rinse treatment carried out using a rinse solution (washing treatment) can be performed according to a known rinse method. Examples of the method of performing the rinse treatment include a method of continuously ejecting a rinse solution onto a support rotating at a certain rate (rotary coating method), a method of immersing a support in a rinse solution for a certain time (dip method), and a method of spraying a rinse solution to the surface of a support (spray method).

According to the resist pattern-forming method of the present embodiment described above, the surface-modified layer is formed on the support using the composition for forming a surface-modified layer according to the first aspect, and the resist film is formed on the surface-modified layer, so that the adhesiveness of the resist film to the support is enhanced. Therefore, even in a case where a fine pattern is formed, pattern collapse of the resist pattern can be suppressed. In addition, the generation of residue during the formation of a resist pattern can be suppressed.

It is preferable that various materials (for example, a resist composition, a resist solvent, a developing solution, a rinse solution, and the like) used in the composition for forming a surface-modified layer of the above-described embodiment and the resist pattern-forming method of the above-described embodiment not contain impurities such as a metal, a metal salt containing a halogen, an acid, an alkali, a sulfur atom, or a phosphorus atom. Here, examples of the impurities containing metal atoms include Na, K, Ca, Fe, Cu, Mn, Mg, Al, Cr, Ni, Zn, Ag, Sn, Pb, Li, and salts thereof. The content of the impurities contained in these materials is preferably 200 ppb or less, more preferably 1 ppb or less, still more preferably 100 parts per trillion (ppt) or less, and particularly preferably 10 ppt or less, where it is most preferable that the impurities are substantially free (less than or equal to the detection limit of the measuring device).

### Examples

Hereinafter, the present invention will be described in more detail based on examples, but the present invention is not limited to these examples.

### <Preparation of Composition for Forming Surface-Modified Layer>

Each of the components shown in Tables 1 to 3 was mixed and dissolved to prepare a composition for forming a surface-modified layer of each example. The resin component was dissolved in 2-heptanone and diluted with propylene glycol monomethyl ether acetate to prepare a solution having a solid content concentration of 1,300 ppm (0.13% by mass).

**[Table 1]**

| Composition for forming surface-modified layer | Component (G) | Component (P) |
|---|---|---|
| (M1)-1 | (G)-1 [90] | (P)-1 [10] |
| (M1)-2 | (G)-1 [90] | (P)-2 [10] |
| (M1)-3 | (G)-1 [90] | (P)-3 [10] |
| (M1)-4 | (G)-1 [90] | (P)-4 [10] |
| (M1)-5 | (G)-1 [90] | (P)-5 [10] |
| (M1)-6 | (G)-1 [90] | (P)-6 [10] |
| (M1)-7 | (G)-1 [90] | (P)-7 [10] |
| (M1)-8 | (G)-1 [90] | (P)-8 [10] |
| (M1)-9 | (G)-1 [90] | (P)-9 [10] |
| (M1)-10 | (G)-1 [90] | (P)-10 [10] |

**[Table 2]**

| Composition for forming surface-modified layer | Component (G) | Component (P) |
|---|---|---|
| (M1)-11 | (G)-1 [90] | (P)-11 [10] |
| (M1)-12 | (G)-1 [90] | (P)-12 [10] |
| (M1)-13 | (G)-1 [90] | (P)-13 [10] |
| (M1)-14 | (G)-2 [90] | (P)-1 [10] |
| (M1)-15 | (G)-3 [90] | (P)-1 [10] |
| (M1)-16 | (G)-1 [90] | (P)-14 [10] |
| (M1)-17 | (G)-1 [90] | (P)-15 [10] |
| (M1)-18 | (G)-1 [80] | (P)-1 [20] |
| (M1)-19 | (G)-1 [70] | (P)-1 [30] |
| (M1)-20 | (G)-1 [60] | (P)-1 [40] |
| (M1)-21 | (G)-1 [50] | (P)-1 [50] |

**[Table 3]**

| Composition for forming surface-modified layer | Component (G) | Component (P) |
|---|---|---|
| (M2)-1 | (G)-1 [100] | - |
| (M2)-2 | (G)-2 [100] | - |
| (M2)-3 | (G)-3 [100] | - |

In Tables 1 to 3, each abbreviation has the following meaning.
(G)-1: A polymer compound represented by Formula (G-1). The weight-average molecular weight (Mw) determined by the GPC measurement in terms of standard polystyrene was 7,000, and the polydispersity (Mw/Mn) thereof was 2.80. The copolymerization composition ratio (the ratio (molar ratio) among constitutional units in the structural formula) determined by ¹³C-NMR was l/m = 40/60.
(G)-2: A polymer compound represented by Formula (G-2). The weight-average molecular weight (Mw) determined by the GPC measurement in terms of standard polystyrene was 7,000, and the polydispersity (Mw/Mn) thereof was 2.80. The copolymerization composition ratio (the ratio (the molar ratio) among constitutional units in the structural formula) determined by ¹³C-NMR was l/m = 80/20.
(G)-3: A polymer compound represented by Formula (G-3). The weight-average molecular weight (Mw) determined by the GPC measurement in terms of standard polystyrene was 7,000, and the polydispersity (Mw/Mn) thereof was 2.80. The copolymerization composition ratio (1/m/n) (the proportion (molar ratio) of each constitutional unit in the structural formula) determined by ¹³C-NMR was 40/40/20.

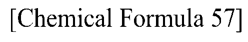

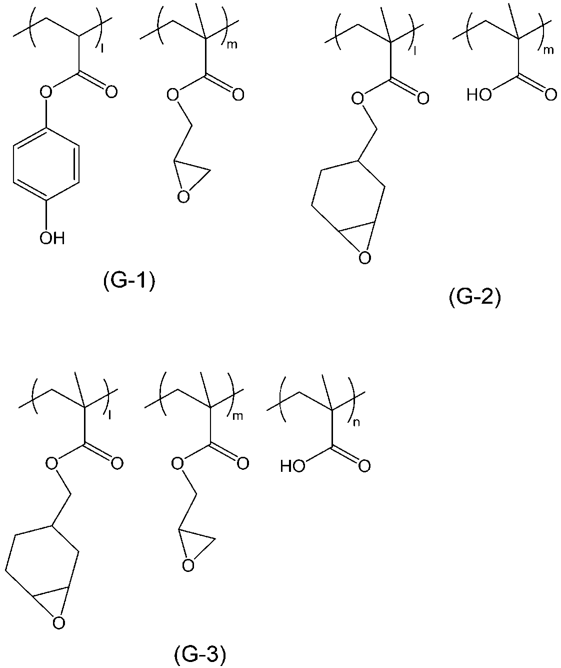

(P)-1: A polymer compound represented by Formula (P-1). The weight-average molecular weight (Mw) determined by the GPC measurement in terms of standard polystyrene was 240,000, and the polydispersity (Mw/Mn) thereof was 2.50. The copolymerization composition ratio (l/m/n/o) (the proportion (molar ratio) of each constitutional unit in the structural formula) determined by ¹³C-NMR was 35/40/15/10.

(P)-2: A polymer compound represented by Formula (P-2). The weight-average molecular weight (Mw) determined by the GPC measurement in terms of standard polystyrene was 240,000, and the polydispersity (Mw/Mn) thereof was 2.50. The copolymerization composition ratio (l/m/n/o) (the proportion (molar ratio) of each constitutional unit in the structural formula) determined by ¹³C-NMR was 35/40/15/10.

(P)-3: A polymer compound represented by Formula (P-3), The weight-average molecular weight (Mw) determined by the GPC measurement in terms of standard polystyrene was 240,000, and the polydispersity (Mw/Mn) thereof was 2.50. The copolymerization composition ratio (l/m/n/o) (the proportion (molar ratio) of each constitutional unit in the structural formula) determined by ¹³C-NMR was 35/40/15/10.

(P)-4: A polymer compound represented by Formula (P-4). The weight-average molecular weight (Mw) determined by the GPC measurement in terms of standard polystyrene was 240,000, and the polydispersity (Mw/Mn) thereof was 2.50. The copolymerization composition ratio (l/m/n/o) (the proportion (molar ratio) of each constitutional unit in the structural formula) determined by ¹³C-NMR was 35/40/15/10.

(P)-5: A polymer compound represented by Formula (P-5). The weight-average molecular weight (Mw) determined by the GPC measurement in terms of standard polystyrene was 240,000, and the polydispersity (Mw/Mn) thereof was 2.50. The copolymerization composition ratio (1/m/n/o) (the proportion (molar ratio) of each constitutional unit in the structural formula) determined by ¹³C-NMR was 35/40/15/10.

(P)-6: A polymer compound represented by Formula (P-6). The weight-average molecular weight (Mw) determined by the GPC measurement in terms of standard polystyrene was 240,000, and the polydispersity (Mw/Mn) thereof was 2.50. The copolymerization composition ratio (l/m/n/o) (the proportion (molar ratio) of each constitutional unit in the structural formula) determined by ¹³C-NMR was 35/40/15/10.

(P)-7: A polymer compound represented by Formula (P-7). The weight-average molecular weight (Mw) determined by the GPC measurement in terms of standard polystyrene was 240,000, and the polydispersity (Mw/Mn) thereof was 2.50. The copolymerization composition ratio (l/m/n/o) (the proportion (molar ratio) of each constitutional unit in the structural formula) determined by ¹³C-NMR was 35/40/15/10.

(P)-8: A polymer compound represented by Formula (P-8). The weight-average molecular weight (Mw) determined by the GPC measurement in terms of standard polystyrene was 240,000, and the polydispersity (Mw/Mn) thereof was 2.50. The copolymerization composition ratio (l/m/n/o) (the proportion (molar ratio) of each constitutional unit in the structural formula) determined by ¹³C-NMR was 35/40/15/10.

(P)-9: A polymer compound represented by Formula (P-9). The weight-average molecular weight (Mw) determined by the GPC measurement in terms of standard polystyrene was 240,000, and the polydispersity (Mw/Mn) thereof was 2.50. The copolymerization composition ratio (l/m/n/o) (the proportion (molar ratio) of each constitutional unit in the structural formula) determined by ¹³C-NMR was 35/40/15/10.

(P)-10: A polymer compound represented by Formula (P-10). The weight-average molecular weight (Mw) determined by the GPC measurement in terms of standard polystyrene was 240,000, and the polydispersity (Mw/Mn) thereof was 2.50. The copolymerization composition ratio (1/m/n/o) (the proportion (molar ratio) of each constitutional unit in the structural formula) determined by ¹³C-NMR was 35/40/15/10.

(P)-11: A polymer compound represented by Formula (P-11). The weight-average molecular weight (Mw) determined by the GPC measurement in terms of standard polystyrene was 240,000, and the polydispersity (Mw/Mn) thereof was 2.50. The copolymerization composition ratio (l/m/n/o) (the proportion (molar ratio) of each constitutional unit in the structural formula) determined by ¹³C-NMR was 35/40/15/10.

(P)-12: A polymer compound represented by Formula (P-12). The weight-average molecular weight (Mw) determined by the GPC measurement in terms of standard polystyrene was 240,000, and the polydispersity (Mw/Mn) thereof was 2.50. The copolymerization composition ratio (l/m/n/o) (the proportion (molar ratio) of each constitutional unit in the structural formula) determined by ¹³C-NMR was 35/40/15/10.

(P)-13: A polymer compound represented by Formula (P-13). The weight-average molecular weight (Mw) determined by the GPC measurement in terms of standard polystyrene was 240,000, and the polydispersity (Mw/Mn) thereof was 2.50. The copolymerization composition ratio (l/m/n/o) (the proportion (molar ratio) of each constitutional unit in the structural formula) determined by ¹³C-NMR was 35/40/15/10.

(P)-14: A polymer compound represented by Formula (P-2). The weight-average molecular weight (Mw) determined by the GPC measurement in terms of standard polystyrene was 240,000, and the polydispersity (Mw/Mn) thereof was 2.50. The copolymerization composition ratio (l/m/n) (the proportion (molar ratio) of each constitutional unit in the structural formula) determined by ¹³C-NMR was 55/35/10.

(P)-15: A polymer compound represented by Formula (P-15). The weight-average molecular weight (Mw) determined by the GPC measurement in terms of standard polystyrene was 240,000, and the polydispersity (Mw/Mn) thereof was 2.50. The copolymerization composition ratio (1/m/n) (the proportion (molar ratio) of each constitutional unit in the structural formula) determined by ¹³C-NMR was 55/35/10.

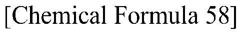

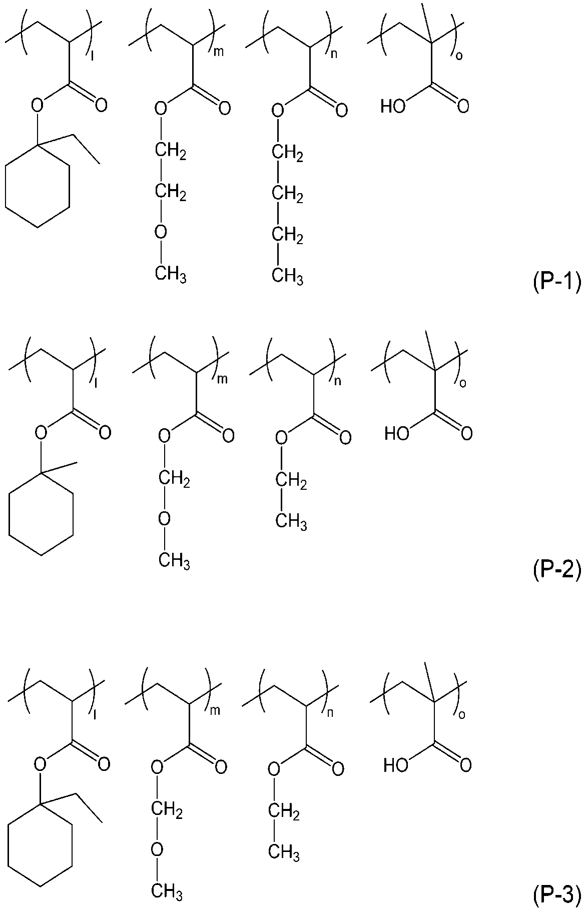

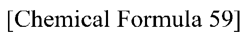

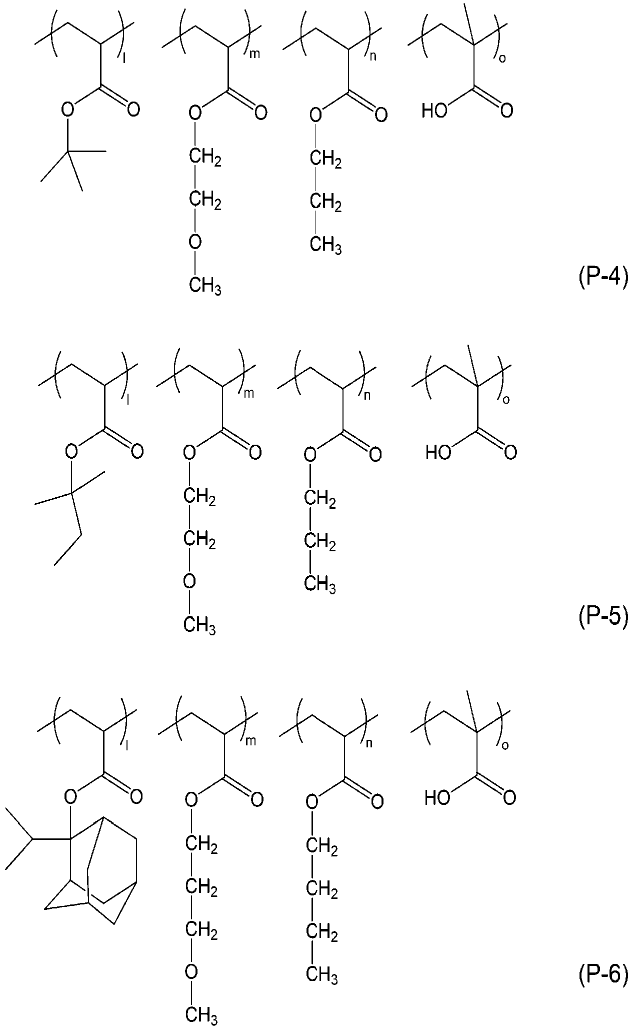

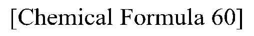

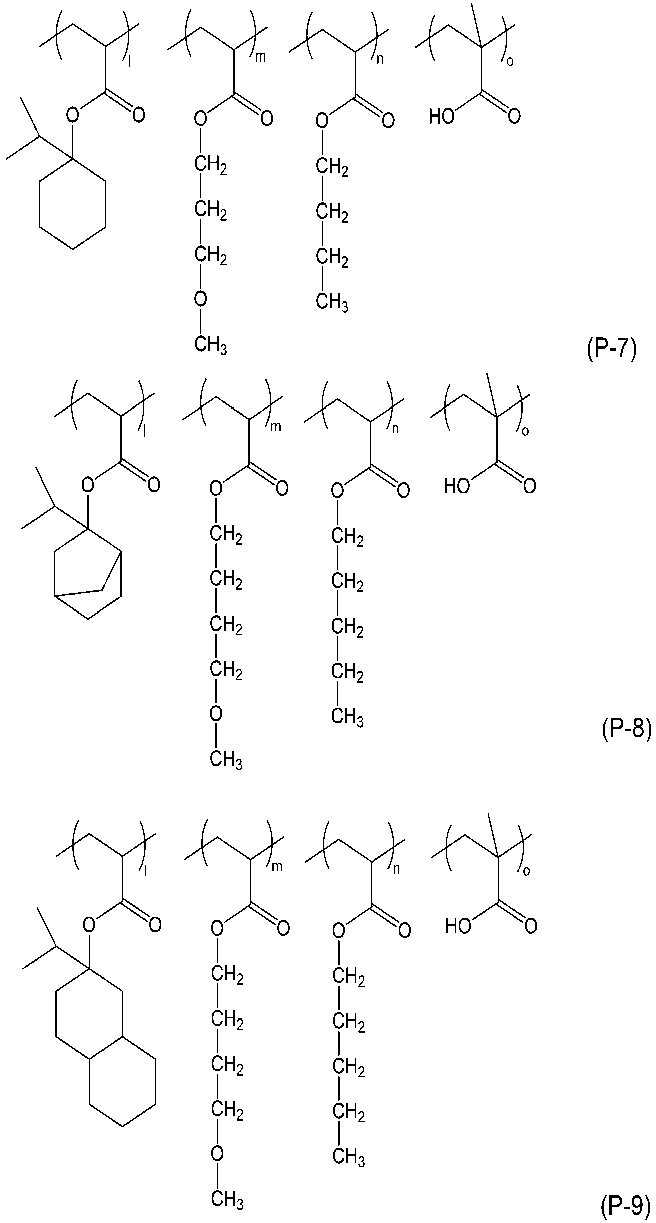

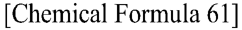

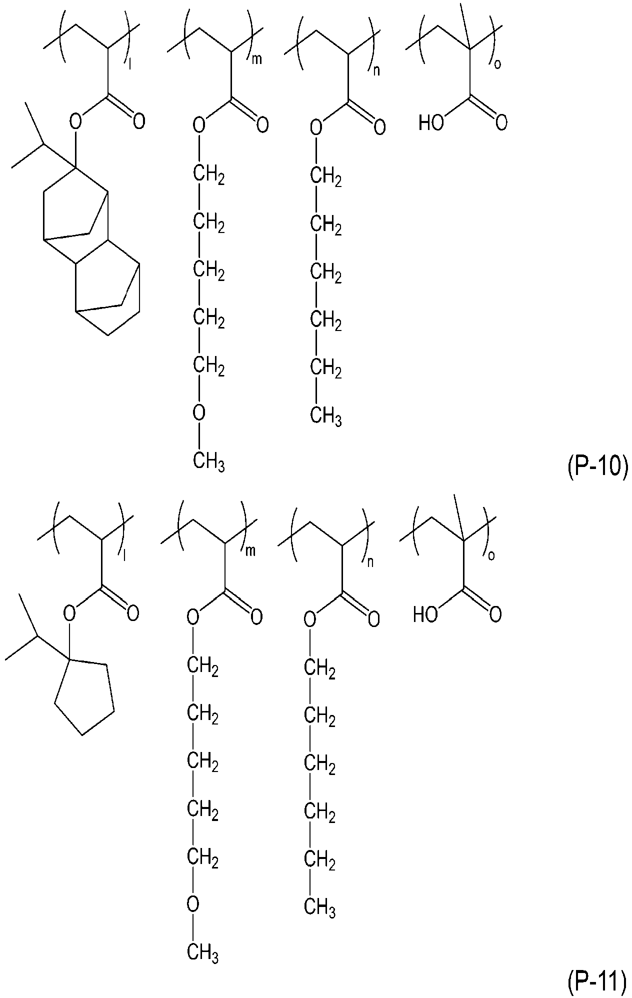

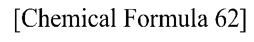

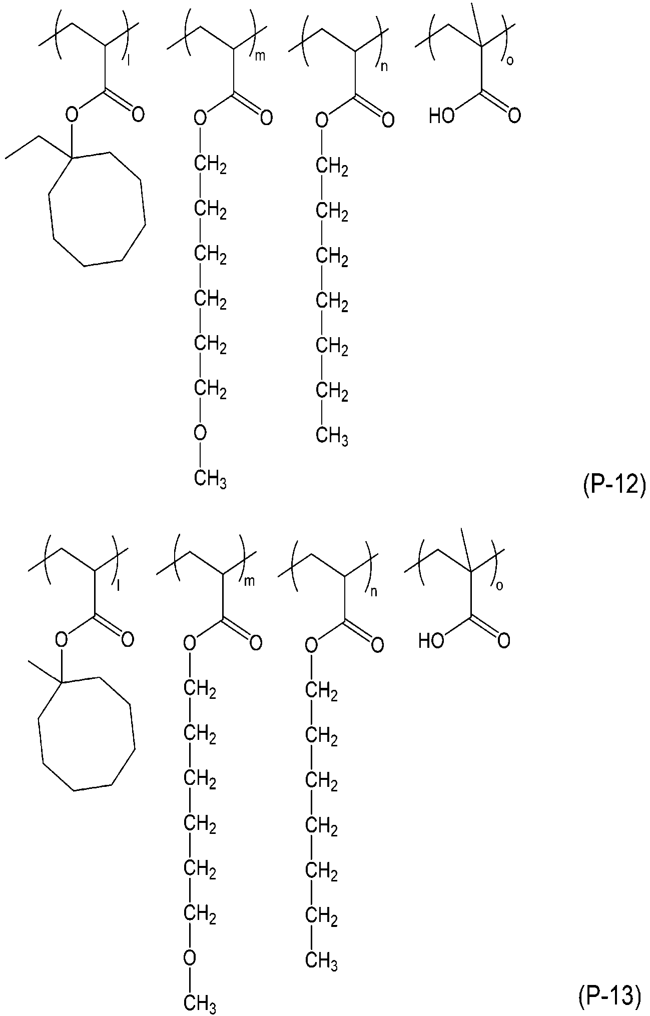

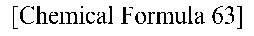

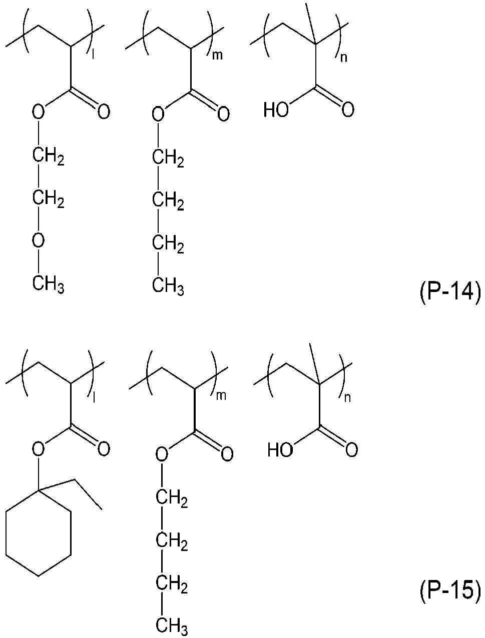

### <Resist Pattern Formation>

### (Examples 1 to 29 and Comparative Examples 1 to 3)

A surface-modified layer having a film thickness of 3 nm was formed by applying the composition for forming a surface-modified layer shown in Tables 4 to 6 onto a silicon substrate and a glass substrate using a spinner, and performing a baking treatment shown in Tables 4 to 6 on a hot plate. Next, a positive tone EB resist (OEBR-CAP1000AE, manufactured by TOKYO OHKA KOGYO CO., LTD.) was applied onto the surface-modified layer using a spinner, and baked at a temperature of 100°C for 60 seconds for a silicon substrate and 10 minutes for a glass substrate to form a resist film having a film thickness of 30 nm. Next, drawing (exposure) was carried out on the resist film by using an electron beam lithography apparatus JEOL JBX-9300FS (manufactured by JEOL Ltd.), with the target size being set to a 1:1 line and space pattern (hereinafter, referred to as an "LS pattern") of a line width of 20 nm, 25 nm, or 30 nm, at an acceleration voltage of 100 kV. Thereafter, a heat treatment (PEB) was performed after exposure at 80°C for 60 seconds on the silicon substrate and 10 minutes on the glass substrate.

Subsequently, alkali development was performed at 23°C for 30 seconds using a 2.38% by mass tetramethylammonium hydroxide (TMAH) aqueous solution "NMD-3" (trade name, manufactured by TOKYO OHKA KOGYO CO., LTD.).

Thereafter, water rinsing was performed for 15 seconds using pure water.

As a result, a 1:1 LS pattern having a line width of 30 nm, 25 nm, or 20 nm was formed.

### [Evaluation of LS Pattern Shape]

The shape of the LS pattern formed according to <Resist Pattern Formation> was observed with a length-measuring SEM (scanning electron microscope, acceleration voltage: 800 V, trade name: SU-8000, manufactured by Hitachi High-Tech Corporation). There was no difference in the evaluation results between a case where a silicon substrate was used and a case where a glass substrate was used.

### (Determination Method)

The 1:1 LS pattern shapes of line widths of 30 nm, 25 nm, and 20 nm were determined according to the following evaluation standards. The results are shown in "30 nm LS", "25 nm LS", and "20 nm LS" in Tables 4 to 6, respectively. The "Determination" in Tables 4 to 6 shows the overall evaluation thereof.

### <Evaluation Standards>

A: No residue, and sufficient adhesion effect of resist (no pattern collapse)
B: There were some residues, and the adhesion effect was sufficient (no pattern collapse).
C: Slight residues were observed, and the adhesion effect was observed (some pattern collapse was observed).
D: A large amount of residues were present, or the adhesion effect was not exhibited (pattern was not formed).

**[Table 4]**

| | Composition for forming surface-modified layer | Baking temperature (°C) | Baking time (sec) | Determination | 30 nm LS | 25 nm LS | 20 nm LS |
|---|---|---|---|---|---|---|---|
| Example 1 | (M1)-1 | 210 | 60 | A | A | A | A |
| Example 2 | (M1)-2 | 210 | 60 | B | B | B | B |
| Example 3 | (M1)-3 | 210 | 60 | B | B | B | B |
| Example 4 | (M1)-4 | 210 | 60 | B | B | B | B |
| Example 5 | (M1)-5 | 210 | 60 | B | B | B | B |
| Example 6 | (M1)-6 | 210 | 60 | B | B | B | B |
| Example 7 | (M1)-7 | 210 | 60 | B | B | B | B |
| Example 8 | (M1)-8 | 210 | 60 | B | B | B | B |
| Example 9 | (M1)-9 | 210 | 60 | B | B | B | B |
| Example 10 | (M1)-10 | 210 | 60 | B | B | B | B |

**[Table 5]**

| | Composition for forming surface-modified layer | Baking temperature (°C) | Baking time (see) | Determination | 30 nm LS | 25 nm LS | 20 nm LS |
|---|---|---|---|---|---|---|---|
| Example 11 | (M1)-11 | 210 | 60 | B | B | B | B |
| Example 12 | (M1)-12 | 210 | 60 | B | B | B | B |
| Example 13 | (M1)-13 | 210 | 60 | B | B | B | B |
| Example 14 | (M1)-14 | 210 | 60 | B | B | B | B |
| Example 15 | (M1)-15 | 210 | 60 | B | B | B | B |
| Example 16 | (M1)-16 | 210 | 60 | B | B | B | C |
| Example 17 | (M1)-17 | 210 | 60 | B | B | B | C |
| Example 18 | (M1)-18 | 210 | 60 | A | A | A | A |
| Example 19 | (M1)-19 | 210 | 60 | A | A | A | A |
| Example 20 | (M1)-20 | 210 | 60 | B | B | B | B |
| Example 21 | (M1)-21 | 210 | 60 | B | B | B | B |
| Example 22 | (M1)-1 | 160 | 60 | C | C | C | C |
| Example 23 | (M1)-1 | 170 | 60 | C | C | C | C |
| Example 24 | (M1)-1 | 180 | 60 | C | C | C | C |
| Example 25 | (M1)-1 | 190 | 60 | B | B | B | B |
| Example 26 | (M1)-1 | 200 | 60 | B | B | B | B |
| Example 27 | (M1)-1 | 220 | 60 | A | A | A | A |
| Example 28 | (M1)-1 | 230 | 60 | A | A | A | A |
| Example 29 | (M1)-1 | 240 | 60 | A | A | A | A |

**[Table 6]**

| | Composition for forming surface-modified laver | Baking temperature (°C) | Baking timee (sec) | Determination | 30 nm LS | 25 nm LS | 20 nm LS |
|---|---|---|---|---|---|---|---|
| Comparative Example 1 | (M2)-1 | 210 | 60 | D | D | D | D |
| Comparative Example 2 | (M2)-2 | 210 | 60 | D | D | D | D |
| Comparative Example 3 | (M2)-3 | 210 | 60 | D | D | D | D |

From the results shown in Tables 4 to 6, it was confirmed that in Examples 1 to 29 in which the compositions (M1)-1 to (M1)-21 for forming a surface-modified layer were used, there was little or no residue after forming the resist pattern in any of the LS patterns, and the adhesiveness of the resist film to the substrate was also enhanced. In general, a finer 20 nm LS pattern is more likely to leave a residue than a 30 nm LS pattern, and thus an adhesion effect is difficult to obtain. In Examples 1 to 29, even in the 20 nm LS pattern, the amount of residues was small, and the adhesion effect was obtained. On the other hand, in Comparative Examples 1 to 3 in which the compositions (M2)-1 to (M2)-3 for forming a surface-modified layer were used, the adhesiveness of the resist film to the substrate was poor, and thus a pattern could not be formed, or a large amount of residues were generated even in a case where a resist pattern was formed.

It was confirmed that the component (P) preferably has a constitutional unit (a1) containing an acid-decomposable group of which the polarity is increased by the action of an acid, and it is preferable that the component (P) have two or more kinds of constitutional units (p0) represented by General Formula (p0-1). It was confirmed that the baking temperature in a case of forming the surface-modified layer is preferably 190°C or higher.

Hereinbefore, preferred examples of the present invention have been described, but the present invention is not limited to these examples. Additions, omissions, substitutions, and other modifications can be made without departing from the scope of the present invention. The present invention is not limited by the above description, but only by the scope of the appended claims.

## Claims

1. A composition for forming a surface-modified layer, which is a composition for forming a surface-modified layer provided between a support and a resist film, the composition comprising:
a resin component (G) having a constitutional unit (g0) represented by General Formula (g0-1); and
a resin component (P) having a constitutional unit (p0) represented by General Formula (p0-1), 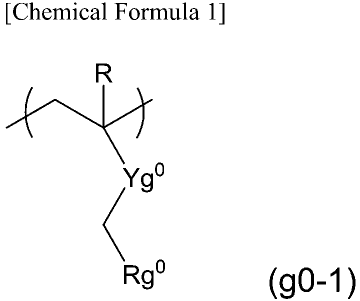
[in the formula, R represents a hydrogen atom, an alkyl group having 1 to 5 carbon atoms, or a halogenated alkyl group having 1 to 5 carbon atoms; Yg⁰ represents a divalent linking group; and Rg⁰ represents an epoxy group-containing group], 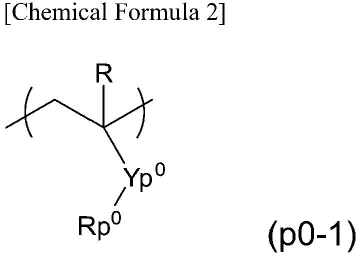
[in the formula, R represents a hydrogen atom, an alkyl group having 1 to 5 carbon atoms, or a halogenated alkyl group having 1 to 5 carbon atoms; Yp⁰ represents a divalent linking group; and Rp⁰ represents a chain-like hydrocarbon group having 2 to 20 carbon atoms, which may have a substituent].

2. The composition for forming a surface-modified layer according to Claim 1, wherein Rg⁰ in General Formula (g0-1) is a group represented by General Formula (rg-1) or an alicyclic epoxy group, 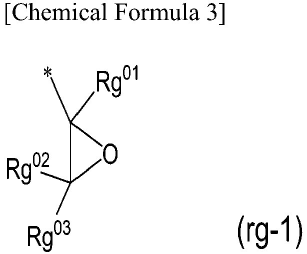 [in the formula, Rg⁰¹ to Rg⁰³ each independently represents a hydrogen atom or an alkyl group, and* represents a bonding site].

3. The composition for forming a surface-modified layer according to Claim 1 or 2,
wherein the resin component (P) has a constitutional unit (a1) containing an acid-decomposable group of which the polarity is increased by the action of an acid.

4. The composition for forming a surface-modified layer according to Claim 1 or 2,
wherein the resin component (P) has two or more kinds of constitutional units (p0).

5. The composition for forming a surface-modified layer according to Claim 1 or 2,
wherein a content of the resin component (P) is 5 to 50 parts by mass with respect to 100 parts by mass of a total mass of the resin component (G) and the resin component (P).

6. A resist pattern-forming method, comprising:
step (i) of forming a surface-modified layer on a support using the composition for forming a surface-modified layer according to Claim 1 or 2;
step (ii) of forming a resist film on the surface-modified layer formed on the support using a resist composition;
step (iii) of exposing the resist film; and
step (iv) of developing the exposed resist film to form a resist pattern.

7. The resist pattern-forming method according to Claim 6,
wherein a film thickness of the surface-modified layer is 1 to 5 nm.
